(19) 

Europäisches
Patentamt
European
Patent Office
Office européen
des brevets

(11) **EP 2 357 673 A1**

(12) **EUROPEAN PATENT APPLICATION**
published in accordance with Art. 153(4) EPC

(43) Date of publication:
**17.08.2011 Bulletin 2011/33**

(51) Int Cl.:
***H01L 31/042*** *(2006.01)*

(21) Application number: **09827370.9**

(22) Date of filing: **19.11.2009**

(86) International application number:
**PCT/JP2009/006246**

(87) International publication number:
**WO 2010/058589 (27.05.2010 Gazette 2010/21)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **19.11.2008 JP 2008296177
19.12.2008 JP 2008324503**

(71) Applicant: **Toppan Printing Co., Ltd.**
**Tokyo 110-8560 (JP)**

(72) Inventors:
• **MORONAGA, Kohei**
**Tokyo 1108560 (JP)**

• **HONMA, Hideaki**
**Tokyo 1108560 (JP)**
• **MURILLO-MORA, Luis Manuel**
**Tokyo 110-8560 (JP)**

(74) Representative: **Martin, Philip John**
**Marks & Clerk LLP**
**62-68 Hills Road**
**Cambridge**
**CB2 1LA (GB)**

(54) **LIGHT REUSING SHEET AND SOLAR BATTERY MODULE**

(57) A light reuse sheet includes: a reflection forming layer (3) having an uneven portion (201) including a first inclined portion (201b) and a second inclined portion (201a); and a reflecting surface (100) provided at a surface of the uneven portion (201). The light reuse sheet generates second light (H2b, H2t) by reflecting first light (HI, H1b, H1t) toward a front plate (22), the first light (H1, H1b, H1t) being transmitted through a filling layer (21) without being received by a light receiving face of a solar battery cell (30), the light reuse sheet generates third light (H3b, H3t) by reflecting the second light (H2b, H2t) at an interface between a light incident surface (110) and outside of the front plate (22), and the light reuse sheet causes the third light (H3b, H3t) to be incident to the light receiving face (J) of the solar battery cell (30).

FIG. 1

EP 2 357 673 A1

**Description**

BACKGROUND OF THE INVENTION

Field of the Invention

The present invention relates to a light reuse sheet having an uneven structure formed on at least one surface thereof, deflecting light in a specific direction using the diffraction, scattering, refraction, or reflection action of light so that light that have been conventionally lost can be reused and relates to a solar battery module in which the light reuse sheet is used.

Priorities are claimed on Japanese Patent Application No. 2008-296177, filed November 19, 2008, and Japanese Patent Application No. 2008-324503, filed December 19, 2008, the contents of which are incorporated herein by reference.

Background Art

In recent years, with the spread of solar battery modules, solar battery modules are being used in a variety of fields.

For example, solar battery modules have been used in relatively small devices that are provided in small electronic apparatuses, such as calculators, and solar battery modules have been installed in homes for household electric appliances. In addition, large-area solar battery power generating systems have been used in large-scale power generating plants, and solar battery modules have been used as power sources for artificial satellites (see, for example, refer to Japanese Unexamined Patent Application, First Publication No. 2001-295437).

In these solar batteries, the quantity of power generated increases principally in proportion to the surface area which is irradiated with light.

Accordingly, in order to improve power generation efficiency, in addition to improving manufacturing technologies, such as sealing technology and film-forming technology, it is an important issue to increase the aperture ratio (the proportion of the area capable of generating power relative to the total area) of the solar battery module.

The method of manufacturing the solar battery cells made of monocrystalline silicon or polycrystalline silicon has a problem in that the cost of silicon is high.

Furthermore, the cost of attaching the solar battery to the module is added to manufacturing costs.

Therefore, a technique has been proposed which uses thin-film silicon solar battery cells in which the quantity of silicon, which is a constituent element of the solar battery cell, is small and which can be formed by, for example, a CVD (Chemical Vapor Deposition) method.

However, the above-mentioned system has low light absorbance since infrared light, in particular, is likely to pass through a thin-film silicon solar battery cell.

Therefore, in order to improve the light use efficiency, a structure has been proposed which improves the light use efficiency by scattering incident light and utilizing the optical path length of light passing through the thin-film silicon solar battery cell.

In general, two types of structures are known in terms of amorphous silicon solar batteries.

As a first type of structure, a structure is known in which a transparent conductive film, such as a $SnO_2$ or ITO (indium tin oxide) film, is formed on a transparent substrate, such as a glass substrate, and a p layer, an i layer, and an n layer of an amorphous semiconductor (Si) are laminated in this order on the transparent conductive film.

As a second type of structure, a structure is known in which a photoelectric conversion active layer having an n layer, an i layer, and a p layer of an amorphous semiconductor (Si) formed in this order is formed on a metal substrate electrode and a transparent conductive film is formed on the photoelectric conversion active layer.

The first structure, in particular, has the following advantages.

Specifically, since the amorphous semiconductor is formed in the order of p-i-n layers, a transparent insulating substrate can function as the base substrate of the solar battery and can also function as a cover glass which covers the surface of the solar battery.

Moreover, since a transparent conductive film made of, for example, $SnO_2$ having plasma resistance has been developed, a photoelectric conversion active layer made of an amorphous semiconductor can be formed on the transparent conductive film by a plasma CVD method.

Since the first structure has the above-mentioned advantages, it is currently in widespread use.

A plasma CVD method that decomposes a raw material gas using glow discharge or a vapor growth method based on a photo CVD method may be used as a method of forming the photoelectric conversion active layer made of an amorphous semiconductor.

Due to using these methods, it is possible to form a thin film with a large area.

The amorphous Si solar battery can be formed at a relatively low temperature of approximately 100°C to 200°C.

Therefore, substrates made of various kinds of substances can be used as the substrate that is used to form the amorphous Si solar battery.

In general, glass substrates and stainless steel substrates have often been used as the substrate.

In the amorphous Si solar battery, the thickness of the silicon light absorption layer at which the conversion efficiency of light into electricity is the maximum is approximately 500 nm.

Therefore, in order to improve the conversion efficiency, it is essential to increase the light absorption quantity within the thickness range of the light absorption layer.

In order to improve the conversion efficiency, conventionally, the optical path length of light in the light absorption layer increases by forming a transparent conductive film having irregularity on the surface thereof on a glass substrate or by forming a metal film having irregularity on the surface thereof on a stainless steel substrate.

In the solar battery manufactured using such a method, the optical path length in the light absorption layer increases and the use efficiency of light is considerably improved, as compared to a structure in which an amorphous Si solar battery is formed on a flat substrate without irregularity formed on the surface of the light absorption layer.

For example, a method of forming a SnO2 film, which is a transparent electrode, using an atmospheric pressure CVD method is used as a general method of forming the irregularity on the surface of the glass substrate.

As a method of forming the irregularity on the surface of a metal substrate, such as a stainless steel substrate, a method has been used in which, when Ag is formed by a vapor deposition method or a sputtering method, the formation conditions are adjusted or a heat treatment is performed after Ag is formed.

The thin-film solar battery has a structure in which a transparent conductive film, a hydrogenated amorphous silicon carbide (a-SiC:H) p layer, a hydrogenated amorphous silicon (a-Si:H) i layer, a hydrogenated amorphous silicon (a-Si:H) n layer, a transparent conductive film, and a rear electrode are formed in this order on a transparent insulating substrate.

In addition, in the above-described manner, an uneven configuration is formed on the surface of the transparent conductive film. In this way, each layer formed on the transparent conductive film has an uneven structure.

Recently, polyimide resins with high heat resistance have been used when a semiconductor element, such as a thin-film solar battery, is formed on a flexible substrate or a lightweight substrate.

A method of forming irregularity in the resin is disclosed in, for example, Japanese Unexamined Patent Application, First Publication No. H04-61285.

Japanese Patent No. 3749015 discloses a technique in which light is retro-reflected by a V-groove periodic structure to improve the use efficiency of light and the apex angle of the V-groove is preferably from 50° to 90°.

In the disclosure, it is preferable that the pitch of the period of the V-grooves be from 10 $\mu$m to 20 $\mu$m.

When the gap between the solar battery cells 401 is reduced, a leakage current occurs.

Therefore, it is necessary to form a region between adjacent solar battery cells 401.

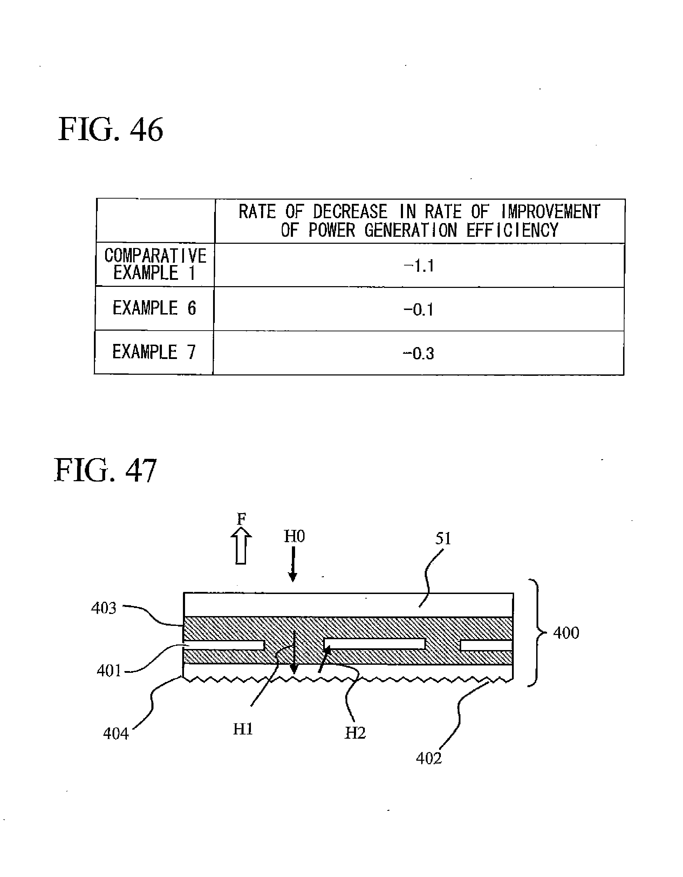

For example, as shown in FIG. 47, a structure is known in which a rear member 402 is arranged on the rear surface of a solar battery module 400 (Japanese Unexamined Patent Application, First Publication No. H10-284747, Japanese Patent No. 3670835, and Japanese Unexamined Patent Application, First Publication No.2006-319250).

According to this structure, among light components H0 incident on the solar battery module 400, light H1 that is incident on the region between adjacent solar battery cells 401 is reflected or scattered by the rear member 402 and light H2 is obtained.

The light H2 is incident on the solar battery cell 401. In this way, light is reused.

However, in the structure, it is difficult to obtain sufficient power generation efficiency.

In FIG. 47, reference numeral 403 represents a filling layer, and a plurality of solar battery cells 401 is arrayed at a predetermined pitch in the filling layer 403.

Reference numeral 404 represents a uneven portion provided in the rear member 402.

Reference numeral 51 represents a front plate.

As described above, there is an increasing demand for improving power generation efficiency per unit area in a conventional solar battery module, but sufficient power generation efficiency is not obtained from a conventional solar battery module.

The reason is that, when light is retro-reflected and used, the light is not retro-reflected at an appropriate angle and most of the retro-reflected light is lost.

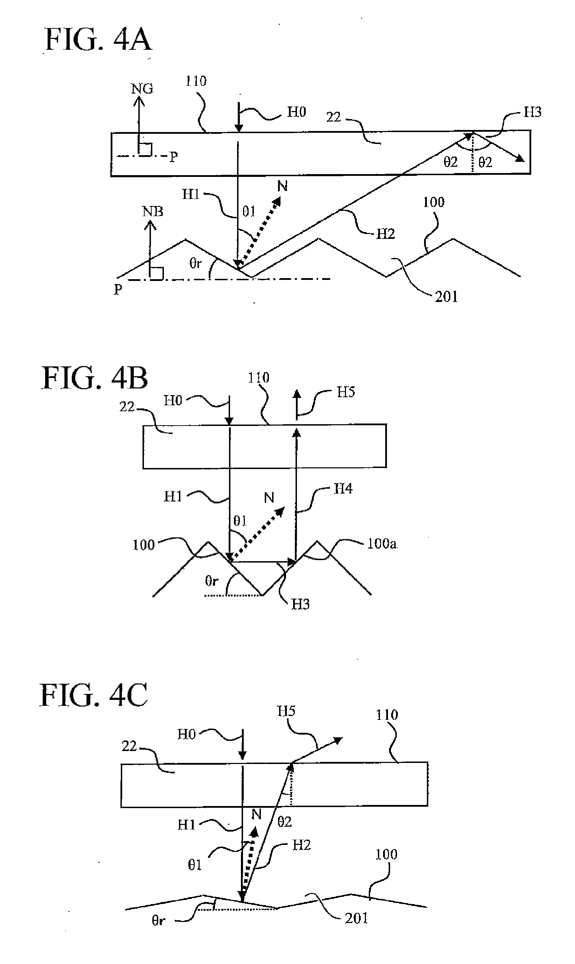

For example, as in Japanese Patent No. 3749015 and Japanese Unexamined Patent Application, First Publication No. H10-284747, when the apex angle of the V-groove is set from 50 degrees to 90 degrees, light H1 is multi-reflected by the periodic structure of the V grooves, as shown in FIG. 4B.

Therefore, the reflected light returns to the incident position of the light H1 or the reflected light is incident on an ineffective region of the solar battery cell.

As a result, the use efficiency of light is not improved.

As disclosed in Japanese Unexamined Patent Application, First Publication No.2006-319250, when light is scattered by a light diffusion layer or a microlens array, scattered light is reflected again at various angles by scattering.

In this case, as shown in FIGS. 4B or 4C, the scattered light returns to the incident position of the light H1 or is incident on an invalid region of the solar battery cell.

As a result, the use efficiency of light is not improved.

Therefore, the reuse efficiency (use efficiency of light) of most of the deflected or scattered light is not improved by merely simply deflecting or scattering the incident light H1.

As described above, there is an increasing demand for improving power generation efficiency per unit area in a conventional solar battery module. However, light loss occurs and it is difficult to obtain sufficient power generation efficiency.

SUMMARY OF THE INVENTION

The invention has been made in view of the above-mentioned problems and an object of the invention is to provide a light reuse sheet capable of effectively reusing light that have been conventionally lost to improve the use efficiency of light and a solar battery module including the light reuse sheet.

In order to achieve the above-described object, a light reuse sheet of a first aspect of the invention is used for a solar battery module. The solar battery module includes: a transparent front plate having a light incident surface to which light is incident; a filling layer which is stacked on a face opposite to the light incident surface and through which the light passing through the front plate is transmitted; and a solar battery cell which is implanted into the filling layer and has a light receiving face located at a face opposed to the front plate, the solar battery cell converting the light transmitted through the filling layer into electric energy by receiving the light by the light receiving face. Specifically, the light reuse sheet of the first aspect of the invention is provided at a face of the filling layer opposite to the light receiving face of the solar battery cell. The light reuse sheet includes: a reflection forming layer having an uneven portion including a first inclined portion and a second inclined portion; and a reflecting surface provided at a surface of the uneven portion. The light reuse sheet generates second light by reflecting first light toward the front plate, the first light being transmitted through the filling layer without being received by the light receiving face of the solar battery cell, the light reuse sheet generates third light by reflecting the second light at an interface between the light incident surface and outside of the front plate, and the light reuse sheet causes the third light to be incident to the light receiving face of the solar battery cell. The second light generated by reflection caused by the first inclined portion travels toward the front plate while having a first angle with respect to the first light, and is reflected by a first interface portion of the front plate so as to be converted into the third light, the first interface portion being arranged separately from the uneven portion by a first distance. The second light generated by reflection caused by the second inclined portion travels toward the front plate while having a second angle that is smaller than the first angle with respect to the first light, and is reflected by a second interface portion of the front plate so as to be converted into the third light, the second interface portion being arranged separately from the uneven portion by a second distance that is smaller than the first distance.

It is preferable that the light reuse sheet of the first aspect of the invention further include a base, and the reflection forming layer is formed on an upper face of the base.

It is preferable that the light reuse sheet of the first aspect of the invention further include a base, and the reflection forming layer and the base are formed in an integrated manner.

In the light reuse sheet of the first aspect of the invention, it is preferable that the reflection forming layer include a reflecting layer having a high reflectance, and the reflecting surface serves as a surface of the reflecting layer.

In the light reuse sheet of the first aspect of the invention, it is preferable that the reflection forming layer contain a scattering reflector which scatters and reflects light.

In the light reuse sheet of the first aspect of the invention, it is preferable that an angle θr between a parallel plane parallel to the light incident surface and the reflecting surface at a predetermined position which is located along the reflecting surface increase in a manner that the predetermined position approaches the front plate along the reflecting surface.

In the light reuse sheet of the first aspect of the invention, it is preferable that, where an angle between the parallel plane and the reflecting surface at a position at which a distance between the reflecting surface and the front plate is maximum in the uneven portion is represented as θrb, an array pitch of the uneven portion is represented as S, a depth of the uneven portion is represented as d, tan $(90°-2θrb)·S/2 > d$ be satisfied.

In the light reuse sheet of the first aspect of the invention, it is preferable that, in a direction perpendicular to a plane parallel to the light incident surface and in a direction opposite to an incident direction of the first light, a distance between a second inclined portion and the light incident surface be greater than a distance between a first inclined portion and the light incident surface, and an angle between a first inclined portion and the parallel plane be greater than an angle between a second inclined portion and the parallel plane.

It is preferable that the light reuse sheet of the first aspect of the invention further include a plurality of uneven portions formed in a strip shape extending in one direction, and the uneven portions are arrayed in parallel to each other along an interface between the reflection forming layer and the filling layer.

It is preferable that the light reuse sheet of the first aspect of the invention further include a plurality of uneven portions formed in a strip shape extending in one direction, and the uneven portions are arrayed so as to intersect with each other along an interface between the reflection forming layer and the filling layer.

It is preferable that the light reuse sheet of the first aspect of the invention further include a plurality of uneven portions which are constituted of independent optical components, the optical components being arrayed in a two-dimensional direction.

In the light reuse sheet of the first aspect of the invention, it is preferable that the optical elements be formed in any of substantially circular cone shape, substantially pyramid shaped, substantially ellipsoidal cone shape, substantially circular cylinder shape, substantially truncated circular cone shape, substantially truncated pyramid shape, substantially truncated ellipsoidal cone shape, substantially hemisphere, substantially half-ellipse, or substantially U-shape in cross-sectional shape.

In the light reuse sheet of the first aspect of the invention, it is preferable that the optical components constituting the uneven portions be micro lenses which are arrayed along an interface between the reflecting layer and the filling layer.

A solar battery module of a second aspect of the invention includes the above-described light reuse sheet of the first aspect of the invention.

In order to achieve the above-described object, a light reuse sheet of a third aspect of the invention is used for a solar battery module. The solar battery module includes: a transparent front plate having a light incident surface to which light is incident; a filling layer which is stacked on a face opposite to the light incident surface and through which the light passing through the front plate is transmitted; and a solar battery cell which is implanted into the filling layer and has a light receiving face located at a face opposed to the front plate, the solar battery cell converting the light transmitted through the filling layer into electric energy by receiving the light by the light receiving face. Specifically, the light reuse sheet of the third aspect of the invention is provided at a face of the filling layer opposite to the light receiving face of the solar battery cell. The light reuse sheet includes: a reflection forming layer having an uneven portion; and a reflecting surface provided at a surface of the uneven portion. The light reuse sheet generates second light by reflecting first light toward the front plate, the first light being transmitted through the filling layer without being received by the light receiving face of the solar battery cell, the light reuse sheet generates third light by reflecting the second light at an interface between the light incident surface and outside of the front plate, and the light reuse sheet causes the third light to be incident to the light receiving face of the solar battery cell. Straight light that is part of the first light is reflected by the reflecting surface and is thereby converted into second light traveling toward the front plate while having a first angle with respect to the straight light, and the second light having the first angle is reflected by a first interface portion of the front plate so as to be converted into the third light, the first interface portion being arranged separately from the uneven portion by a first distance. Refracted light that is part of the first light is reflected by the reflecting surface and is thereby converted into second light traveling toward the front plate while having a second angle that is greater than the first angle with respect to the straight light, and the second light having the second angle is reflected by a second interface portion of the front plate so as to be converted into the third light, the second interface portion being arranged separately from the uneven portion by a second distance that is greater than the first distance.

It is preferable that the light reuse sheet of the third aspect of the invention further include a base, and the reflection forming layer is formed on an upper face of the base.

It is preferable that the light reuse sheet of the third aspect of the invention further include a base, and the reflection forming layer and the base are formed in an integrated manner.

In the light reuse sheet of the third aspect of the invention, it is preferable that the reflection forming layer include a reflecting layer having a high reflectance, and the reflecting surface serves as a surface of the reflecting layer.

In the light reuse sheet of the third aspect of the invention, it is preferable that the reflection forming layer contain a scattering reflector which scatters and reflects light.

In the light reuse sheet of the third aspect of the invention, it is preferable that an angle $\theta r$ between a parallel plane parallel to the light incident surface and the reflecting surface at a predetermined position which is located along the reflecting surface decrease in a manner that the predetermined position approaches the front plate along the reflecting surface.

In the light reuse sheet of the third aspect of the invention, it is preferable that, where an angle between the parallel plane and the reflecting surface at a position at which a distance between the reflecting surface and the front plate is maximum in the uneven portion is represented as $\theta rb$, an array pitch of the uneven portion is represented as S, a height of the uneven portion is represented as h, $\tan(90° - 2\theta rb) \cdot S/2 > h$ is satisfied.

It is preferable that the light reuse sheet of the third aspect of the invention further include a plurality of uneven portions formed in a strip shape extending in one direction, and the uneven portions are arrayed in parallel to each other along an interface between the reflection forming layer and the filling layer.

It is preferable that the light reuse sheet of the third aspect of the invention further include a plurality of uneven portions formed in a strip shape extending in one direction, and the uneven portions are arrayed so as to intersect with each other along an interface between the reflection forming layer and the filling layer.

It is preferable that the light reuse sheet of the third aspect of the invention further include a plurality of uneven portions which are constituted of independent optical components, the optical components being arrayed in a two-dimensional direction.

In the light reuse sheet of the third aspect of the invention, it is preferable that the optical elements be formed in any of substantially circular cone shape, substantially pyramid shaped, substantially ellipsoidal cone shape, substantially circular cylinder shape, substantially truncated circular cone shape, substantially truncated pyramid shape, substantially truncated ellipsoidal cone shape, substantially hemisphere, substantially half-ellipse, or substantially U-shape in cross-sectional shape.

In the light reuse sheet of the third aspect of the invention, it is preferable that the optical components constituting the uneven portions be micro lenses which are arrayed along an interface between the reflecting layer and the filling layer.

A solar battery module of a fourth aspect of the invention includes the light reuse sheet of the above-described third aspect of the invention.

Effects of the Invention

According to the invention, it is possible to effectively reuse light that have been conventionally lost to improve the use efficiency of light and improve power generation efficiency of the solar battery module.

BRIEF DESCRIPTION OF THE DRAWINGS

FIG. 1 is a cross-sectional view illustrating a solar battery module according to an embodiment of the invention.
FIG. 2 is an enlarged cross-sectional view illustrating a light reuse sheet according to the embodiment of the invention.
FIG. 3 is a perspective view illustrating an example of a reflecting convex portion provided in a reflection forming layer of the light reuse sheet according to the embodiment of the invention.
FIG. 4A is a diagram illustrating the operation of a conventional reflecting portion.
FIG. 4B is a diagram illustrating the operation of a conventional reflecting portion.
FIG. 4C is a diagram illustrating the operation of a conventional reflecting portion.
FIG. 5A is a diagram illustrating the operation of a reflecting portion according to the invention.
FIG. 5B is a diagram illustrating the operation of the reflecting portion according to the invention.
FIG. 6 is an enlarged cross-sectional view illustrating a light reuse sheet of a solar battery module according to an embodiment of the invention.
FIG. 7 is a plan view illustrating the arrangement relationship between a light reuse sheet and solar battery cells of a solar battery module according to the invention.
FIG. 8 is a plan view illustrating the arrangement relationship between a light reuse sheet and solar battery cells of a solar battery module according to the invention.
FIG. 9 is a plan view illustrating the arrangement relationship between a light reuse sheet and solar battery cells of a solar battery module according to the invention.
FIG. 10 is a plan view illustrating the arrangement relationship between a light reuse sheet and solar battery cells of a solar battery module according to the invention.
FIG. 11 is a partial enlarged perspective view illustrating an example of the arrangement of reflecting concave portions of a light reuse sheet according to the invention.
FIG. 12A is a diagram illustrating a modification of an optical component formed in a reflection forming layer of the light reuse sheet according to the invention.
FIG. 12B is a diagram illustrating a modification of the optical component formed in the reflection forming layer of the light reuse sheet according to the invention.
FIG. 12C is a diagram illustrating a modification of the optical component formed in the reflection forming layer of the light reuse sheet according to the invention.
FIG. 13 is a diagram illustrating a modification of the optical component formed in the reflection forming layer of the light reuse sheet according to the invention.
FIG. 14A is a diagram illustrating a modification of the optical component formed in the reflection forming layer of the light reuse sheet according to the invention.
FIG. 14B is a diagram illustrating a modification of the optical component formed in the reflection forming layer of the light reuse sheet according to the invention.
FIG. 15 is a diagram illustrating a modification of the optical component formed in the reflection forming layer of the light reuse sheet according to the invention.

FIG. 16 is a diagram illustrating a modification of the optical component formed in the reflection forming layer of the light reuse sheet according to the invention.

FIG. 17A is a diagram illustrating a modification of the optical component formed in the reflection forming layer of the light reuse sheet according to the invention.

FIG. 17B is a diagram illustrating a modification of the optical component formed in the reflection forming layer of the light reuse sheet according to the invention.

FIG. 17C is a diagram illustrating a modification of the optical component formed in the reflection forming layer of the light reuse sheet according to the invention.

FIG. 18 is a diagram illustrating a modification of the optical component formed in the reflection forming layer of the light reuse sheet according to the invention.

FIG. 19A is an enlarged cross-sectional view illustrating a light reuse sheet of a solar battery module according to an embodiment of the invention.

FIG. 19B is an enlarged cross-sectional view illustrating a light reuse sheet of a solar battery module according to an embodiment of the invention.

FIG. 20A is an enlarged cross-sectional view illustrating a light reuse sheet of a solar battery module according to an embodiment of the invention.

FIG. 20B is an enlarged cross-sectional view illustrating a light reuse sheet of a solar battery module according to an embodiment of the invention.

FIG. 21 is a cross-sectional view illustrating a solar battery module according to an embodiment of the invention.

FIG. 22 is a cross-sectional view illustrating a solar battery module according to an embodiment of the invention.

FIG. 23 is a cross-sectional view illustrating a solar battery module according to an embodiment of the invention.

FIG. 24 is an enlarged cross-sectional view illustrating a light reuse sheet according to an embodiment of the invention.

FIG. 25 is a perspective view illustrating an example of a reflecting convex portion formed in a reflection forming layer of a light reuse sheet according to an embodiment of the invention.

FIG. 26A is a diagram illustrating the operation of a conventional reflecting portion.

FIG. 26B is a diagram illustrating the operation of a conventional reflecting portion.

FIG. 26C is a diagram illustrating the operation of a conventional reflecting portion.

FIG. 27 is a diagram illustrating the operation of a conventional reflecting portion.

FIG. 28A is a diagram illustrating the operation of a reflecting portion according to an embodiment of the invention.

FIG. 28B is a diagram illustrating the operation of a reflecting portion according to an embodiment of the invention.

FIG. 28C is a diagram illustrating the operation of a reflecting portion according to an embodiment of the invention.

FIG. 29 is an enlarged cross-sectional view illustrating a light reuse sheet of a solar battery module according to an embodiment of the invention.

FIG. 30 is a plan view illustrating the arrangement relationship between a light reuse sheet and solar battery cells of a solar battery module according to the invention.

FIG. 31 is a plan view illustrating the arrangement relationship between a light reuse sheet and solar battery cells of a solar battery module according to the invention.

FIG. 32 is a plan view illustrating the arrangement relationship between a light reuse sheet and solar battery cells of a solar battery module according to the invention.

FIG. 33 is a plan view illustrating the arrangement relationship between a light reuse sheet and solar battery cells of a solar battery module according to the invention.

FIG. 34 is a partial enlarged perspective view illustrating an example of the arrangement of reflecting convex portions in a light reuse sheet according to the invention.

FIG. 35A is a partial enlarged cross-sectional view illustrating a reflection forming layer of a light reuse sheet according to the invention and an example of the arrangement of reflecting convex portions formed in the reflection forming layer.

FIG. 35B is a partial enlarged cross-sectional view illustrating the reflection forming layer of the light reuse sheet according to the invention and an example of the arrangement of the reflecting convex portions formed in the reflection forming layer.

FIG. 35C is a partial enlarged cross-sectional view illustrating the reflection forming layer of the light reuse sheet according to the invention and an example of the arrangement of the reflecting convex portions formed in the reflection forming layer.

FIG. 36 is a diagram illustrating a modification of the optical component formed in the reflection forming layer of the light reuse sheet according to the invention.

FIG. 37A is a diagram illustrating a modification of the optical component formed in the reflection forming layer of the light reuse sheet according to the invention.

FIG. 37B is a diagram illustrating a modification of the optical component formed in the reflection forming layer of the light reuse sheet according to the invention.

FIG. 38 is a diagram illustrating a modification of the optical component formed in the reflection forming layer of the light reuse sheet according to the invention.

FIG. 39 is a diagram illustrating a modification of the optical component formed in the reflection forming layer of the light reuse sheet according to the invention.

FIG. 40A is a diagram illustrating a modification of the optical component formed in the reflection forming layer of the light reuse sheet according to the invention.

FIG. 40B is a diagram illustrating a modification of the optical component formed in the reflection forming layer of the light reuse sheet according to the invention.

FIG. 40C is a diagram illustrating a modification of the optical component formed in the reflection forming layer of the light reuse sheet according to the invention.

FIG. 41 is a diagram illustrating a modification of the optical component formed in the reflection forming layer of the light reuse sheet according to the invention.

FIG. 42A is an enlarged cross-sectional view illustrating a light reuse sheet of a solar battery module according to an embodiment of the invention.

FIG. 42B is an enlarged cross-sectional view illustrating a light reuse sheet of a solar battery module according to an embodiment of the invention.

FIG. 43A is an enlarged cross-sectional view illustrating a light reuse sheet of a solar battery module according to an embodiment of the invention.

FIG. 43B is an enlarged cross-sectional view illustrating a light reuse sheet of a solar battery module according to an embodiment of the invention.

FIG. 44 is a cross-sectional view illustrating a solar battery module according to an embodiment of the invention.

FIG. 45 is a cross-sectional view illustrating a solar battery module according to an embodiment of the invention.

FIG. 46 is a diagram illustrating examples and Comparative example 1 of the invention.

FIG. 47 is a cross-sectional view illustrating a conventional battery module.

DESCRIPTION OF THE PREFERRED EMBODIMENTS

Hereinafter, embodiments of the invention will be described with reference to the drawings.

In the drawings used in the following description, the scale of each component has been suitably altered in order to make each component have a recognizable size.

(First Embodiment)

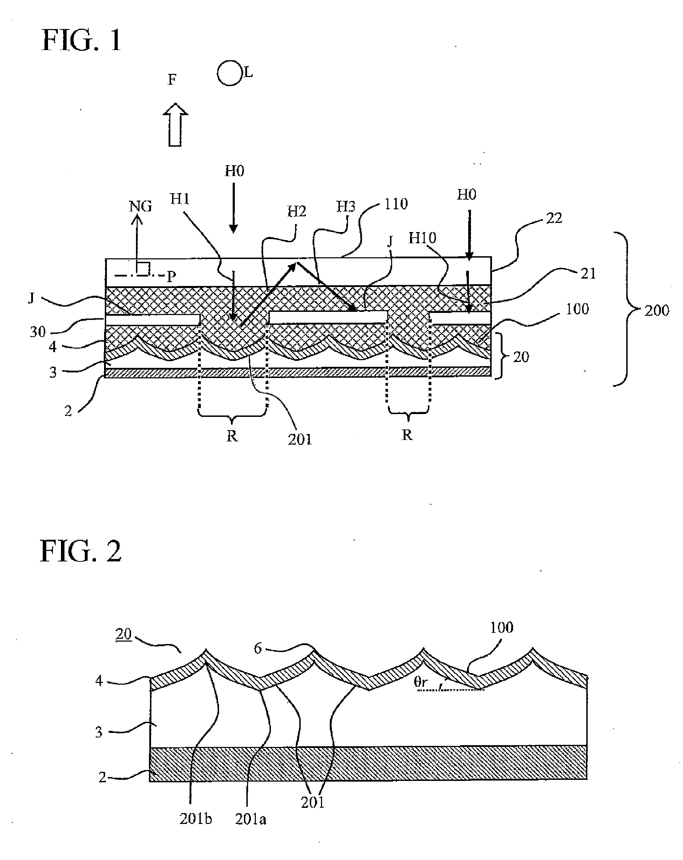

FIG. 1 is a cross-sectional view illustrating a solar battery module according to an embodiment of the invention.

FIG. 2 is an enlarged cross-sectional view illustrating a light reuse sheet according to this embodiment.

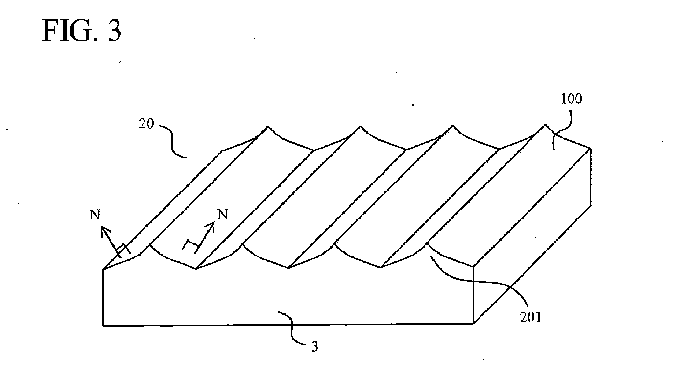

FIG. 3 is a perspective view illustrating an example of a reflecting concave portion formed in a reflection forming layer of the light reuse sheet according to this embodiment.

As shown in FIG. 1, a solar battery module 200 includes a light reuse sheet 20, a filling layer 21, and a front plate 22.

The light reuse sheet 20, the filling layer 21, and the front plate 22 are laminated in this order.

A plurality of solar battery cells 30 is arranged at a constant pitch in a matrix in a direction parallel to the plane of the filling layer 21 in the filling layer 21.

The front plate 22 is a transparent plate through which light emitted from a light source L such as sunlight or illumination light is transmitted.

The front plate 22 protects the solar battery cells 30 from, for example, impact, contamination, and the infiltration of water and is made of a transparent material with high transmittance.

For example, the front plate 22 is made of glass, such as toughened glass or sapphire glass, or a resin sheet, such as PC (polycarbonate) or PEN (polyethylene naphthalate).

When the front plate 22 is made of toughened glass, the thickness thereof is in the range of approximately 3 mm to 6 mm. When the front plate 22 is made of a resin sheet, the thickness thereof is in the range of 100 $\mu$m to 3000 $\mu$m.

As shown in FIGS. 1 and 2, the light reuse sheet 20 includes a base 2 and a reflection forming layer 3 that is formed on the upper surface of the base 2.

A plurality of concave portions 201 that reflects light is formed in the upper surface of the reflection forming layer 3 along a plane parallel to a plane P which is parallel to a light incident surface 110 of the front plate 22.

The cross-sectional area of the concave portion 201 in the plane parallel to the plane P which is parallel to the light incident surface 110 increases as a portion of the surface of the concave portion 201 becomes closer to the front plate 22 in the depth direction of the concave portion 201.

The concave portion 201 has a curved reflecting surface.

The concave portion 201 is formed such that the angle θr between the plane P parallel to the light incident surface 110 of the front plate 22 and the reflecting surface of the concave portion 201 increases as the reflecting surface of the concave portion 201 becomes closer to the front plate 22 in the depth direction of the concave portion 201.

The reflecting surface of the concave portion 201 is covered with a metal reflecting layer 4 having high reflectance.

The surface of the reflecting layer 4 is a reflecting surface 100.

The filling layer 21 is formed on the reflecting surface 100.

The concave portion 201 according to the first embodiment is formed in a strip shape extending in one direction, as shown in FIG. 3.

The strip-shaped concave portions 201 are arranged in parallel to each other along the plane parallel to the light incident surface 110 of the front plate 22.

As the structure of the concave portions 201, a plurality of independent optical components having a concave lens shape may be arranged at a constant pitch or at random in the two-dimensional direction.

The filling layer 21 seals the solar battery cell 30.

The filling layer 21 is made of a material with high light transmittance in order to transmit light H0 incident on the filling layer 21.

The filling layer 21 is generally made of, for example, flame-resistant EVA (ethylene vinyl acetate).

As shown in FIG. 1, the light H0 is emitted from the light source L from the sunlight or illumination light side F and is vertically incident on the light incident surface 110 of the front plate 22. The light H0 incident on the front plate 22 passes through the front plate 22 and travels to the filling layer 21.

A normal line NG of the light incident surface 110 is parallel to the normal line of the plane P when the front plate 22 is arranged in the most stable state on the plane P.

The light vertically incident on the light incident surface 110 is incident on the solar battery module 200 in parallel to the normal line NG.

Among the light components H0 incident on the front plate 22, light H10 passes through the filling layer 21 and is then incident on the solar battery cell 30 and light H1 travels to the light reuse sheet 20.

The solar battery cell 3 0 has a function of converting light incident on a light receiving surface J into electric energy using the photoelectric effect and is selected from a large number of different types of solar battery cells such as monocrystalline silicon solar battery cells, polycrystalline silicon solar battery cells, thin-film silicon solar battery cells, and CIGS (Cu-In-Ga-Se compound) solar battery cells.

A plurality of solar battery cells 30 is connected to an electrode to form a module.

The light H10 that is incident on the solar battery cell 30 from the filling layer 21 is converted into electric energy by the solar battery cell 30.

In general, the percentage of light reflected from the light incident surface 110 in the light that is obliquely incident on the light incident surface 110 is greater than that of light reflected from the light incident surface 110 in the light H0 that is vertically incident on the light incident surface 110. Therefore, a small amount of light is incident on the solar battery cell 3 0 and the amount of light used to generate power is small.

Therefore, when the incident light H0 is vertically incident on the light incident surface 110, the maximum efficiency is obtained.

When the incident light H0 is vertically incident on the light incident surface 110, that is, when the sun is substantially vertically disposed relative to the light incident surface 110, it is possible to improve optical efficiency.

Therefore, the relative position between the sun and the solar battery module has a great effect on the improvement of the overall efficiency of the solar battery module.

The light reuse sheet 20 according to the embodiment of the invention has a structure capable of obtaining the maximum optical efficiency when the incident light H0 is vertically incident on the light incident surface 110.

The light reuse sheet 20 has a function of reflecting light passing through the solar battery cell 30 or the light H1 incident between adjacent solar battery cells 30 from the reflecting surface 100 of the light reuse sheet 20.

The light H2 reflected from the reflecting surface 100 is reflected again from, for example, the interface between the front plate 22 and air and becomes light H3 that is incident on the light receiving surface J of the solar battery cell 30. The light H3 is converted into electric energy by the solar battery cell 30.

In this way, it is possible to improve the use efficiency of light, as compared to the solar battery module without the light reuse sheet 20.

The effect of reusing light is noticeable when the incident light H0 is vertically or substantially vertically incident on the light incident surface 110.

The reflected light H2 is converted into the light H3 with the highest efficiency and the light H3 is converted into electric energy by the solar battery cell 30.

The traveling direction of the reflected light H2 shown in FIG. 1 can be controlled by the structure of the concave portions 201 forming the reflecting surface 100 of the light reuse sheet 20.

In this way, it is possible to make a large amount of light incident on the light receiving surface J.

In FIGS. 3 to 6, a normal line N is a straight line vertical to a tangent plane at any point on the reflecting surface 100.

In FIG. 4A, a sheet normal line NB is vertical to the direction of the plane P of the V-shaped uneven structure of the light reuse sheet 20.

The angle θr of the reflecting surface 100 is formed between the reflecting surface 100 and the plane P.

In general, the sheet normal line NB is arranged in parallel to the normal line NG of the incident surface 100. Therefore, the incident light H1 is incident in parallel to the sheet normal line NB.

As shown in FIG. 1, photoelectric conversion is not performed in a region R between adjacent solar battery cells 30, that is, in the region in which the solar battery cell 30 is not provided.

However, the light H1 that passes through the region R and is then incident on the light reuse sheet 20 is reflected to the light receiving surface J of the solar battery cell 30. In this way, it is possible to effectively use the light H1.

In this case, as shown in FIG. 4A, when the incident angle θ2 of light on the interface between the front plate 22 and air is sufficiently large, the light H2 that passes through the region R, is incident on the reflecting surface 100 and is then reflected from the reflecting surface 100 is sufficiently reflected as the light H2 from the interface between the front plate 22 and air in a specific direction.

Therefore, it is possible to make the reflected light H2 effectively incident on the solar battery cell 30.

When the angle formed between the incident light H1 and the reflected light H2 increases, it is possible to make the reflected light H2 incident on the light receiving surface J of a distant solar battery cell 30.

Therefore, it is possible to use the light H1 that is incident on a portion that is away from the solar battery cell 30 and the amount of light incident on the light receiving surface of the solar battery cell increases. As a result, it is possible to improve the use efficiency of light.

In order to improve the use efficiency of light, it is necessary to increase the angle θr of the reflecting surface 100. When the angle formed between the incident light H1 and the reflected light H2 is greater than or equal to 35 degrees, a sufficient effect is obtained.

That is, it is preferable that the angle θr of the reflecting surface 100 be greater than or equal to 17.5 degrees (= 35/2 degrees).

However, when the angle θr is greater than 30 degrees, as shown in FIG. 4B, the light H1 incident on the reflecting surface 100 is reflected from the reflecting surface 100 of the uneven structure to a reflecting surface 100a adjacent to the reflecting surface 100.

Light H4 that is incident on the adjacent reflecting surface 100a again and is continuously reflected by the reflecting surfaces 100 and 100a is generated.

The phenomenon in which light incident on the reflecting surface 100 is incident on the adjacent reflecting surface 100a again and is continuously reflected from the reflecting surfaces 100 and 100a is referred to as multiple reflection.

The incident angle θ2 of the multi-reflected light H4 on the interface between the front plate 22 and air is less than 35 degrees. Therefore, the light is not sufficiently reflected and a portion of the light is converted into light H5 emitted to air. As a result, light loss that does not contribute to the photoelectric effect occurs.

Therefore, when the angle θr of the reflecting surface 100 of the concave portion 201 is less than or equal to 30 degrees, multiple reflection does not occur. It is preferable that the angle θr of the reflecting surface 100 of the concave portion 201 be less than or equal to 30 degrees.

When the angle θr of the reflecting surface 100 of the concave portion 201 is less than 17.5 degrees, as shown in FIG. 4C, multiple reflection does not occur in the light H1 incident on the reflecting surface 100 of the concave portion 201, as shown in FIG. 4B.

However, since the incident angle θ2 of the light H4 is less than 35 degrees, the light H2 reflected from the reflecting surface 100 of the concave portion 201 is not sufficiently reflected from the interface between the front plate 22 and air and is converted into the light H5 that is emitted to air. As a result, light loss occurs.

In this case, it is difficult to sufficiently reflect the light H1 that is vertically incident on the region R between the adjacent solar battery cells 30 of the solar battery module 200 to the solar battery cell 30.

Therefore, a sufficient amount of light is not incident on the light receiving surface of the solar battery cell.

When the angle θr of the reflecting surface 100 of the concave portion 201 is greater than or equal to 17.5 degrees, the incident angle θ2 is greater than 35 degrees. Therefore, it is preferable that the angle θr of the reflecting surface 100 of the concave portion 201 be greater than or equal to 17.5 degrees.

Therefore, it is preferable that the structure of the concave portion 201 of the light reuse sheet 20 be set to an angle at which multiple reflection does not occur after the light H1 is reflected from the reflecting surface 100 of the concave portion 201 and a sufficient amount of light H2 is reflected from the interface between the front plate 22 and air, as shown in FIG. 4A.

In addition, in the concave portion 201, it is preferable that the percentage of the area in which the angle θ1 of the reflecting surface 100 is from 17.5 degrees to 30 degrees is greater than or equal to that of the area in which the angle θr of the reflecting surface 100 is less than 17.5 degrees and greater than 30 degrees.

In the concave portion 201, when the percentage of the area in which the angle θr of the reflecting surface 100 is from 17.5 degrees to 30 degrees is less than that of the area in which the angle θr of the reflecting surface 100 has the other values, it is difficult to make a sufficient amount of light incident on the light receiving surface of the solar battery cell.

The concave portion 201 having the reflecting surface 100 has a microscopic convex shape.

There is a scattering region called a Mie scattering region in the range that is approximately ten times the wavelength of light.

Since a visible light region is from 460 nm to 780 nm, a smoothing process for smoothing the surface with a roughness less than or equal to 7.8 $\mu$m can be performed to calculate the normal line N.

It is preferable to use a laser microscope in the measuring method.

In addition, an optical microscope or an electron microscope may be used to measure the cross section.

In this case, the sheet normal line NB can be regarded as a line vertical to a sample table having the light reuse sheet 20 placed thereon.

It is preferable that the angle θr of the reflecting surface 100 be as large as possible.

In this case, when the light H2 reflected from the reflecting surface 100 is incident on the interface between the front plate 22 and air, the incident angle θ2 increases, and a sufficient amount of light is likely to be reflected.

However, as shown in FIG. 4B, when the angle θr of the reflecting surface 100 is simply large, multiple reflection occurs and the light H2 reflected from the reflecting surface 100 passes through the front plate 22 without being sufficiently reflected from the interface between the front plate 22 and air. As a result, light loss occurs.

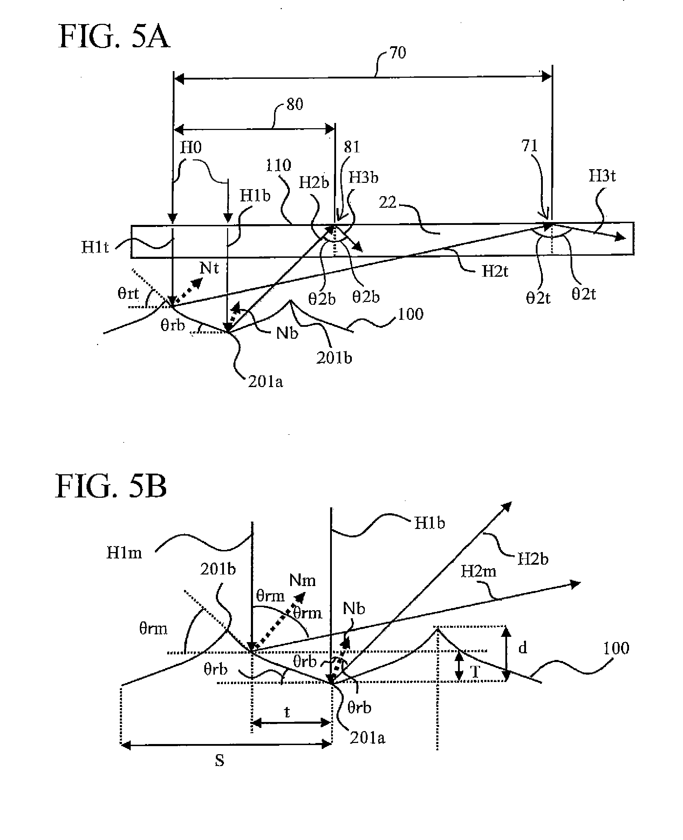

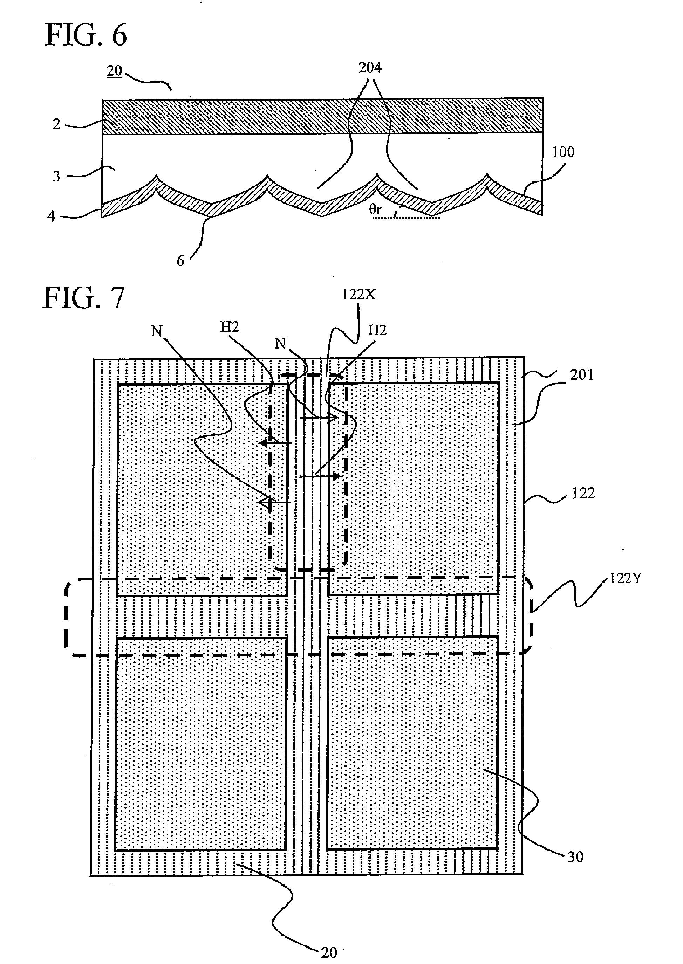

In the invention, in order to achieve the concave portion 201 capable of increasing the angle θr and preventing the occurrence of multiple reflection, the structure shown in FIGS. 5A, 5B, and 6 is used.

The first embodiment will be described with reference to FIGS. 2, 5A, and 5B.

FIG. 2 is an enlarged cross-sectional view illustrating the light reuse sheet of the solar battery module according to the first embodiment of the invention.

FIGS. 5A and 5B are diagrams illustrating the light reuse sheet according to this embodiment.

As shown in FIGS. 2, 5A, and 5B, the light reuse sheet 20 according to the first embodiment includes the base 2 and the reflection forming layer 3 that is formed on the upper surface of the base 2.

A plurality of concave portions 201 that reflects light is formed in the upper surface of the reflection forming layer 3 along a plane parallel to the plane P which is parallel to the light incident surface 110 of the front plate 22.

The cross-sectional area of the concave portion 201 in the plane P parallel to the front plate 22 increases from the bottom 201a of the concave portion 201 to the top 201 b of the concave portion 201 in the depth direction of the concave portion 201, that is, toward the front plate 22.

The concave portion 201 has a curved reflecting surface.

The angle θr between the parallel plane P and the reflecting surface of the concave portion 201 at a predetermined position on the concave portion 201 increases as the predetermined position is moved from the bottom 201a of the concave portion 201 to the top 201b of the concave portion 201 along the reflecting surface 100.

That is, the angle θr is changed such that an angle θrb at a position close to the bottom 201a is small and an angle θrt at a position that is close to the top 201b is large.

The reflecting surface of the concave portion 201 is covered with the metal reflecting layer 4 having high reflectance.

The surface of the reflecting layer 4 is the reflecting surface 100.

The filling layer 21 shown in FIG. 1 is formed on the reflecting surface 100.

In FIGS. 5A and 5B, Nb indicates a normal line in the vicinity of the bottom 201 a of the concave portion 201 and Nt indicates a normal line in the vicinity of the top 201b of the concave portion 201.

In other words, the light reuse sheet 20 according to the first embodiment includes the reflection forming layer 3 including the concave portions 201 (uneven portion) each having the top 201b (first inclined portion) and the bottom 201a (second inclined portion) and the reflecting surface 100 provided on the surface of the concave portion 201.

The light reuse sheet 20 reflects incident light components H1, H1b, and H1t (first light) that pass through the filling layer 21 without being received by the light receiving surface J of the solar battery cell 30 to the front plate 22 and generates reflected light components H2b and H2t (second light).

The light components H2b and H2t reflected from the light reuse sheet 20 are reflected from the interface between the light incident surface 110 and the outside of the front plate 22 and reflected light components H3b and H3t (third light) are generated.

The reflected light components H3b and H3t are incident on the light receiving surface J of the solar battery cell 30 by the light reuse sheet 20.

In the light reuse sheet 20, the reflected light H2t (second light) generated by reflection caused by the top 201b has a first angle with respect to the incident light H1t (first light) and travels to the front plate 22.

The reflected light H2t is reflected from a first interface portion 71 of the front plate 22 that is a first distance 70 away from the concave portion 201 and is converted into the reflected light H3t (third light).

In the light reuse sheet 20, the reflected light H2b (second light) generated by reflection caused by the bottom 201a has a second angle less than the first angle with respect to the incident light H1b (first light) and travels to the front plate 22.

The reflected light H2b is reflected from a second interface portion 81 of the front plate 22 that is a second distance 80 less than the first distance 70 away from the concave portion 201 and is converted into the reflected light H3b (third light).

The first angle is two time more than the angle formed between the reflecting surface 100 of the top 201b and the plane P.

The second angle is two times the angle formed between the reflecting surface 100 of the bottom 201a and the plane P.

In FIG. 5A, the top 201b corresponds to the first inclined portion. In FIG. 5B, an intermediate portion which is the starting point of the normal line Nm corresponds to the first inclined portion.

In the light reuse sheet 20 having the above-mentioned structure according to the first embodiment, among the incident light components H1 that are vertically incident on the light incident surface 110 of the front plate 22, the light H1b that is incident in the vicinity of the bottom 201 a of the concave portion 201 is incident on the reflecting surface 100 that is inclined at the angle θrb, is reflected from the reflecting surface 100, and is converted into the light H2b, as shown in FIG. 5A.

The light H2b is generated by the reflecting surface 100 in the vicinity of the bottom 201a of the concave portion 201 serving as a first member and is not incident on the reflecting surface 100 of the concave portion 201 serving as a second member adjacent to the first member.

The light H2b is incident on the interface between the front plate 22 and air at an incident angle θ2b, is sufficiently reflected from the interface, and is converted into the light H3b.

In the light reuse sheet 20, among the incident light components H0 that are vertically incident on the light incident surface 110 of the front plate 22, the light H1t that is incident in the vicinity of the top 201b of the concave portion 201 is incident on the reflecting surface 100 which is inclined at the angle θrt, is reflected from the reflecting surface 100, and is converted into the light H2t, as shown in FIG. 5A.

The light H2t is generated by the reflecting surface 100 in the vicinity of the top 201b of the concave portion 201 serving as the first member and is not incident on the reflecting surface 100 of the concave portion 201 serving as the second member adjacent to the first member.

The light H2t is incident on the interface between the front plate 22 and air at an incident angle θ2t, is sufficiently reflected from the interface, and is converted into the light H3t.

In the light reuse sheet 20, the angle θrt is greater than the angle θrb.

Therefore, the incident angle θ2t of light on the interface between the front plate 22 and air is greater than the incident angle θ2b, and the probability of light being sufficiently reflected from the interface between the front plate 22 and air increases. It is possible to improve the use efficiency of light.

The shape of the concave portion 201 where the above-mentioned effect is obtained satisfies the following Expressions 1 and 2:

$$(\text{Expression 1}) \quad \theta rb < \theta rm < \theta rt;$$

and

$$(\text{Expression 2}) \quad \tan(90° - 2\theta rb) \times S/2 > d.$$

In the above-mentioned expressions, θrb indicates the angle formed between the parallel plane P and the reflecting surface 100 and indicates the angle formed between the reflecting surface 100 and the plane P at a position where the distance between the front plate 22 and the surface of the concave portion 201 is the maximum, that is, in the vicinity of the bottom in the cross-section of a periodic structure.

In addition, θrt indicates the angle between the parallel plane P and the reflecting surface 100 and indicates the angle formed between the reflecting surface 100 and the plane P at a position where the distance between the front plate 22 and the surface of the concave portion 201 is the minimum, that is, in the vicinity of the top in the cross-section of the periodic structure.

θrm indicates the angle formed between the parallel plane P and the reflecting surface 100 and indicates the angle in an intermediate portion between the bottom and the top.

S indicates the pitch between the concave portions 201.

d indicates the depth of the concave portion 201.

As described above, since the shape of the concave portion 201 satisfies Expression 1, light incident on the light reuse sheet 20 is reflected by the reflecting surface 100 of a portion close to the top and the incident angle of light on the interface between the front plate 22 and air increases.

Therefore, the probability of light being sufficiently reflected from the interface between the front plate 22 and air increases.

In Expression 2, as shown in FIG. 5B, since the angle formed between the light H1b and the normal line Nb of the reflecting surface 100 is equal to the angle $\theta$rb of the reflecting surface 100, the angle formed between the light H2b reflected from the reflecting surface 100 and the plane direction (parallel plane P) is 90°-2$\theta$rb.

In the shape of the concave portion 201 satisfying Expression 2, light that is vertically incident in the vicinity of the bottom in the cross-section of the periodic structure is reflected without multiple reflection. Therefore, the light is deflected to the light receiving surface J of the solar battery cell 30 with high efficiency.

The shape of the reflecting surface is not limited to the curved shape shown in FIGS. 5A and 5B.

For example, the reflecting surface may have a polygonal shape having two or more sides in a cross-sectional view.

Alternatively, the shape of the reflecting surface may be a combination of the polygonal shape and the curved shape.

In the above-mentioned structure, it is important that multiple reflection does not occur in the light H1b which is incident in the vicinity of the bottom 201a of the concave portion 201 and the angle $\theta$rm increases as a position on the reflecting surface having the angle $\theta$rm becomes closer to the sunlight or illumination light side F.

Conditions for achieving the above-mentioned structure are represented by the following Expression 3:

$$(\text{Expression 3}) \quad \tan (90°\text{-}2\theta\text{rm})(\text{S/2}+t) > \text{d-T}.$$

In Expression 3, $\theta$rm indicates the angle formed between the reflecting surface 100 in the vicinity of the top 201 b of the concave portion 201 and the parallel plane P parallel to the light incident surface 110 of the front plate 22.

In addition, S indicates the pitch between the concave portions 201.

d indicates the depth of the concave portion 201.

t indicates the distance between the position of the starting point of the normal line Nb in the vicinity of the bottom 201a of the concave portion 201 and the position of the starting point of the normal line Nm in the vicinity of the top 201b of the concave portion 201 in a direction parallel to the parallel plane P.

T indicates the distance (height) between the position of the starting point of the normal line Nb in the vicinity of the bottom 201a of the concave portion 201 and the position of the starting point of the normal line Nm in the vicinity of the top 201b of the concave portion 201 in a direction vertical to the parallel plane P.

In the optical path of light H2m based on Expression 3, when the light H2m that is incident on the reflecting surface 100 of the concave portion 201 serving as the first member and then reflected and deflected travels to the vicinity of the top 201b of the concave portion 201 closest to the light H2m in the deflection direction, that is, when the light H2m travels a distance (S/2+t) in the direction parallel to the plane P, the light H2m passes through the position that is closer to the front plate 22 than to the top 201b of the concave portion 201 serving as the second member adjacent to the first member.

That is, the light H2m is not incident on the reflecting surface 100 of the top 201b.

Therefore, multiple reflection does not occur.

It is preferable that the angles $\theta$rb, $\theta$rm, and $\theta$rt satisfy 17.5° ≤ $\theta$rb < $\theta$rin < $\theta$rt < 45°.

When the angles $\theta$rb, $\theta$rm, and $\theta$rt of the reflecting surface 100 are greater than or equal to 17.5 degrees, the light H2 reflected from the reflecting surface 100 is incident on the interface between the front plate 22 and air at a sufficiently large angle even though light is incident on the reflecting surface 100 at any position.

In this way, a sufficient amount of light is reflected and deflected to the light receiving surface J of the solar battery cell 30 with high efficiency.

When the angles $\theta$rb, $\theta$rm, and $\theta$rt of the reflecting surface 100 are greater than or equal to 45 degrees, the light H2 reflected from the reflecting surface 100 is deflected in the direction parallel to the front plate 22 or from the front plate 22 to the sunlight or illumination light side F.

Therefore, it is preferable that the angle $\theta$r of the reflecting surface 100 be less than 45 degrees.

(Second Embodiment)

FIG. 6 is an enlarged cross-sectional view illustrating a light reuse sheet of a solar battery module according to a second embodiment of the invention.

A light reuse sheet 20 according to the second embodiment is a modification of the first embodiment.

The second embodiment differs from the first embodiment in the following structure.

The second embodiment has a structure reverse to that of the first embodiment.

That is, a light transmissive base 2 is provided on a filling layer having solar battery cells which are implanted thereinto.

A reflection forming layer 3 is provided on the lower surface of the base 2 opposite to the filling layer.

A reflecting surface 100 having a concave curve shape that is reverse to the shape of the concave portion 201 according to the first embodiment and has the same inclination angle as the concave portion 201 is formed on the lower surface of the reflection forming layer 3 opposite to the base 2.

In the light reuse sheet 20 having the above-mentioned structure according to the second embodiment, a plurality of reflecting concave portions 204 is formed along a plane parallel to the plane P which is parallel to a light incident surface of a front plate.

The reflecting surface of the concave portion 204 is covered with a reflecting layer 4 with high reflectance.

In this case, the interface between the reflecting layer 4 and the concave portion 204 is the reflecting surface 100.

In the second embodiment, the same operation and effect as those in the first embodiment are obtained.

In the light reuse sheet 20 having the shape shown in FIG. 6, the angle between the top 6 of a structure layer (reflection forming layer) and the plane P is greater than that in the structure shown in FIG. 2.

Therefore, it is possible to easily mold the light reuse sheet 20 with a desired shape.

After molding, resistance to, for example, damage and friction is improved. As a result, handling ability is improved.

(Third Embodiment)

FIG. 7 is a plan view illustrating the arrangement relationship between a light reuse sheet and solar battery cells of a solar battery module according to a third embodiment of the invention.

In the third embodiment, as shown in FIG. 7, a plurality of rectangular solar battery cells 30 of the solar battery module is arranged in a matrix at a constant pitch in the X direction and the Y direction on the plane.

In a light reuse sheet 20, a region 122 in which the solar battery cell 30 is not provided is formed between adjacent solar battery cells 30.

In the region 122, strip-shaped concave portions 201 that have the reflecting surface according to the above-described embodiments and extend in the longitudinal direction (X direction) of the light reuse sheet 20 are arranged at a constant pitch in parallel to the width direction (the lateral direction of the light reuse sheet 20; the Y direction) of the light reuse sheet 20.

In this case, the use efficiency of light incident on the concave portion 201 in a region 122X is high.

In FIG. 7, an arrow N indicates a normal line of the reflecting surface of the strip-shaped concave portion 201 and an arrow H2 indicates the direction in which light is reflected from the reflecting surface of the concave portion 201 to the solar battery cell 30.

(Fourth Embodiment)

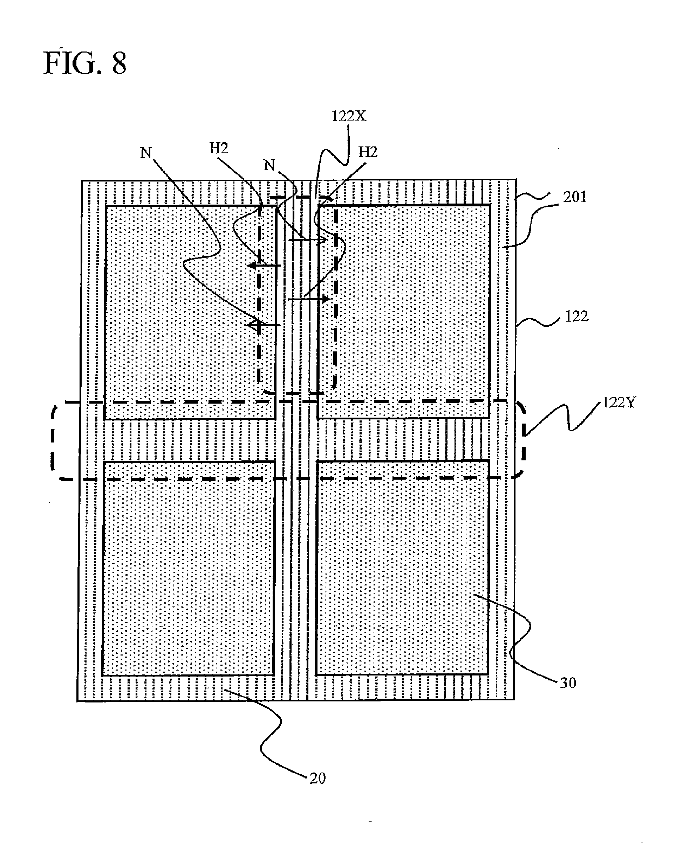

FIG. 8 is a plan view illustrating the arrangement relationship between a light reuse sheet and solar battery cells of a solar battery module according to a fourth embodiment of the invention.

In the fourth embodiment, as shown in FIG. 8, a plurality of rectangular solar battery cells 30 of the solar battery module is arranged in a matrix at a constant pitch in the X direction and the Y direction on the plane.

In a light reuse sheet 20, a region 122 in which the solar battery cell 30 is not provided is formed between adjacent solar battery cells 30.

In the region 122, strip-shaped concave portions 201 having the reflecting surface according to the above-described embodiments extend in an oblique direction intersecting the longitudinal direction of the light reuse sheet 20 and are arranged in parallel to each other at a constant pitch.

In FIG. 8, an arrow N1 indicates a normal line of the reflecting surface of the concave portion 201 and an arrow H2 indicates the direction in which light is reflected from the reflecting surface of the concave portion 201 to the solar battery cell 30.

In the solar battery module having the above-mentioned structure, the concave portion 201 is arranged such that the intersection angle between the direction in which the strip-shaped concave portion extends and the direction in which the side of the solar battery cell 30 extends has an optional value.

In this way, it is possible to convert light incident on the region 122 into the light H2 reflected from the reflecting surface of the concave portion 201 and make the light H2 incident on the solar battery cell 30, as compared to FIG. 7.

Therefore, it is possible to deflect light with high efficiency.

(Fifth Embodiment)

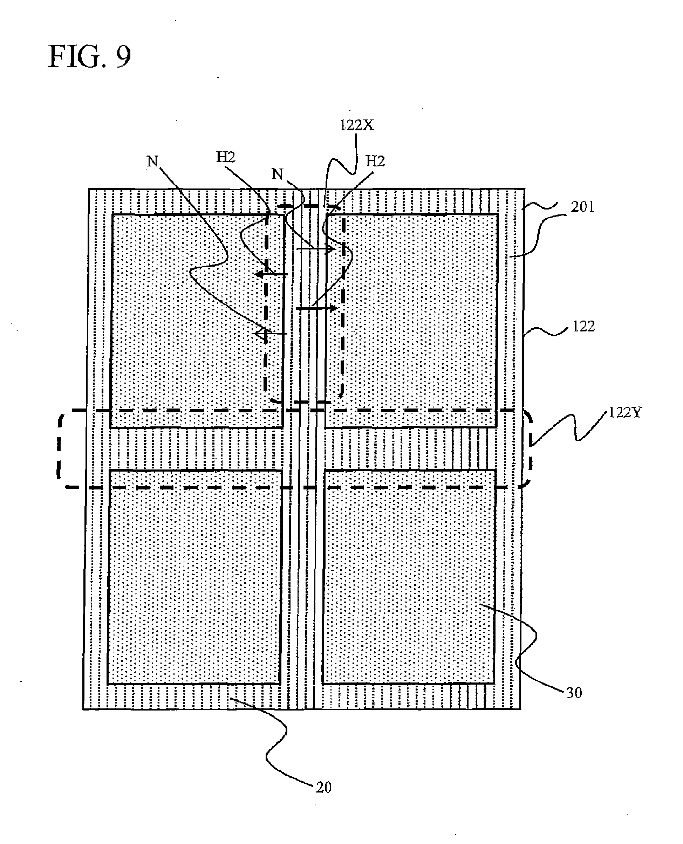

FIG. 9 is a plan view illustrating the arrangement relationship between a light reuse sheet and solar battery cells of a solar battery module according to a fifth embodiment of the invention.

In the fifth embodiment, as shown in FIG. 9, a plurality of rectangular solar battery cells 30 of the solar battery module is arranged in a matrix at a constant pitch in the X direction and the Y direction on the plane.

In a light reuse sheet 20, a region 122 in which the solar battery cell 30 is not provided is formed between adjacent solar battery cells 30.

A reflecting region 120 including strip-shaped concave portions having the curved reflecting surface according to the above-described embodiments is provided in the region 122.

In FIG. 9, an arrow N indicates a normal line of the curved reflecting surface of the strip-shaped concave portion and an arrow H2 indicates the direction in which light is reflected from the reflecting surface of the concave portion to the solar battery cell 30.

In the solar battery module having the above-mentioned structure, since the reflecting region 120 is arranged so as to surround the solar battery cell 30 in correspondence with the position of the solar battery cell 30, it is possible to effectively deflect the light H2 reflected from the reflecting region 120 with the solar battery cell 30.

(Sixth Embodiment)

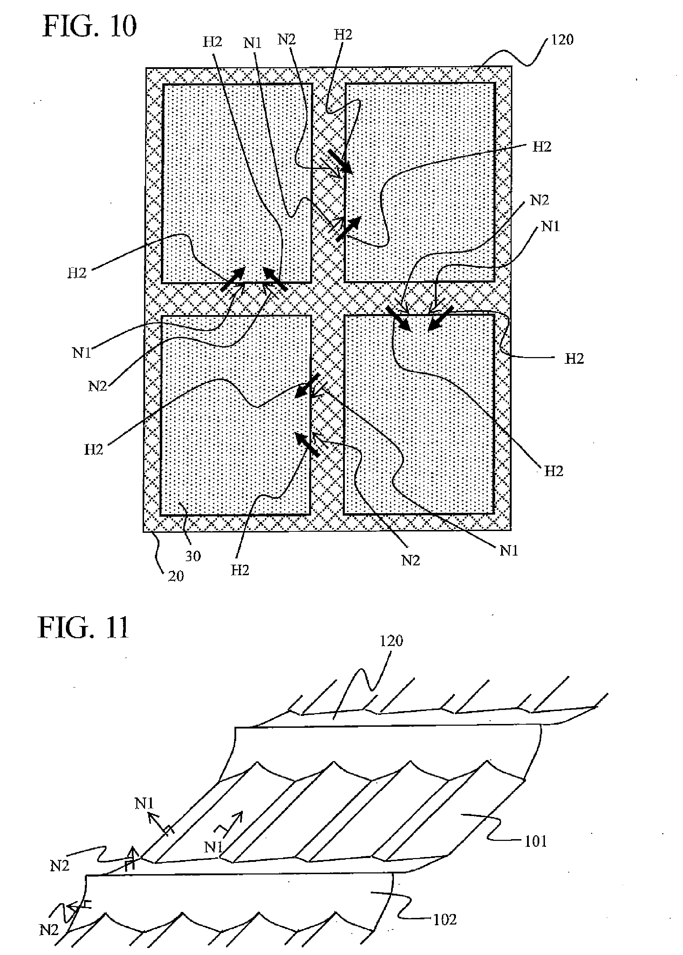

FIG. 10 is a plan view illustrating the arrangement relationship between a light reuse sheet and solar battery cells of a solar battery module according to a sixth embodiment of the invention.

In the sixth embodiment, as shown in FIG. 10, a plurality of rectangular solar battery cells 30 of the solar battery module is arranged in a matrix at a constant pitch in the X direction and the Y direction on the plane.

In a light reuse sheet 20, a region 122 in which the solar battery cell 30 is not provided is formed between adjacent solar battery cells 30.

A reflecting region 120 formed by arranging the strip-shaped concave portions having the reflecting surface according to the above-described embodiments so as to intersect each other is provided in the region 122.

In FIG. 10, arrows N1 and N2 indicate normal lines of the reflecting surfaces of the concave portions intersecting each other and an arrow H2 indicates the direction in which light is reflected from the reflecting surfaces of the concave portions intersecting each other to the solar battery cell 30.

The intersection angle between the strip-shaped concave portions may be appropriately set and is preferably in the range of 30 degrees to 90 degrees.

As such, in the light reuse sheet 20, when the reflecting region 120 formed by arranging the strip-shaped concave portions so as to intersect each other is used, one side of the rectangular solar battery cell 30 intersects the strip-shaped concave portion.

It is preferable to arrange the solar battery cell 30 and the strip-shaped concave portion such that the light H2 reflected from the reflecting surface of the concave portion is deflected to the solar battery cell 30.

When the strip-shaped concave portions are arranged as shown in FIG. 10, it is possible to use the light reuse sheet 20 in which the shape of the concave portion is uniform in the plane, as compared to FIG. 9.

In this way, it is easy to align the solar battery cells 30 and the light reuse sheet 20 and it is possible to simplify a manufacturing process.

(Seventh Embodiment)

FIG. 11 is a partial enlarged perspective view illustrating an example of the arrangement of reflecting concave portions in a light reuse sheet according a seventh embodiment of the invention.

As shown in FIG. 11, a reflecting region 120 of a light reuse sheet 20 according to the seventh embodiment is formed by combining a plurality of first concave portions 101 and a plurality of second concave portions 102.

Specifically, a plurality of first strip-shaped concave portions 101 having the reflecting surface according to the above-described embodiments are arranged so as to be adjacent to each other in the width direction.

The plurality of second strip-shaped concave portions 102 longer than the first concave portion 101 and the plurality of first concave portions 101 are combined so as to intersect each other.

In FIG. 11, arrows N1 and N2 indicate normal lines of the reflecting surfaces of the first concave portion 101 1 and the second concave portion 102 that intersect each other.

The intersection angle between the first concave portion 101 and the second concave portion 102 of the reflecting region 120 according to the seventh embodiment may be appropriately set and is preferably in the range of 30 degrees to 90 degrees.

(Eighth Embodiment)

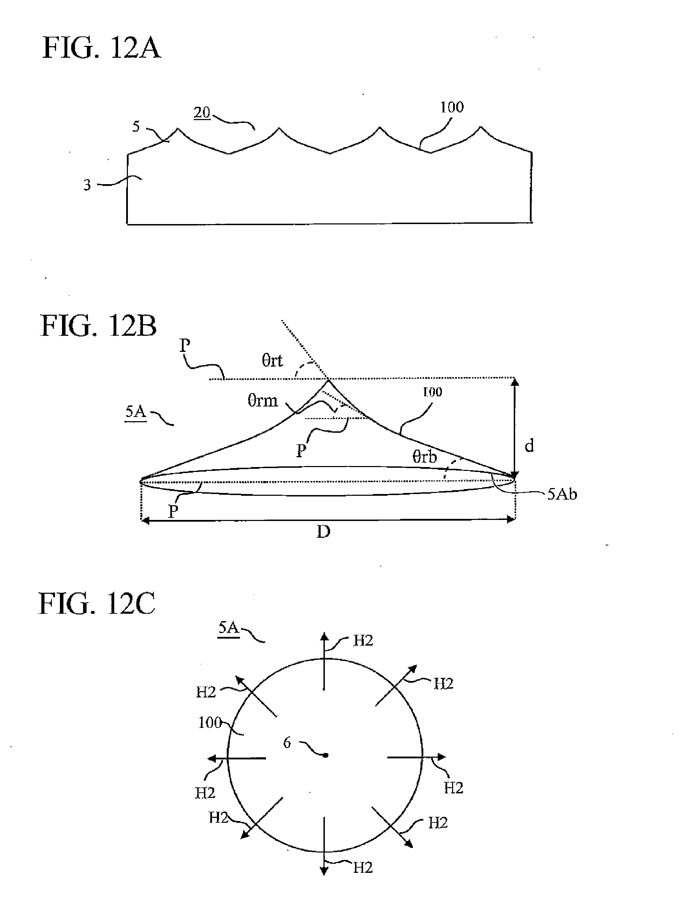

FIGS. 12A to 12C are partial enlarged cross-sectional views illustrating a reflection forming layer of a light reuse sheet according to an eighth embodiment of the invention and an example of the arrangement of reflecting concave portions formed in the reflection forming layer.

In the seventh embodiment, the reflecting concave portions that are integrally formed on the upper surface of a reflection forming layer 3 of a light reuse sheet 20 are independent optical components 5, as shown in FIGS. 12B and 12C.

For example, the reflecting concave portion is formed by a combination of microlenses 5A that have a substantially circular cone shape and include a reflecting surface 100.

The optical components 5 are arranged on the upper surface of the reflection forming layer 3 in a two-dimensional direction at a constant pitch or a random pitch to form the light reuse sheet 20.

In the optical component 5A shown in FIG. 12B, D indicates a diameter and d indicates the height from the base to the top.

The optical component 5A has a convex circular cone shape.

The external surface of the optical component 5A forms the reflecting surface 100 having a quadratic curve shape.

In FIG. 12B, the angle formed between the reflecting surface 100 and the plane P at the base of the optical component 5A is represented by $\theta rb$ and the angle formed between the reflecting surface 100 and the plane P at the top of the optical component 5A is represented by $\theta rb$.

The angle formed between the reflecting surface 100 and the plane P in an intermediate portion between the top and the base of the optical component 5A is represented by $\theta rm$.

The angle $\theta rm$ is set so as to increase as the intermediate portion becomes closer to the top of the optical component 5A from the base.

In the optical component 5A, similarly to the case shown in FIGS. 5A and 5B, light that is incident in the vicinity of a base 5Ab of the optical component 5A is incident on the reflecting surface 100 having the angle $\theta rb$, is reflected from the reflecting surface 100, and becomes the same reflected light as the light H2b shown in FIGS. 5A and 5B.

The reflected light is not incident on the reflecting surface 100 of an adjacent optical component 5A and is incident on the interface between air and the light reflecting surface of the front plate shown in FIGS. 5A and 5B at an incident angle $\theta 2b$. Then, the light is sufficiently reflected.

In this case, since the angles $\theta rm$ and $\theta rt$ are greater than the angle $\theta rb$, the incident angle of light on the interface between the light incident surface of the front plate and air is greater than the angle $\theta rb$.

In this way, the probability of a sufficient amount of light being reflected from the interface between the light incident surface of the front plate and air increases, and it is possible to improve the use efficiency of light.

In the light reuse sheet 20 shown in FIG. 12C that is obtained by arranging the independent optical components 5 shown in FIG. 12B in the two-dimensional direction, the light H2 that is incident on the reflecting surface 100 of the optical component 5 and then reflected is radially deflected.

That is, in FIG. 12C, it is possible to deflect light in the two-dimensional direction, as compared to the case in which the strip-shaped concave portions are arranged as shown in FIGS. 3 or 11.

Therefore, it is not necessary to adjust the position of the solar battery cell and the position of the light reuse sheet 20 as shown in FIGS. 7 to 10 and it is possible to simplify a manufacturing process and prevent a reduction in the use efficiency of light due to a defect in the alignment between the solar battery cell and the light reuse sheet.

(Ninth Embodiment)

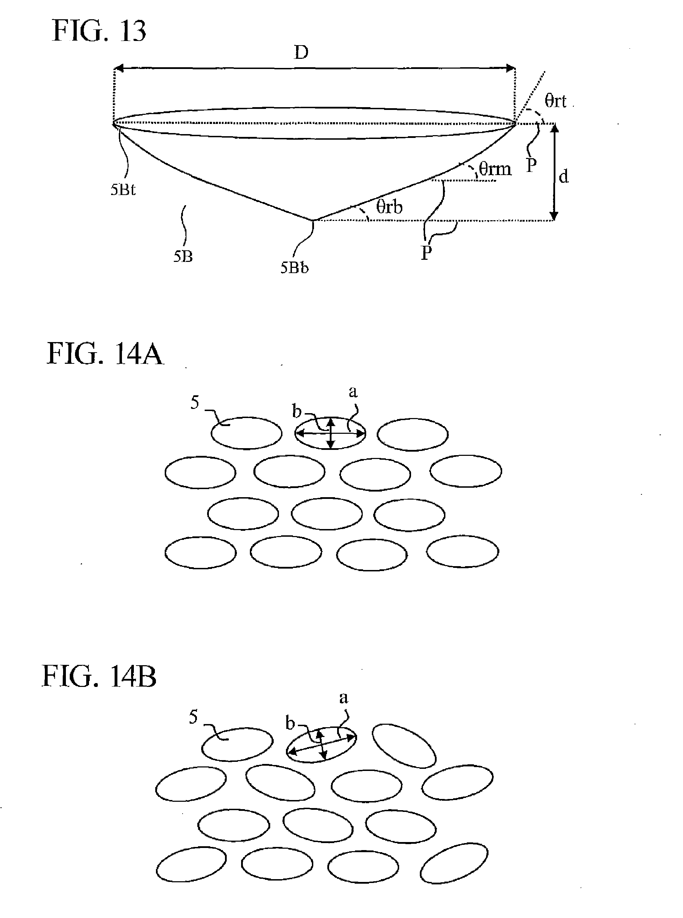

FIG. 13 is a diagram illustrating a modification of the optical component formed in the reflection forming layer of the light reuse sheet according to the invention.

An optical component 5B shown in FIG. 13 has a concave circular cone shape having a diameter D and a depth d.

A reflecting surface 100 having a quadratic curve shape is provided on the inner surface of the optical component 5B.

The angle formed between the reflecting surface 100 and the plane P at the bottom 5Bb of the optical component 5B is represented by $\theta rb$ and the angle formed between the reflecting surface 100 and the plane P in an opening 5Bt of the optical component 5B is represented by $\theta rt$.

In the optical component 5B, the angle formed between the reflecting surface 100 and the plane P in an intermediate portion between the bottom 5Bb and the opening 5Bt is represented by θrm.

The angle θrm is set so as to increase as the intermediate portion becomes closer to the opening 5Bt of the optical component 5A from the bottom 5Bb.

In the optical component 5B, similarly to the case shown in FIGS. 5A and 5B, light that is incident in the vicinity of the bottom 5Bb of the optical component 5B is incident on the reflecting surface 100 having the angle θrb and is then reflected from the reflecting surface 100. Then, the light becomes the same reflected light as the light H2b shown in FIGS. 5A and 5B.

The reflected light is not incident on the reflecting surface 100 of an adjacent optical component 5B, but is incident on the interface between air and the light reflecting surface of the front plate shown in FIGS. 5A and 5B at an incident angle θ2b. Then, the light is sufficiently reflected.

In this case, since the angles θrm and θrt are greater than the angle θrb, the incident angle of light on the interface between the light incident surface of the front plate and air is greater than the angle θrb.

In this way, the probability of a sufficient amount of light being reflected from the interface between the light incident surface of the front plate and air increases, and it is possible to improve the use efficiency of light.

The optical element 5A shown in FIG. 12B and the optical element 5B shown in FIG. 13 may be configured such that the opening portion has a substantially circular shape, a substantially elliptical shape, and a polygonal shape and polygonal concave lens portions curved in a concave shape are arranged without any gap.

(Tenth Embodiment)

FIGS. 14A and 14B are diagrams illustrating a modification of the optical component formed in the reflection forming layer of the light reuse sheet according to the invention.

An optical component 5 shown in FIG. 14A has an elliptical cone shape having a long axis a and a short axis b.

The side surface of the optical component 5 has the same reflecting surface as that of, for example, the optical element 5A shown in FIG. 12B or the optical element 5B shown in FIG. 13.

A plurality of optical components 5 is arranged at a constant pitch such that the long axes a thereof are parallel to each other, thereby forming a light reuse sheet.

Since the optical component 5 has an elliptical cone shape, it is possible to strongly deflect light reflected from the reflecting surface of the optical component 5 in any direction.

In particular, when an opening portion has an elliptical shape, it is possible to strongly deflect light in a direction that is substantially orthogonal to the long axis a of the ellipse.

Therefore, since the direction that is substantially orthogonal to the long axis a of the ellipse is aligned with the solar battery cell, it is possible to improve the use efficiency of light.

The optical component 5 shown in FIG. 14B has an elliptical cone shape having a long axis a and a short axis b.

The side surface of the optical component 5 has the same reflecting surface as that of, for example, the optical element 5A shown in FIG. 12B or the optical element 5B shown in FIG. 13.

A plurality of optical components 5 is arranged at a non-uniform pitch such that the long axes a thereof are not parallel to each other, thereby forming a light reuse sheet.

When the optical components 5 are arranged in this way, an in-plane variation in the direction of the long axis a is statistically controlled, and it is thereby possible to strongly deflect reflected light in an optional range in the radial direction.

(Eleventh Embodiment)

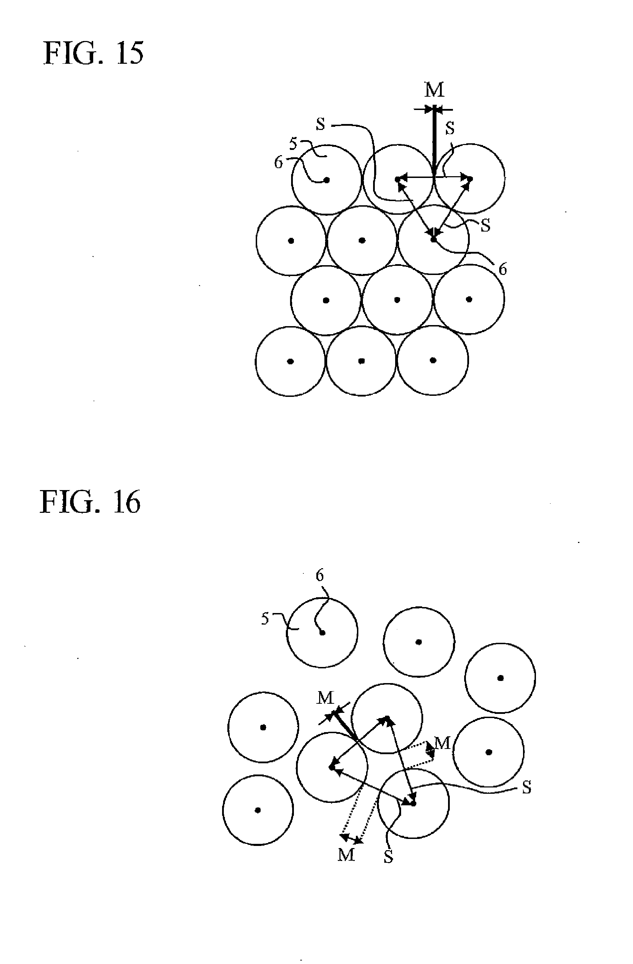

FIG. 15 is a diagram illustrating a modification of the optical component formed in the reflection forming layer of the light reuse sheet according to the invention.

An optical component 5 according to an eleventh embodiment is a microlens that has a dome shape or a substantially circular cone shape and includes an opening portion with a substantially circular shape.

In a light reuse sheet according to this modification, a plurality of optical components 5 is relatively densely and geometrically arranged.

Specifically, the optical components 5 are arranged on a plurality of light reuse sheets such that a regular triangle lattice pattern is formed by lines S (S corresponds to the pitch between the optical components 5) linking the tops 6 (the bottoms 6 when the optical component 5 is, for example, the optical element 5B shown in FIG. 13) of three adjacent optical components 5.

In the arrangement pattern, the pitch S between the tops 6 of the optical components 5 and the distance M between adjacent optical components 5 are constant. Therefore, it is possible to densely arrange the optical components 5, which are microlenses.

(Twelfth Embodiment)

FIG. 16 is a diagram illustrating a modification of the optical component formed in the reflection forming layer of the light reuse sheet according to the invention.

An optical component 5 according to an eleventh embodiment is a microlens that has a dome shape or a substantially circular cone shape and includes an opening portion with a substantially circular shape.

In the light reuse sheet according to this modification, a plurality of optical components 5 is arranged such that the pitch S between the optical components 5 and the distance M between adjacent optical components 5 are set at random.

The term "random" means that the pitch S between the tops 6 of the optical components 5 and the distance M between the optical components 5 are substantially irregular in any region of the light reuse sheet.

Therefore, even when a plurality of optical components 5 is regularly arranged in a very small portion of any region, a structure in which a plurality of optical components 5 is irregularly arranged in the entire region is included in the "random" structure.

As described above, when the plurality of optical components 5 is arranged at random, the following effect is obtained.

That is, when a texture structure is provided in order to prevent the reflection of light incident on the light incident surface of the front plate, it is possible to prevent the generation of bright and dark fringes due to the interference between the structure of the light reuse sheet and the texture structure of the front plate.

As shown in FIG. 15, when the optical components 5 having a circular opening portion are arranged in a regular triangle lattice pattern and there is a small variation in the pitch S between the tops 6 of the optical components 5 and the distance M between the optical components 5 in the plane, brightness unevenness is observed in the entire light reuse sheet.

For this reason, a small variation in distance is emphasized and visible in the structure in which the optical components 5 are highly uniformly arranged.

As shown in FIG. 16, since the optical components 5 are arranged at random, it is possible to prevent brightness unevenness from being visible.

(Thirteenth Embodiment)

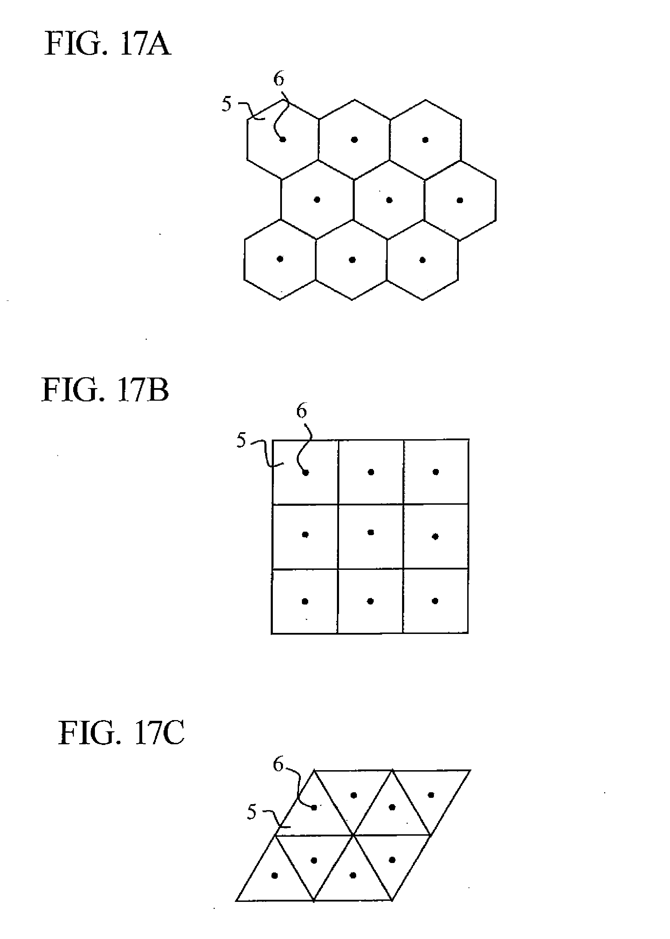

FIGS. 17A to 17C are diagrams illustrating a modification of the optical component formed in the reflection forming layer of the light reuse sheet according to the invention.

An optical component 5 shown in FIG. 17A is a microlens that has a substantially hexagonal pyramid shape and includes an opening portion with a regular hexagonal shape.

In the light reuse sheet according to this modification, a plurality of optical components 5 is arranged in a honeycomb shape so as to come into close contact with each other.

An optical component 5 shown in FIG. 17B is a microlens that has a substantially quadrangular pyramid shape and includes an opening portion with a square shape.

In the light reuse sheet, a plurality of optical components 5 is arranged in a matrix so as to come into close contact with each other.

An optical component 5 shown in FIG. 17C is a microlens that has a substantially triangular pyramid shape and includes an opening portion with a regular triangle shape.

In the light reuse sheet, a plurality of optical components 5 is arranged in a matrix so as to come into close contact with each other.

In FIGS. 17A to 17C, reference numeral 6 indicates the top of the optical component 5.

(Fourteenth Embodiment)

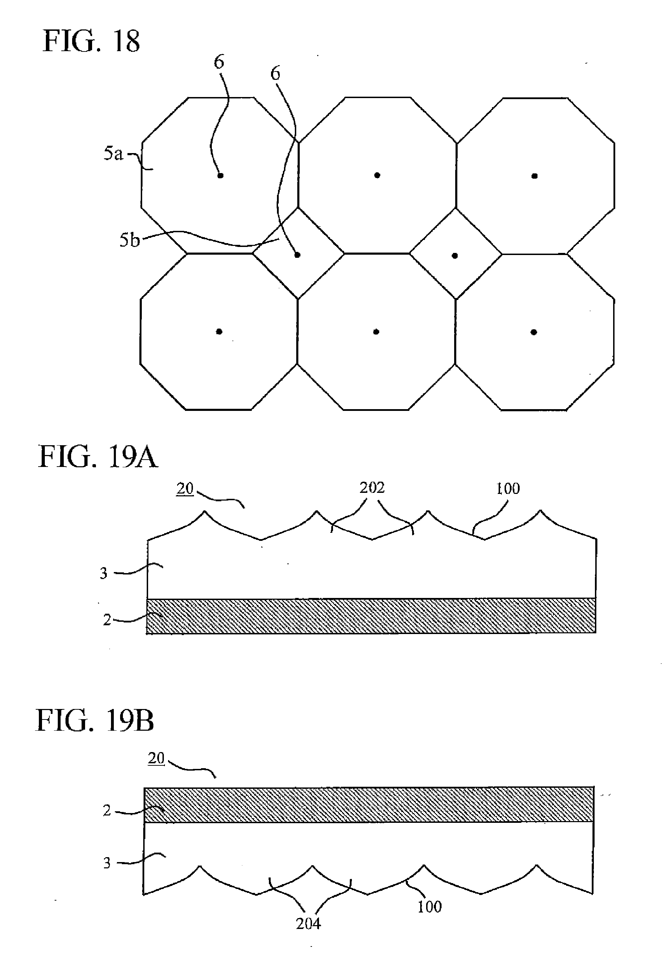

FIG. 18 is a diagram illustrating a modification of the optical component formed in the reflection forming layer of the light reuse sheet according to the invention.

In the modification shown in FIG. 18, a light reuse sheet includes an optical component 5a, which is a microlens that has a substantially octagonal pyramid shape and includes an opening portion with a regular octagon shape, and an optical component 5b, which is a microlens that has a substantially quadrangular pyramid shape and includes an opening portion with a square shape.

In the light reuse sheet, a plurality of optical components 5a and a plurality of optical components 5b are arranged in a matrix so as to come into close contact with each other.

In FIG. 18, reference numeral 6 indicates the tops of the optical components 5a and 5b.

As the arrangement of the optical components 5 or the optical components 5a and 5b according to this embodiment, it is preferable to use an arrangement structure in which an opening portion has a polygonal shape and a plurality of optical components is arranged without any gap, as shown in FIGS. 17A to 17C.

When a plurality of optical components is arranged without any gap, a flat portion between the optical components that does not deflect incident light to the solar battery cell is barely formed.

Therefore, it is possible to improve the use efficiency of light.

Since a plurality of optical components is arranged without any gap, it is possible to prevent a small distance variation occurring in the flat portion from being emphasized and visible. As a result, it is possible to prevent brightness unevenness.

As the structure in which a plurality of optical components is arranged without any gap, a structure in which the opening portions have a regular hexagonal shape, a square shape, or a regular triangular shape and the opening portions have the same shape may be used.

Since the optical components are formed such that the opening portions have the same shape, it is possible to form the optical components with the same dimensions and shape.

Therefore, it is possible to form a light reuse sheet that does not cause brightness unevenness.

In particular, when the opening portion has a regular hexagonal shape, a connecting portion for connecting adjacent opening portions is not formed in a straight line, but can be formed in zigzag which is more complicated than the straight line.

Therefore, when a texture structure is provided in order to prevent the reflection of the light H0 incident on the front plate 22, it is possible to prevent the generation of bright and dark fringes due to the interference between the structure of the light reuse sheet 20 and the texture structure of the front plate 22.

As shown in FIG. 18, a plurality of optical components may be arranged without any gap therebetween by combining the opening portions and different polygonal optical components 5a and 5b.

As the structure of the optical components, a structure in which convex portions having a substantially circular cone shape or a substantially polygonal pyramid shape are arranged may be used as well as the structure using only the concave portions, and the convex portions may be combined to form a structure including desired concave portions.

(Fifteenth Embodiment)

FIGS. 19A and 19B are enlarged cross-sectional views illustrating a light reuse sheet of a solar battery module according to a fifteenth embodiment of the invention.

A light reuse sheet 20 shown in FIG. 19A includes a base 2 and a reflection forming layer 3 that is formed on the upper surface of the base 2.

The reflection forming layer 3 is made of a material including a scattering reflector for improving a light reflecting performance and a heat resistance performance.

A plurality of strip-shaped reflecting concave portions 202 which is the same as that shown in FIG. 2 is formed in the upper surface of the reflection forming layer 3 so as to be arranged in parallel along the upper surface of the base 2.

The concave portion 202 has a curved reflecting surface 100.

In the light reuse sheet 20 having the above-mentioned structure, it is possible to omit the reflecting layer 4, as compared to the light reuse sheet 20 shown in FIG. 2, and it is possible to obtain the same operation and effect as those of the structure shown in FIGS. 5A and 5B.

The light reuse sheet 20 shown in FIG. 19B is a modification of the light reuse sheet shown in FIG. 19A.

The difference between the light reuse sheet shown in FIG. 19A and the light reuse sheet shown in FIG. 19B will be described below.

The structure of the light reuse sheet shown in FIG. 19B is reverse to that of the light reuse sheet shown in FIG. 19A. That is, the light transmissive base 2 is provided on the filling layer into which the solar battery cells are implanted.

The reflection forming layer 3 including the scattering reflector is provided on the surface of the base 2 opposite to the filling layer.

A plurality of strip-shaped reflecting concave portions 204 is formed on the surface of the reflection forming layer 3 opposite to the base 2 so as to be arranged in parallel along the lower surface of the base 2.

The plurality of strip-shaped reflecting concave portions 204 have a shape reverse to that of the concave portion 202 in the light reuse sheet shown in FIG. 19A and have a concave curved reflecting surface 100 having the same inclination angle as the reflecting surface of the concave portion 202.

In the light reuse sheet 20 having the above-mentioned structure, it is possible to omit the reflecting layer 4, as compared to the light reuse sheet 20 shown in FIG. 6, and it is possible to obtain the same operation and effect as those of the structure shown in FIGS. 5A and 5B.

As the structure of the light reuse sheets 20 shown in FIGS. 19A and 19B, a light reuse sheet including a plurality of independent optical components, which are concave portions or concave microlenses formed in the upper surface or the lower surface of the reflection forming layer 3, may be used.

As the structure of the light reuse sheet, a structure in which concave optical components are arranged on the upper surface or the lower surface of the reflection forming layer 3 in the two-dimensional direction at a constant pitch or a random pitch may be used.

As a method of forming the concave portions in the reflection forming layer 3, for example, the following method may be used.

First, for example, a thermosetting resin, an ultraviolet-curable resin, or an electron beam-curable resin is coated or injected onto a concavity and convexity forming surface of a plane stamper or a roller stamper.

Then, the base 2 is arranged on the coated or injected resin and a curing process is performed.

Then, the cured resin is demolded from the stamper.

(Sixteenth Embodiment)

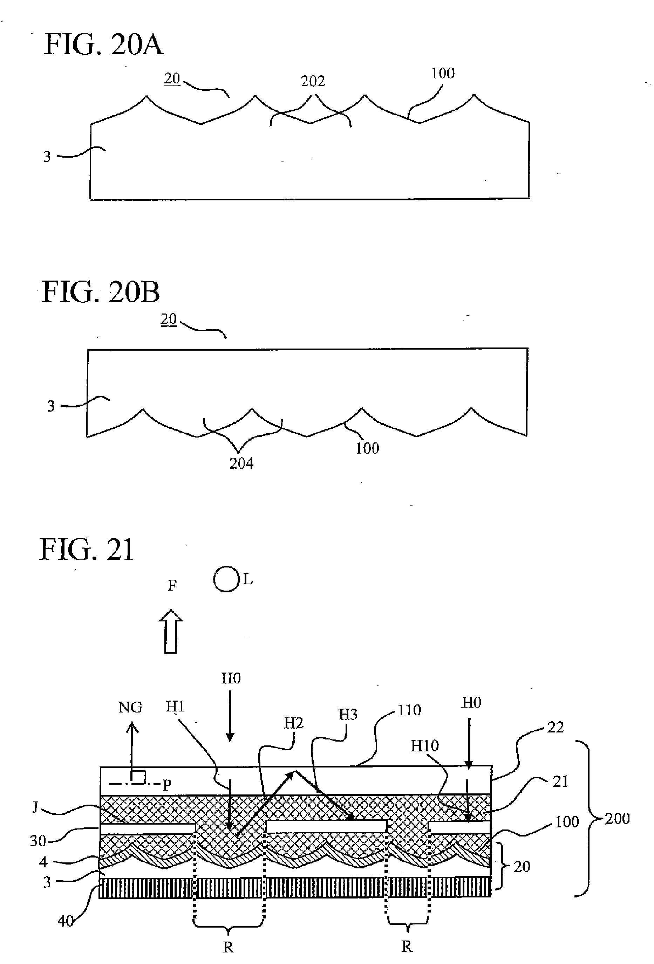

FIGS. 20A and 20B are enlarged cross-sectional views illustrating a light reuse sheet of a solar battery module according to a sixteenth embodiment of the invention.

A light reuse sheet 20 shown in FIG. 20A does not include the base 2 and includes only a reflection forming layer 3 including a scattering reflector for improving a light reflecting performance and a heat resistance performance.

A plurality of strip-shaped reflecting concave portions 202 which is the same as that shown in FIG. 19A is formed in the upper surface of the reflection forming layer 3 so as to be arranged in parallel to each other.

The concave portion 202 has a curved reflecting surface 100.

The light reuse sheet 20 having the above-mentioned structure has the same operation and effect as those shown in FIGS. 5A and 5B.

A light reuse sheet 20 shown in FIG. 20B is a modification of the light reuse sheet shown in FIG. 20A.

The light reuse sheet 20 does not include the base 2 and includes only a reflection forming layer 3 including a scattering reflector for improving a light reflecting performance and a heat resistance performance.

Next, the difference between the light reuse sheet shown in FIG. 20A and the light reuse sheet shown in FIG. 20B will be described.

The structure of the light reuse sheet shown in FIG. 20B is reverse to that of the light reuse sheet shown in FIG. 20A. That is, the plurality of strip-shaped reflecting concave portions 204 is formed in the lower surface of the reflection forming layer 3 so as to be arranged in parallel to each other.

The shape of the reflecting concave portion 204 is reverse to that of the concave portion 202 in the light reuse sheet shown in FIG. 20A and has a concave curved reflecting surface 100 having the same inclination angle as the concave curved reflecting surface of the concave portion 202.

The light reuse sheet 20 with the above-mentioned structure has the same operation and effect as those shown in FIGS. 5A and 5B.

For example, a press method, a casting method, an injection molding method, or an extrusion molding method using a mold is used to manufacture the light reuse sheets 20 shown in FIGS. 20A and 20B that do not include the base 2 but include only the reflection forming layer 3.

In the method, the uneven structure is formed at the same time as a process of forming a sheet body is performed.

The pitch between the concave portions forming the reflecting surface 100 is preferably less than or equal to 300 $\mu$m and more preferably less than or equal to 200 $\mu$m.

When the pitch between the concave portions is greater than 300 $\mu$m, a sufficient amount of resin is not filled into the mold of the bottom of the concave portion during the molding of the reflecting surface 100. As a result, moldability deteriorates.

Therefore, when the pitch between the concave portions is less than or equal to 200 $\mu$m, it is possible to perform molding even when a resin with a relatively high viscosity is used.

When the pitch between the concave portions and the convex portions is too small, it is difficult to manufacture a mold.

Therefore, the pitch is preferably greater than or equal to 25 $\mu$m and more preferably greater than or equal to 50 $\mu$m.

When the pitch between the concave portions is less than 25 $\mu$m, it takes a long time to cut the mold and the takt time is reduced, which results a reduction in production efficiency.

When the pitch between the concave portions is less than 50 $\mu$m, the resin is not properly filled into the grooves during the molding of the reflecting surface 100, and it is difficult to form the shape of the bottom of the concave portion and the top of the convex portion to the shape of the mold.

That is, it is difficult to appropriately transfer the shape of the mold to the light reuse sheet.

The thickness of the reflection forming layer 3 is not particularly limited. However, for example, the thickness of the reflection forming layer 3 is from 30 $\mu$m to 500 $\mu$m.

The above-mentioned manufacturing method may be appropriately selected according to its suitability for use with the following materials.

In addition to polymer compositions, for example, a scattering reflector, a curing agent, a plasticizer, a dispersing agent, various kinds of leveling agents, ultraviolet absorbing agents, antioxidants, viscosity modifiers, lubricants, and photostabilizers may be mixed with the polymer composition forming the reflection forming layer 3.

The above-mentioned polymer composition is not particularly limited.

Examples of the polymer composition include poly (meth) acrylic resins, polyurethane resins, fluorine resins, silicone resins, polyimide resins, epoxy resins, polyethylene resins, polypropylene resins, methacrylic resins, polymethylpentene resins, cyclic polyolefin resins, polystyrene resins, such as acrylonitrile (poly) styrene copolymers (AS resins) and acrylonitrile-butadiene-styrene copolymers (ABS resinss), polyvinyl chloride resins, polycarbonate resins, polyester resins, polyamide resins, polyamide imide resins, polyarylphthalate resins, polysulfone resins, polyphenylene sulfide resins, polyether sulfone resins, polyethylene naphthalate resins, polyether imide resins, acetal resins, and cellulose resins. One or two or more kinds of these polymers may be mixed for use.

Examples of the polyol which forms the raw material of the polyurethane resins include polyols obtained by polymerizing monomeric components that include hydroxyl-containing unsaturated monomers or polyester polyols obtained under conditions of an excess of hydroxyl. One or two or more kinds of the polyols may be mixed for use.

Examples of the hydroxyl-containing unsaturated monomer include: (a) hydroxyl-containing unsaturated monomers, such as 2-hydroxyethyl acrylate, 2-hydroxypropyl acrylate, 2-hydroxyethyl methacrylate, 2-hydroxypropyl methacrylate, allyl alcohol, homoallylic alcohol, cinnamic alcohol, and crotonyl alcohol; and (b) hydroxyl-containing unsaturated monomers obtained by the reaction between dihydric alcohols or epoxy compounds, such as ethylene glycol, ethylene oxide, propylene glycol, propylene oxide, butylene glycol, butylene oxide, 1,4-bis (hydroxymethyl) cyclohexane, phenyl glycidyl ether, glycidyl decanoate, and Placcel FM-1 (manufactured by Daicel Chemical Industries, Ltd.), and unsaturated carboxylic acids, such as acrylic acid, methacrylic acid, maleic acid, fumaric acid, crotonic acid, and itaconic acid.

It is possible to manufacture a polyol by polymerizing one or two or more kinds of these hydroxyl-containing unsaturated monomers.

The above-mentioned polyol may be manufactured by polymerizing one or two or more kinds of ethylenic unsaturated monomers selected from, for example, ethyl acrylate, n-propyl acrylate, isopropyl acrylate, n-butyl acrylate, tert-butyl acrylate, ethylhexyl acrylate, ethyl methacrylate, n-propyl methacrylate, isopropyl methacrylate, n-butyl methacrylate, tert-butyl methacrylate, ethylhexyl methacrylate, glycidyl methacrylate, cyclohexyl methacrylate, styrene, vinyl toluene, 1-methyl styrene, acrylic acid, methacrylic acid, acrylonitrile, vinyl acetate, vinyl propionate, vinyl stearate, allyl acetate, diallyl adipate, diallyl itaconate, diethyl maleate, vinyl chloride, vinylidene chloride, acrylamide, N-methylolacrylamide, N-butoxymethyl acrylamide, diacetone acrylamide, ethylene, propylene, and isoprene and the hydroxyl-containing unsaturated monomer selected from the above (a) and (b).

The number-average molecular weight of the polyol obtained by polymerizing a monomeric component containing the hydroxyl-containing unsaturated monomer is from 1000 to 500000 and preferably is from 5000 to 100000.

The hydroxyl value thereof is from 5 to 300, preferably from 10 to 200, and more preferably from 20 to 150.

The polyester polyol obtained under conditions of an excess of hydroxyl is manufactured by a reaction between (c) polyhydric alcohols, such as ethylene glycol, diethylene glycol, propylene glycol, dipropylene glycol, 1,3-butanediol, 1,4-butanediol, 1,5-pentanediol, neopentyl glycol, hexamethylene glycol, decamethylene glycol, 2,2,4-trimethyl-1,3-pentanediol, trimethylolpropane, hexanetriol, glycerin, pentaerythritol, cyclohexanediol, hydrogenated bisphenol A, bis (hydroxymethyl) cyclohexane, hydroquinone bis (hydroxyethyl ether), tris (hydroxyethyl) isocyanurate, and xylylene glycol, and (d) polybasic acids, such as maleic acid, fumaric acid, succinic acid, adipic acid, sebacic acid, azelaic acid, trimetic acid, terephthalate acid, phthalic acid, and isophthalic acid, under the condition that the hydroxyl group number in the polyhydric alcohol, such as propanediol, hexanediol, polyethylene glycol, and trimethylolpropane, is greater than the carboxyl group number of the polybasic acid.

The number-average molecular weight of the polyester polyol obtained under the above-described condition of excess hydroxyl is from 500 to 300000 and preferably is from 2000 to 100000.

The hydroxyl value thereof is from 5 to 300, preferably is from 10 to 200, and more preferably from 20 to 150.

The polyol that is used as the polymer material of the polymer composition is preferably the above-mentioned polyester polyol, or an acrylic polyol which is obtained by polymerizing a monomeric component containing the hydroxyl-containing unsaturated monomer and has, for example, a (meth) acrylic unit.

When a polyester polyol or an acrylic polyol is used as the polymer material, it is possible to improve weather resistance and prevent, for example, the yellowing of the reflection forming layer 3.

One or both of the polyester polyols and the acrylic polyols may be used.

The number of hydroxyl groups in the polyester polyols and the acrylic polyols is not particularly limited, but it may be two or more per molecule. When the hydroxyl value in the solid portion is less than or equal to 10, the number of cross-linking points is reduced and film properties, such as solvent resistance, water resistance, heat resistance, and surface hardness, tend to deteriorate.

A scattering reflector may be included in the polymer composition forming the reflection forming layer 3 in order to improve the reflection performance and the heat resistance performance.

The scattering reflector included in the polymer composition can improve the heat resistance of the reflection forming layer 3 or the light reuse sheet 20. When a material having a refractive index which is considerably different from that of the polymer composition is used, it is possible to reflect light.

When sufficient reflectance is obtained in this manner, the metal reflecting layer 4 may not be provided as shown in FIGS. 19A, 19B, 20A, and 20B.

However, when an excessively large amount of scattering reflector is included, multiple reflection occurs in the scattered and reflected light, which results in the loss of light. Therefore, it is preferable that principal rays of the scattered and reflected light be sufficiently reflected and scattered light other than the principal rays have a refraction angle of less than 5 degrees with respect to the principal rays.

An inorganic material forming the scattering reflector agent is not particularly limited.

An inorganic oxide is preferably used as the inorganic material.

For example, silica may be used as the inorganic oxide. In addition, a metal compound, such as ZnS, may be used. In particular, metal oxides, such as $TiO_2$, ZrO, and $Al_2O_3$, are preferable.

In addition, hollow grains of silica may be used.

Among them, $TiO_2$ is preferable since it has a high refractive index and is easily dispersed.

The shape of the scattering reflector is not particularly limited and the grain thereof may have any shape, such as a spherical shape, a needle shape, a plate shape, a fish scale shape, or a crushed shape.

The lower limit of the mean grain diameter of the scattering reflector is preferably 0.1 $\mu$m, and the upper limit thereof is preferably 30 $\mu$m.

When the mean grain diameter is less than 0.1 $\mu$m, light is not sufficiently reflected.

On the other hand, when the mean grain diameter is greater than 30 $\mu$m, moldability is reduced.

The lower limit of the blending quantity of scattering reflector blended into 100 parts of the polymer composition is preferably 30 parts in terms of solid content.

The upper limit of the blending quantity of the scattering reflector is preferably 100 parts.

The reason is that, when the blending quantity of inorganic filling agent is less than 30 parts, it is difficult to sufficiently reflect the light H1 which is incident on the reflection forming layer 3 from the filling layer 21.

On the other hand, when the blending quantity is greater than 100 parts, moldability is reduced.

A material having an organic polymer fixed to the surface thereof may be used as the scattering reflector.

The use of the scattering reflector having the organic polymer fixed thereto can improve dispersibility in the polymer composition and affinity with the polymer composition.

For the organic polymer, for example, the molecular weight, shape, composition, and presence or absence of a functional group are not particularly limited, and any organic polymer may be used.

The organic polymer may have any shape, such as a straight chain shape, a branched shape, a bridged structure.

Specific examples of the resin forming the above-mentioned organic polymer include (meth) acrylic resin, polystyrene, polyvinyl acetate, polyolefins, such as polyethylene or polypropylene, polyvinyl chloride, polyvinylidene chloride, polyester, such as polyethylene terephthalate, copolymers of these, and resins partially denatured by means of a functional group such as an amino group, an epoxy group, a hydroxyl group, and a carboxyl group.

Among the resins, it is preferable that resins including as an indispensable component an organic polymer containing a (meth) acrylic unit, such as a (meth) acrylic-based resin, a (meth) acrylic-styrene-based resin, or a (meth) acrylic-polyester-based resin, have a film forming function.

In addition, resins having compatibility with the above-mentioned polymer compositions is preferable. Therefore, a resin that has the same composition as the polymer composition is most preferable.

A polyol having a cycloalkyl group is preferable as the above-mentioned polymer composition.

The introduction of the cycloalkyl group into the polyol serving as the polymer composition can improve the hydrophobicity of the polymer composition, such as water repellency and water resistance and improve, for example, the flexural resistance and dimensional stability of the reflection forming layer 3 and the light reuse sheet 20 under high-temperature and high-humidity conditions.

In addition, the basic coating performance of the reflection forming layer 3, such as weather resistance, hardness, bulky feeling, and solvent resistance are improved.

Furthermore, affinity with the scattering reflector having an organic polymer fixed to the surface thereof and the dispersibility of the scattering reflector are improved.

Isocyanate may be included as a curing agent in the polymer composition.

As such, when the isocyanate curing agent is included in the polymer composition, a strong bridged structure is obtained, and the coating properties of the reflection forming layer 3 are further improved.

The same materials as the polyfunctional isocyanate compounds are used as the isocyanate.

Among them, an aliphatic isocyanate which prevents the yellowing of a film is preferable.

The scattering reflector may also include an organic polymer.

In this way, it is possible to give appropriate consistency and toughness to the inorganic material, which is the core of the scattering reflector.

A material including an alkoxy group is preferably used as the organic polymer, and the content thereof is not particularly limited.

For example, it is preferable that the content of the alkoxy group per gram of the scattering reflector be from 0.01 mmol to 50 mmol.

The alkoxy group can improve the affinity of the organic polymer with the polymer composition and the dispersibility of the organic polymer in the polymer composition.

The alkoxy group has an RO group which is coupled to a metallic element forming a fine grain framework.

The R is a substitutable alkyl group, and the RO groups in the fine particles may be the same or different from each other.

The detailed examples of the R include methyl, ethyl, n-propyl, isopropyl, and n-butyl.

It is preferable to use the same metal alkoxy group as the metal forming the scattering reflector. When the scattering reflector is colloidal silica, it is preferable to use an alkoxy group having silicon as the metal.

The content of the organic polymer in the scattering reflector having the organic polymer fixed thereto is not particularly limited. However, the content of the organic polymer in the scattering reflector is preferably from 0.5% by mass to 50% by mass.

In the light reuse sheet 20, when the reflecting layer 4 is used, a surface treatment may be performed on a surface of the reflecting layer 4 to be subjected to vapor deposition (the surface of the reflection forming layer 3) in order to improve the adhesiveness between them (not shown).

Examples of the surface treatment include: (a) corona discharge processing, ozone processing, low-temperature plasma processing using oxygen gas or nitrogen gas, glow discharge processing, and oxidation processing using chemical agents; and (b) primer coating processing, undercoat processing, anchor coating processing, and vapor deposition anchor coating processing.

Among the surface treatments, corona discharge processing and anchor coating processing are preferable since they improve adhesion strength with the reflecting layer 4 and contribute to forming a precise and uniform reflecting layer 4.

Examples of the anchor coating agent used in the anchor coating processing include polyester-based anchor coating agents, polyamide-based anchor coating agents, polyurethane-based anchor coating agents, epoxy-based anchor coating agents, phenol-based anchor coating agents, (meth) acrylic-based anchor coating agents, polyvinyl acetate-based anchor coating agents, polyolefin-based anchor coating agents, such as polyethylene and polypropylene, and cellulose-based anchor coating agents.

Among these anchor coating agents, polyester-based anchor coating agents are particularly preferable since they can further improve the adhesion strength of the reflecting layer 4.

The coating quantity (in terms of solid content) of the anchor coating agent is preferably from 1 $g/m^2$ to 3 $g/m^2$.

When the coating quantity of anchor coating agent is less than 1 $g/m^2$, the effect of improving the adhesion of the reflecting layer 4 is reduced.

On the other hand, when the coating quantity of the anchor coating agent is greater than 3 $g/m^2$, there is a concern that, for example, the strength and durability of the light reuse sheet 20 will be reduced.

Various kinds of additives, such as a silane coupling agent which is used to improve adhesion, a blocking inhibitor which is used to prevent blocking, and an ultraviolet absorbing agent which is used to improve, for example, weather resistance may be appropriately mixed with the above-mentioned anchor coating agent.

The quantity of additive added to the mixture is preferably from 0.1 % by weight to 10% by weight in order to maintain the balance between the effect of the additive and the inhibition of the function of the anchor coating agent.

When the quantity of additive added to the mixture is less than 0.1% by weight, it is difficult to sufficiently prevent blocking and sufficient weather resistance is not obtained. On the other hand, when the quantity of additive is greater than 10% by weight, the functions of the top coating agent deteriorate.

The reflecting layer 4 reflects light incident on the light reuse sheet 20.

The reflecting layer 4 is formed by vapor-depositing metal on the surface of the reflection forming layer 3 on which the uneven structure is formed.

A vapor deposition apparatus for forming the reflecting layer 4 is not particularly limited as long as it can vapor-deposit metal without causing any deterioration such as the contraction or yellowing of the reflection forming layer 3.

As the apparatus for forming the reflecting layer 4, apparatuses capable of performing the following methods are used: (a) physical vapor deposition (PVD) methods, such as a vacuum deposition method, a sputtering method, an ion plating method, and an ion cluster beam method, and (b) chemical vapor deposition (CVD) methods, such as a plasma chemical vapor deposition method, a thermal chemical vapor deposition method, and a photochemical vapor deposition method.

Among the deposition methods, a vacuum deposition method or an ion plating method is preferable since it has high productivity and is capable of forming a high-quality reflecting layer 4.

It is preferable that specular reflection occur in the reflecting layer 4.

The use of the reflecting layer 4 generating the specular reflection makes it possible to generate reflected light with sufficient directionality, as compared to the reflecting layer generating scattered reflection.

Metal used to form the reflecting layer 4 is not particularly limited as long as it has metallic luster and can be vapor-deposited.

Examples of the metal used to form the reflecting layer 4 include aluminum (Al), silver (Ag), nickel (Ni), tin (Sn), and zirconium (Zr).

Among the metal materials, aluminum is preferable since it has high reflectance and enables a precise reflecting layer 4 to be formed comparatively easily.

The reflecting layer 4 may have a single-layer structure or a multi-layer structure of two or more layers.

When the reflecting layer 4 has a multi-layer structure, the deterioration of the reflection forming layer 3 due to a reduction in the thermal load generated during vapor deposition is reduced, and the adhesion between the reflection forming layer 3 and the reflecting layer 4 can be improved.

In this case, a metal oxide layer may be provided on the metal film.

The vapor deposition conditions in the physical vapor deposition method and the chemical vapor deposition method are suitably set in accordance with, for example, the kind of resin forming the reflection forming layer 3 or the base 2, and the thickness of the reflecting layer 4.

The lower limit of the thickness of the reflecting layer 4 is preferably 10 nm and more preferably 20 nm.

The upper limit of the thickness of the reflecting layer 4 is preferably 200 nm and more preferably 100 nm.

When the thickness of the reflecting layer 4 is less than a lower limit of 10 nm, it is difficult to sufficiently reflect light incident on the reflecting layer 4 from the filling layer 21.

Even when the thickness is greater than or equal to 20 nm, the amount of light reflected from the reflecting layer 4 does not increase any further.

Therefore, the thickness of the reflecting layer 4 is preferably 20 nm.

On the other hand, when the thickness of the reflecting layer 4 is greater than an upper limit of 200 nm, visible cracks occur in the reflecting layer 4.

When the thickness is less than or equal to 100 nm, no visible cracks occur in the reflecting layer 4.

The top coating process may be performed on the outer surface of the reflecting layer 4 (not shown).

As such, when the top coating process is performed on the outer surface of the reflecting layer 4, the reflecting layer 4 is sealed and protected. As a result, the handling ability of the light reuse sheet 20 is improved.

In addition, the deterioration of the reflecting layer 4 over time is prevented.

Examples of the top coating agent used in the top coating process include polyester-based top coating agents, polyamide-based top coating agents, polyurethane-based top coating agents, epoxy-based top coating agents, phenol-based top coating agents, (meth) acrylic-based top coating agents, polyvinyl acetate-based top coating agents, polyolefin-based top coating agents, such as polyethylene and polypropylene, and cellulose-based top coating agents.

Among the top coating agents, polyester-based top coating agents are particularly preferable since they have high adhesion strength with the reflecting layer 4 and contribute to protecting the surface of the reflecting layer 4 and sealing defects.

The quantity (in terms of solid content) of top coating agent used for coating is preferably from 3 $g/m^2$ to 7 $g/m^2$.

If the quantity of top coating agent used for coating is less than 3 $g/m^2$, there is a concern that the effect of sealing and protecting the reflecting layer 4 will be reduced.

Even when the quantity of top coating agent used for coating is greater than 7 $g/m^2$, the sealing and protection effect of the reflecting layer 4 does not significantly increase, but the thickness of the light reuse sheet 20 increases.

Various kinds of additives, such as a silane coupling agent which is used to improve adhesion, an ultraviolet absorbing agent which is used to improve, for example, weather resistance, and an inorganic filler which is used to improve, for example, heat resistance, may be appropriately mixed with the top coating agent.

The quantity of additive added to the mixture is preferably from 0.1 % by weight to 10% by weight in order to maintain the balance between the effect of the additive and the inhibition of the functions of the top coating agent.

When the quantity of additive added to the mixture is less than 0.1% by weight, it is difficult to obtain sufficient adhesion, weather resistance, and heat resistance.

On the other hand, when the quantity of additive added to the mixture is greater than 10% by weight, the functions of the top coating agent deteriorate.

The base 2 forming the light reuse sheet 20 is formed by sheet molding using a synthetic resin as a material.

As the synthetic resin used to form the base 2, preferably, a resin having weather resistance, such as water resistance and durability against ultraviolet rays, is used since it is disposed outdoors.

Examples of the synthetic resin include polyethylene resins, such as polyethylene terephthalate resin (PET resin), polypropylene resins, (meth) acrylic resins, polymethylpentene resins, cyclic polyolefin resins, polystyrene resins, acrylonitrile (poly) styrene copolymers (AS resins), acrylonitrile-butadiene-styrene copolymers (ABS resins), polyvinyl chloride resins, fluorine resins, poly (meth) acrylic resins, polycarbonate resins, polyester resins, polyamide resins, polyimide resins, polyamide imide resins, polyarylphthalate resins, silicone resins, polysulfone resins, polyphenylene sulfide resins, polyether sulfone resins, polyethylene naphthalate resins, polyether imide resins, epoxene resins, polyurethane resins, acetal resins, and cellulose resins.

Among the above-mentioned resins, polyimide resins, polycarbonate resins, polyester resins, fluorine resins, and polylactic acid resins are preferable as resins that have, for example, high heat resistance, strength, weather resistance, durability, and gas barrier properties against water vapor.

Examples of the polyester-based resin include polyethylene terephthalate and polyethylene naphthalate.

Among the polyester resins, polyethylene terephthalate is particularly preferable since it has a good balance between various functionalities, such as heat resistance and weather resistance and costs.

Examples of the fluorine-based resin include polytetrafluoroethylene (PTFE), perfluoroalkoxy resin (PFA), which is a copolymer of tetrafluoroethylene and perfluoroalkyl vinyl ether, a copolymer (FEP) of tetrafluoroethylene and hexafluoropropylene, a copolymer (EPE) of tetrafluoroethylene, perfluoroalkyl vinyl ether, and hexafluoropropylene, a copolymer (ETFE) of tetrafluoroethylene and ethylene or propylene, polychlorotrifluoroethylene resin (PCTFE), a copolymer (ECTFE) of ethylene and chlorotrifluoroethylene, polyvinylidene fluoride-based resin (PVDF), and polyvinyl fluoride-based resin (PVF).

Among these fluorine resins, polyvinyl fluoride-based resin (PVF) or a copolymer (ETFE) of tetrafluoroethylene and ethylene or propylene is particularly preferable since it has high strength, heat resistance, and weather resistance.

Examples of the cyclic polyolefin-based resin include: (a) polymers obtained by polymerizing cyclic dienes, such as cyclopentadiene (and derivatives thereof), dicyclopentadiene (and derivatives thereof), cyclohexadiene (and derivatives thereof), and norbornadiene (and derivatives thereof); and (b) copolymers obtained by copolymerizing a cyclic diene with one or two or more kinds of olefin-based monomers, such as ethylene, propylene, 4-methyl-1-pentene, styrene, butadiene, and isoprene.

Among these cyclic polyolefin resins, polymers of cyclic dienes, such as cyclopentadiene (and derivatives thereof), dicyclopentadiene (and derivatives thereof), and norbomadiene (and derivatives thereof), are particularly preferable since they have, for example, high strength, heat resistance, and weather resistance.

One kind of the synthetic resins or a mixture of two or more kinds of the synthetic resins may be used as the material forming the base 2.

In addition, various kinds of additives may be mixed with the material forming the base 2 in order to improve and reform, for example, workability, heat resistance, weather resistance, mechanical properties, and dimensional stability.

Examples of the additive include lubricants, cross-linking agents, anti-oxidants, ultraviolet absorbing agents, photostabilizers, filling materials, reinforcement fibers, reinforcing agents, antistatic agents, flame retardants, fire retardants, foaming agents, fungicides, and pigments.

A method for forming the base 2 is not particularly limited.

A known method, such as an extrusion method, a cast molding method, a T-die casting method, a cutting method, or an inflation method, is used to form the base 2.

When the base 2 is used, the thickness thereof is preferably from 25 $\mu$m to 500 $\mu$m and more preferably 250 $\mu$m.

When the thickness of the base 2 is less than 25 $\mu$m, curling occurs due to cure shrinkage of, for example, a ultraviolet curable resin during the coating of the reflection forming layer 3, and a defect occurs when the base is incorporated into the solar battery module 200.

On the other hand, when the thickness of the base 2 is greater than 500 $\mu$m, the weight of the film increases so that the weight of the solar battery module 200 also increases.

When the thickness of the base 2 is less than or equal to 250 $\mu$m, it is possible to achieve a lightweight solar battery module 200.

When the base 2 is incorporated into the solar battery module 200, it is preferable to incorporate the base 2 into the solar battery module 200 with the surface of the base 2 being flat.

Since the base 2 is incorporated into the solar battery module 200 in the flat state, it is possible to form a substantially flat solar battery module 200.

In this way, it is possible to stably install the solar battery module 200.

The base 2 or the reflection forming layer 3 can include an ultraviolet stabilizer or a polymer having an ultraviolet stabilizer group coupled to the molecular chain thereof.

For example, radicals and active oxygen generated by ultraviolet rays are deactivated by the ultraviolet stabilizer or the ultraviolet stabilizer group, and it is possible to improve, for example, the ultraviolet stability and weather resistance of the light reuse sheet 20.

Hindered amine-based ultraviolet stabilizers or hindered amine-based ultraviolet stabilizer groups which have high stability against ultraviolet rays are preferably used as the ultraviolet stabilizer or ultraviolet stabilizer group.

According to the solar battery module 200 using the light reuse sheet 20 having the above-mentioned structure, light incident on the region R between adjacent solar battery cells 30 can be reflected from the reflecting surface 100 of the light reuse sheet 20 and then be incident on the solar battery cell 30.

In this way, it is possible to use light incident on the region R between adjacent solar battery cells 30 and thus improve the power generation efficiency of the solar battery module 200.

(Seventeenth Embodiment)

FIG. 21 is a cross-sectional view illustrating a solar battery module according to a seventeenth embodiment of the invention.

In FIG. 21, the same components as those in the above-described embodiments are represented as the same reference numerals and a description thereof will be omitted or described in brief. The difference between this embodiment and the structure shown in FIG. 1 will be described in detail.

In a solar battery module 200, a substrate including a barrier layer 40, which is an aluminum layer with a thickness of 10 $\mu$m to 30 $\mu$m or a silica layer with a thickness of 10 nm to 100 nm, is used instead of the base 2 in a light reuse sheet 20.

In this case, in order to improve the durability of the barrier layer 40, PVF (polyvinyl fluoride resin) may be coated on the barrier layer 40 or a film made of a polyvinyl fluoride resin may be adhered to the barrier layer 40, thereby protecting the solar battery module.

According to this structure, it is possible to use the solar battery module 200 as a back sheet.

(Eighteenth Embodiment)

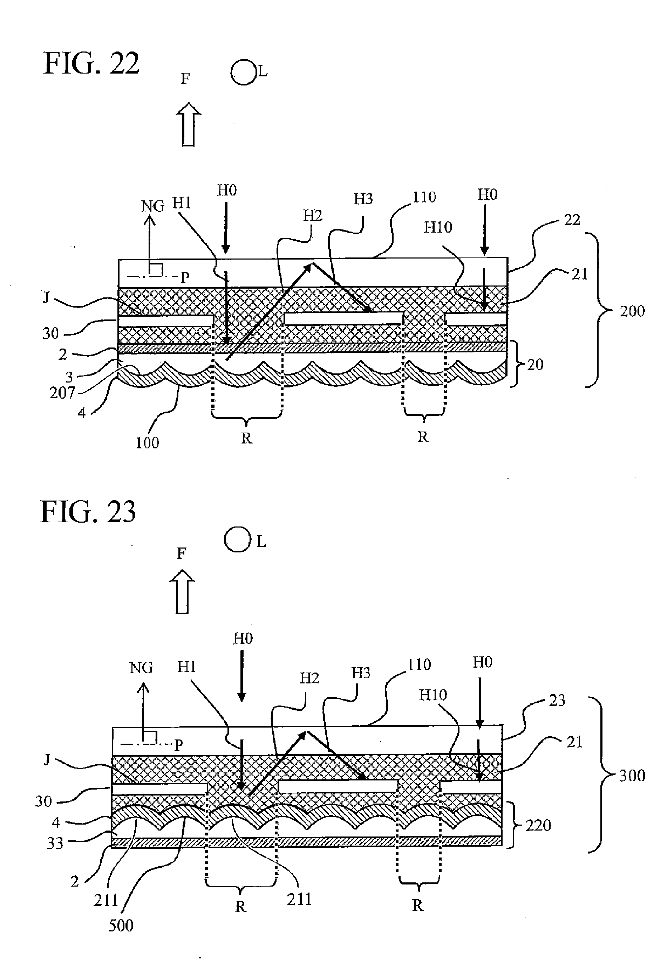

FIG. 22 is a cross-sectional view illustrating a solar battery module according to an eighteenth embodiment of the invention.

In FIG. 22, the same components as those in the above-described embodiments are represented as the same reference numerals and a description thereof will be omitted or described in brief. The difference between this embodiment and the structure shown in FIG. 1 will be described in detail.

The arrangement structure of a light reuse sheet 20 of a solar battery module 200 according to the eighteenth embodiment is reverse to that of the light reuse sheet 20 shown in FIG. 1.

That is, in the eighteenth embodiment, a light transmissive base 2 is provided on the lower surface of a filling layer 21 having solar battery cells 30 which are implanted thereinto.

A reflection forming layer 3 is provided on the lower surface of the base 2 opposite to the filling layer 21.

A plurality of concave portions 207 is provided on the lower surface of the reflection forming layer 3 opposite to the base 2.

The plurality of concave portions 207 has the same shape as the concave portions 201 according to the first embodiment and includes a concave curved reflecting surface having the same inclination angle as that of the concave portions 201.

The plurality of concave portions 207 is formed along a plane parallel to the plane P which is parallel to a light incident surface of a front plate.

The reflecting surfaces of the plurality of concave portions 207 are covered with a reflecting layer 4 having high reflectance.

The solar battery module 200 including the light reuse sheet 20 having the above-mentioned structure has the same operation and effect as those of the structure shown in FIG. 1.

In the invention, the following structure may be used: a plurality of light emitting elements, such as LEDs or EL elements, is implanted into the filling layer 21, instead of the solar battery cells 30 implanted into the filling layer 21 shown in FIGS. 1 and 22 and the light reuse sheet 20 and the light emitting elements are combined with each other.

According to this structure, an illuminating module is achieved.

(Nineteenth Embodiment)

In the following nineteenth to thirty-sixth embodiments, the same components as those in the first to eighteenth embodiments are represented as the same reference numerals and a description thereof will be omitted or described in brief.

FIG. 23 is a cross-sectional view illustrating a solar battery module according to a nineteenth embodiment of the invention.

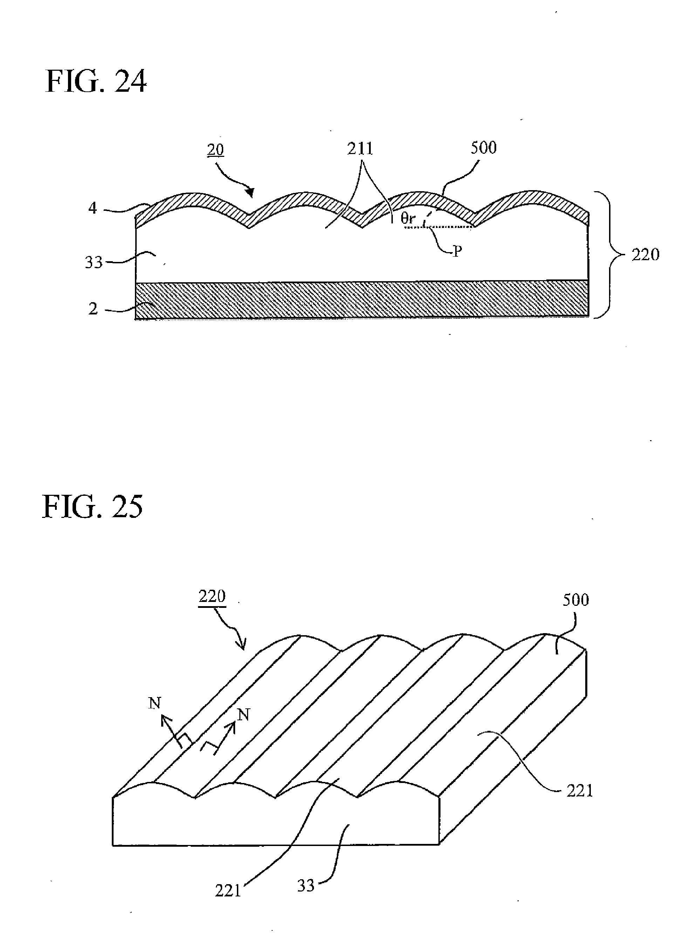

FIG. 24 is an enlarged cross-sectional view illustrating a light reuse sheet according to this embodiment.

FIG. 25 is a perspective view illustrating an example of a reflecting convex portion formed in a reflection forming layer in the light reuse sheet according to this embodiment.

As shown in FIG. 23, a solar battery module 300 includes a light reuse sheet 220, a filling layer 21, and a front plate 23. The light reuse sheet 220, the filling layer 21, and the front plate 23 are laminated in this order.

A plurality of solar battery cells 30 is provided in the filling layer 21 so as to be arranged in a matrix at a constant pitch in a direction parallel to the plane of the filling layer 21.

The front plate 23 transmits light, such as sunlight or illumination light, from a light source L.

The front plate 23 protects the solar battery cells 3 0 from, for example, impact, contamination, and the infiltration of water and is made of a transparent material with high transmittance.

For example, the front plate 23 is made of glass, such as toughened glass or sapphire glass, or a resin sheet, such as PC (polycarbonate) or PEN (polyethylene naphthalate).

When the front plate 23 is made of toughened glass, the thickness thereof is in the range of approximately 3 mm to 6 mm. When the front plate 23 is made of a resin sheet, the thickness thereof is in the range of 100 μm to 3000 μm.

As shown in FIGS. 23, 24, 28A to 28C, the light reuse sheet 220 includes a base 2, which is a flat plate, and a reflection forming layer 33 that is formed on the upper surface of the base 2.

A plurality of convex portions 211 is formed on the upper surface of the reflection forming layer 33 along a plane parallel to the plane P.

The cross-sectional area of the convex portion 211 in the plane parallel to the plane P increases as a portion of the surface of the convex portion 211 becomes closer to the front plate 23 in a direction in which the convex portion 211 protrudes.

The convex portion 211 has a curved reflecting surface.

The convex portion 211 is formed such that the angle θr between the plane P parallel to the light incident surface 110 of the front plate 23 and the reflecting surface of the convex portion 211 is reduced as the reflecting surface of the convex portion 211 becomes closer to the front plate 23 in the direction in which the convex portion 211 protrudes.

The reflecting surface of the convex portion 211 is covered with a metal reflecting layer 4 having high reflectance.

The surface of the reflecting layer 4 is a reflecting surface 500.

The filling layer 21 is formed on the reflecting surface 500.

It is preferable that the base 2 be a flat plate.

The convex portion 211 according to the nineteenth embodiment is formed in a strip shape extending in one direction, as shown in FIG. 25.

The strip-shaped convex portions 211 are arranged in parallel to each other along the plane parallel to the light incident surface 110 of the front plate 23.

As the structure of the convex portions 211, a plurality of independent optical components having a convex lens shape may be arranged at a constant pitch or at random in the two-dimensional direction.

The filling layer 21 seals the solar battery cells 30.

The filling layer 21 is made of a material with high light transmittance in order to transmit light H0 incident on the filling layer 21.

The filling layer 21 is generally made of, for example, flame-resistant EVA (ethylene vinyl acetate).

As shown in FIG. 23, the light H0 is emitted from the light source L from the sunlight or illumination light side F and is vertically incident on the light incident surface 110 of the front plate 23. The light H0 incident on the front plate 23 passes through the front plate 23 and travels to the filling layer 21.

A normal line NG of the light incident surface 110 is parallel to the normal line of the plane P when the front plate 23 is arranged in the most stable state on the plane P.

The light vertically incident on the light incident surface 110 is incident on the solar battery module 300 in parallel to the normal line NG.

Among the light components H0 incident on the front plate 23, light H10 passes through the filling layer 21 and is then incident on the solar battery cell 30 and light H1 travels to the light reuse sheet 220.

The solar battery cell 30 has a function of converting light incident on a light receiving surface J into electric energy using the photoelectric effect and is selected from a large number of different types of solar battery cells such as monocrystalline silicon solar battery cells, polycrystalline silicon solar battery cells, thin-film silicon solar battery cells, and C1GS (Cu-In-Ga-Se compound) thin-film solar battery cells.

A plurality of solar battery cells 30 is connected to each other by an electrode to form a module.

The light H10 that is incident on the solar battery cell 30 from the filling layer 21 is converted into electric energy by the solar battery cell 30.

In general, the percentage of light reflected from the light incident surface 110 in the light that is obliquely incident on the light incident surface 110 is greater than that of light reflected from the light incident surface 110 in the light H0 that is vertically incident on the light incident surface 110. Therefore, a small amount of light is incident on the solar battery cell 30 and the amount of light used to generate power is small.

Therefore, when the incident light H0 is vertically incident on the light incident surface 110, the maximum efficiency is obtained.

When the incident light H0 is vertically incident on the light incident surface 110, that is, when the sun is substantially vertically disposed relative to the light incident surface 110, it is possible to improve optical efficiency.

Therefore, the relative position between the sun and the solar battery module has a great effect on the improvement of the overall efficiency of the solar battery module.

The light reuse sheet 220 according to the embodiment of the invention has a structure capable of obtaining the maximum optical efficiency when the incident light H0 is vertically incident on the light incident surface 110.

The light reuse sheet 220 has a function of reflecting light passing through the solar battery cell 30 or the light H1 incident between adjacent solar battery cells 30 from the reflecting surface 500 of the light reuse sheet 220.

The light H2 reflected from the reflecting surface 500 is reflected again from, for example, the interface between the front plate 23 and air and becomes light H3 that is incident on the light receiving surface J of the solar battery cell 30. The light H3 is converted into electric energy by the solar battery cell 30.

In this way, it is possible to improve the use efficiency of light, as compared to the solar battery module without the light reuse sheet 220.

The effect of reusing light is noticeable when the incident light H0 is vertically or substantially vertically incident on the light incident surface 110.

The reflected light H2 is converted into the light H3 with the highest efficiency and the light H3 is converted into electric energy by the solar battery cell 30.

The traveling direction of the reflected light H2 shown in FIG. 23 can be controlled by the structure of the convex portions 211 forming the reflecting surface 500 of the light reuse sheet 220.

In this way, it is possible to make a large amount of light incident on the light receiving surface J.

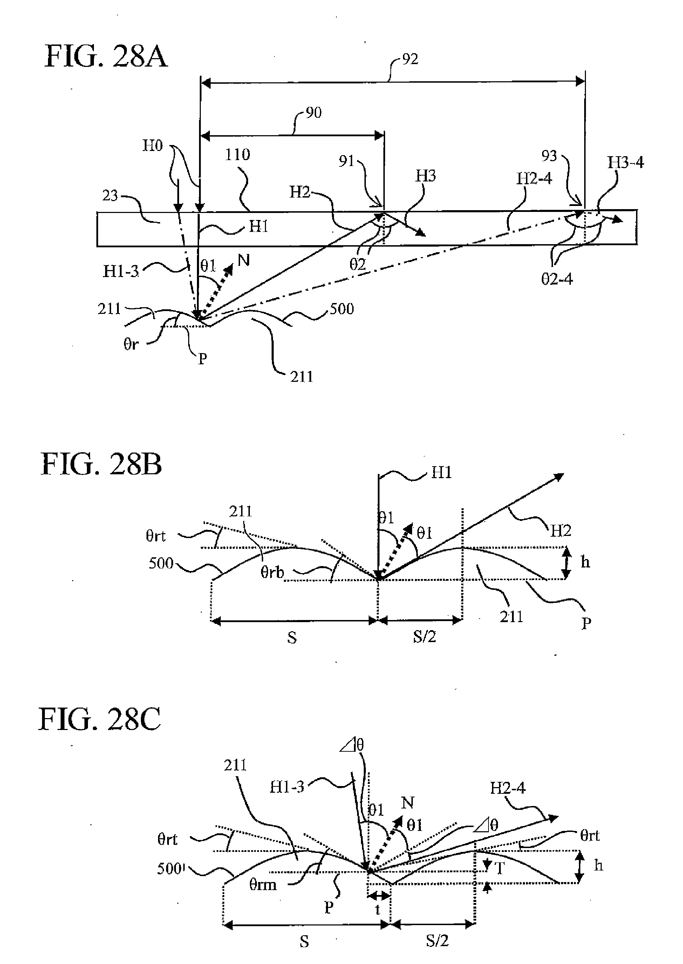

In FIGS. 25 to 28C, a normal line N is a straight line vertical to a tangent plane at any point on the reflecting surface 500.

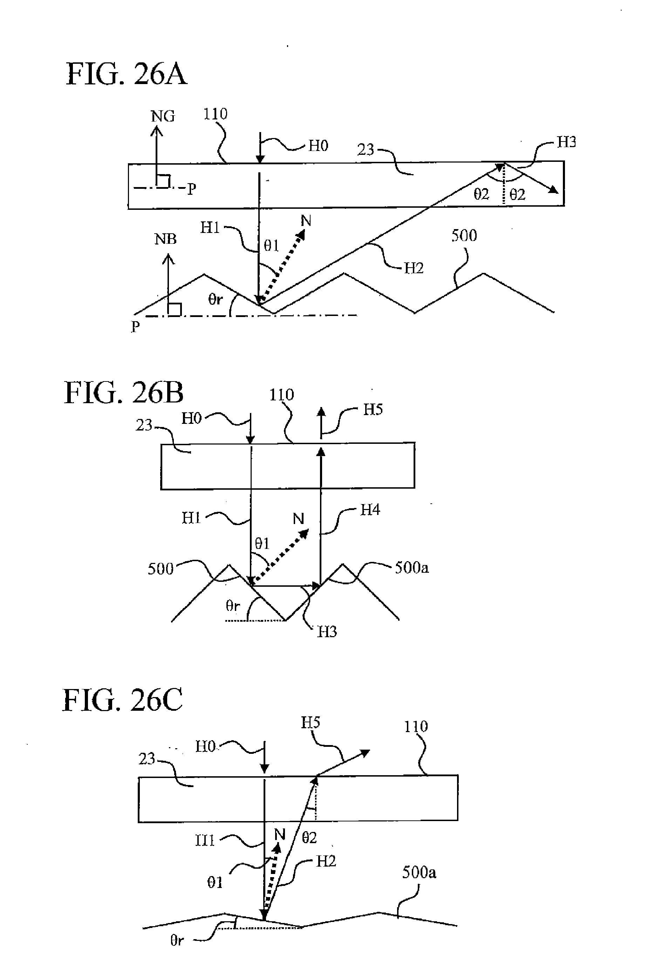

In FIG. 26A, a sheet normal line NB is vertical to the plane P of the V-shaped uneven structure of the light reuse sheet 220.

The angle θr of the reflecting surface 500 is formed between the reflecting surface 500 and the plane P.

In general, the sheet normal line NB is arranged in parallel to the normal line NG of the incident surface 110. Therefore, the incident light H1 is incident in parallel to the sheet normal line NB.

As shown in FIG. 23, photoelectric conversion is not performed in a region R between adjacent solar battery cells 30, that is, in the region R in which the solar battery cell 30 is not provided.

However, the light H1 that passes through the region R and is then incident on the light reuse sheet 220 is reflected to the light receiving surface J of the solar battery cell 30. In this way, it is possible to effectively use the light H1.

In this case, as shown in FIG. 26A, when the incident angle θ2 of light on the interface between the front plate 23 and air is sufficiently large, the light H2 that passes through the region R, is incident on the reflecting surface 500 and is then reflected from the reflecting surface 500 is reflected as the light H2 from the interface between the front plate 23 and air in a specific direction.

Therefore, it is possible to make the reflected light H2 effectively incident on the solar battery cell 30.

When the angle formed between the incident light H1 and the reflected light H2 increases, it is possible to make the reflected light H2 incident on the light receiving surface J of a distant solar battery cell 30.

Therefore, it is possible to use the light H1 that is incident on a portion that is away from the solar battery cell 30 and the amount of light incident on the light receiving surface of the solar battery cell increases. As a result, it is possible to improve the use efficiency of light.

In order to improve the use efficiency of light, it is necessary to increase the angle θr of the reflecting surface 500. When the angle formed between the incident light H1 and the reflected light H2 is greater than or equal to 35 degrees, a sufficient effect is obtained.

That is, it is preferable that the angle θr of the reflecting surface 500 be greater than or equal to 17.5 degrees (= 35/2 degrees).

However, when the angle θr is greater than 30 degrees, as shown in FIG. 26B, the light H1 incident on the reflecting surface 100 is reflected from the reflecting surface 500 of the uneven structure to a reflecting surface 500a of the convex portion 211 adjacent to the reflecting surface 500.

Light H4 that is incident on the reflecting surface 500a of the adjacent convex portion 211 again and is continuously reflected by the reflecting surfaces 100 and 100a is generated.

The phenomenon in which light incident on the reflecting surface 500 is incident on the reflecting surface 500a of the adjacent convex portion 211 again and is continuously reflected from the reflecting surfaces 500 and 100a is referred to as multiple reflection.

The incident angle θ2 of the multi-reflected light H4 on the interface between the front plate 23 and air is less than 35 degrees. Therefore, the light is not reflected and a portion of the light is converted into light H5 emitted to air. As a result, light loss that does not contribute to the photoelectric effect occurs.

Therefore, when the angle θr of the reflecting surface 500 of the convex portion 211 is less than or equal to 30 degrees, multiple reflection does not occur. It is preferable that the angle θr of the reflecting surface 500 of the convex portion 211 be less than or equal to 30 degrees.

When the angle θr of the reflecting surface 500 of the convex portion 211 is less than 17.5 degrees, as shown in FIG. 26C, multiple reflection does not occur in the light H1 incident on the reflecting surface 500 of the convex portion 211, unlike FIG. 26B.

However, since the incident angle θ2 of the light H4 is less than 35 degrees, the light H2 reflected from the reflecting surface 500 of the convex portion 211 is not reflected from the interface between the front plate 23 and air and is converted into light H5 that is emitted to air. As a result, light loss occurs.

In this case, it is difficult to sufficiently reflect the light H1 that is vertically incident on the region R between the adjacent solar battery cells 30 of the solar battery module 300 to the solar battery cell 30.

Therefore, a sufficient amount of light is not incident on the light receiving surface of the solar battery cell.

When the angle θr of the reflecting surface 500 of the convex portion 211 is greater than or equal to 17.5 degrees, the incident angle θ2 is greater than 35 degrees. Therefore, it is preferable that the angle θr of the reflecting surface 500 of the convex portion 211 be greater than or equal to 17.5 degrees.

Therefore, it is preferable that the structure of the convex portion 211 of the light reuse sheet 220 be set to an angle at which multiple reflection does not occur after the light H1 is reflected from the reflecting surface 500 of the convex portion 211 and a sufficient amount of light H2 is reflected from the interface between the front plate 23 and air, as shown in FIG. 26A.

In addition, in the convex portion 211, it is preferable that the percentage of the area in which the angle θ1 of the reflecting surface 500 is from 17.5 degrees to 30 degrees be greater than or equal to that of the area in which the angle θr of the reflecting surface 500 is less than 17.5 degrees and greater than 30 degrees.

In the convex portion 211, when the percentage of the area in which the angle θr of the reflecting surface 500 is from 17.5 degrees to 30 degrees is less than that of the area in which the angle θr of the reflecting surface 500 has the other values, it is difficult to make a sufficient amount of light incident on the light receiving surface of the solar battery cell.

The convex portion 211 having the reflecting surface 500 has a microscopic convex shape.

There is a scattering region called a Mie scattering region in the range that is approximately ten times the wavelength of light.

Since a visible light region is from 460 nm to 780 nm, a smoothing process for smoothing the surface with a roughness less than or equal to 7.8 μmcan be performed to calculate the normal line N.

It is preferable to use a laser microscope in the measuring method.

In addition, an optical microscope or an electron microscope may be used to measure the cross section.

In this case, the sheet normal line NB can be regarded as a line vertical to a sample table having the light reuse sheet 220 placed thereon.

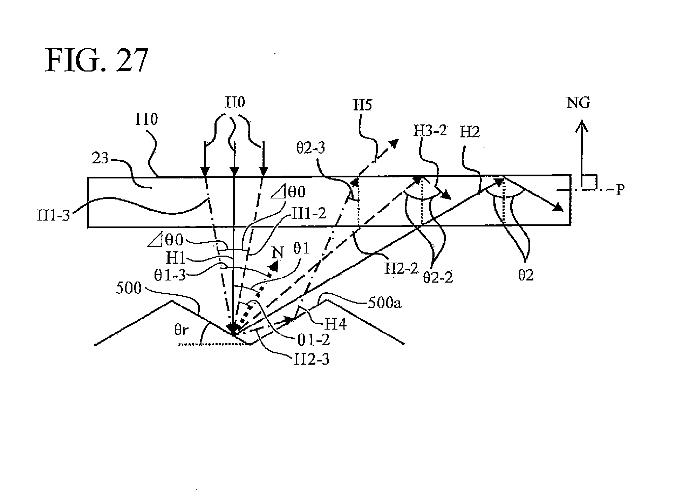

However, as shown in FIG. 26A, when the reflecting surface 500 of the V-shaped uneven structure is flat, the phenomenon shown in FIG. 27 occurs.

The front plate 23 has a function of protecting impact, contamination, and the infiltration of water and the solar battery module is generally installed outside the building where the amount of sunlight is the maximum.

Therefore, it is inevitable that fine damage or contamination will occur in a portion of the front plate 23 that contacts air, that is, the light incident surface 110 of the front plate 23 due to a change in the weather or external environment.

When fine damage or contamination occurs in the light incident surface 110 and the incident light H0 is vertically incident on the light incident surface 110, a refraction angle Δθ (Δθ < 10 degrees) is formed with respect to the normal line NG of the light incident surface 110 due to the fine damage or contamination occurring in the light incident surface 110, and light having the refraction angle is incident on the solar battery module.

Next, the experiment result of the refraction angle formed due to the fine damage or contamination occurring in the front plate 23 will be described.

As a test piece, a general plate (the entire surface of the plate was a smooth surface) with a size of 15 cm by 15 cm and a thickness of 2 mm was prepared.

As the outdoor test, the glass plate was installed on the building roof so as to be exposed to wind and rain and the outdoor test was performed for three months from June to August.

After the outdoor test, parallel light was vertically incident on the glass plate, and EZContrast (viewing angle measuring device) manufactured by ELDIM Company was used to measure the angle of view at 100 points on the surface of the glass. As a result of the measurement, in 90% or more of the area, the vertically incident light was refracted at an angle of Δθ.

The maximum value of Δθ was less than 10°.

Light H1-2 represented by a dashed line in FIG. 27 is incident on the solar battery module 300 at a refraction angle of Δθ0.

When an angle θ1-2 formed between the light H1-2 incident on the reflecting surface 500 and the normal line N is less than an angle θ1 formed between light H1 that is incident on the reflecting surface 500 without a refraction of Δθ0 and the normal line N, light H2-2 reflected from the reflecting surface 500 is incident on the front plate 23 at an angle of 02-2, without any multiple reflection.

When the incident angle 02-2 is greater than 35 degrees, a sufficient amount of light is reflected from the interface between the front plate 23 and air and light H3-2 is obtained. The light H3-2 can be incident on the light receiving surface of the solar battery cell 30.

In general, when the light H1 is incident on the solar battery module 300 without a refraction of Δθ0, multiple reflection does not occur, as represented by the light components H1, H2, and H3 in FIGS. 26A or 27.

The light H1 is reflected from the reflecting surface 500 and is then converted into the light H2. The light H2 is sufficiently reflected from the interface between the front plate 23 and air.

In the optical path, since the refraction angle Δθ0 caused by the fine damage or contamination occurring in the light incident surface 110 is sufficiently small, there is no serious problem.

However, light H1-3 represented by a one-dot chain line in FIG. 27 is incident on the solar battery module 300 at a refraction angle of Δθ0.

When an angle θ1-3 formed between the light H1-3 incident on the reflecting surface 500 and the normal line N is greater than the angle θ1 formed between light H1 that is incident on the reflecting surface 500 without a refraction of Δθ0 and the normal line N, light H2-3 that is incident and reflected from the reflecting surface 500 is multi-reflected from the reflecting surface 500.

Specifically, after the light H2-3 is reflected from the reflecting surface 500 of the convex portion 211 serving as a first member, it is reflected from the reflecting surface 500 of a convex portion 211 serving as a second member adjacent to the first member and is then converted into multi-reflected light H4.

The light H4 is incident on the interface between the front plate 23 and air at an angle θ2-3.

In this case, since the incident angle θ2-3 is less than 35 degrees, the light H4 is not sufficiently reflected from the interface between the front plate 23 and air and a portion of the light H4 is converted into light H5 that is emitted to air.

The light H5 is lost and the use efficiency of light is reduced.

In order to solve the above-mentioned problems, the light reuse sheet 220 according to the nineteenth embodiment of the invention has the structure shown in FIGS. 28A to 28C.

In the light reuse sheet 220, the cross-sectional area of the reflecting convex portion 211 in the plane parallel to the plane P is reduced toward the front plate 23 in the direction in which the convex portion 211 protrudes.

The convex portion 211 has the curved reflecting surface 500.

The curved reflecting surface 500 has curvature.

Specifically, the angle θr between the parallel plane P and the reflecting surface of the convex portion 211 at a predetermined position on the convex portion 211 is reduced as the predetermined position becomes closer to the sunlight or illumination light side F along the reflecting surface 500.

That is, the angle θr formed between the plane P parallel to the light incident surface 110 of the front plate 23 and the reflecting surface of the convex portion 211 is reduced toward the front plate 23 in the direction in which the convex portion 211 protrudes.

That is, the angle θr is changed such that the angle θrb of the reflecting surface in the bottom of the convex portion 211 is large and the angle θrt of the reflecting surface at the top of the convex portion 211 is small.

In other words, the light reuse sheet 220 according to the nineteenth embodiment includes a reflection forming layer 33 having the convex portions 211 (uneven portion) and the reflecting surface 500 provided on the surface of the convex portion 211.

The light reuse sheet 220 reflects the incident light components H1, H1-3, and H1-2 (first light components) that pass through the filling layer 21 without being received by the light receiving surface J of the solar battery cell 30 to the front plate 23, thereby generating reflected light components H2, H2-2, and H2-4 (second light components).

The light reuse sheet 220 reflects the reflected light components H2, H2-2, and H2-4 from the interface between the light incident surface 110 and the outside of the front plate 23 to generate reflected light components H3, H3-2, and H3-4 (third light components).

In the light reuse sheet 220, the reflected light components H3, H3-2, and H3-4 are incident on the light receiving surface J of the solar battery cell 30.

In the light reuse sheet 220, the light H1 (straight light) among the incident light components H1, H1-3, and H1-2 is reflected by the reflecting surface 500 and is converted into the reflected light H2 (second light component) that has a first angle with respect to the light H1 and travels toward the front plate 23.

The reflected light H2 having the first angle is reflected from a first interface portion 91 of the front plate 23 that is a first distance 90 away from the convex portion 211 and is converted into the reflected light H3 (third light).

In the light reuse sheet 220, the light H1-3 (refracted light) among the incident light components H1, H1-3, and H1-2 is reflected by the reflecting surface 500 and is converted into the reflected light H2-4 (second light) that has a second angle greater than the first angle with respect to the light H1 and travels toward the front plate 23.

The reflected light H2-4 having the second angle is reflected from a second interface portion 93 of the front plate 23 that is a second distance 92 greater than the first distance 90 away from the convex portion 211 and is converted into the reflected light H3-4 (third light).

In the light reuse sheet 220 having the above-mentioned structure according to the nineteenth embodiment, since the reflecting surface 500 of the convex portion 211 has the above-mentioned structure, multiple reflection does not occur even though the light H1-3 having a refraction angle of $\Delta\theta0$ is incident on the reflecting surface 500.

Specifically, the light H2-4 reflected from the reflecting surface 500 is incident (incident angle: $\theta2$-4) on the interface between the light incident surface 110 of the front plate 23 and air without any multiple reflection.

The light H2-4 is sufficiently reflected from the interface and is converted into light H3-4.

In this way, it is possible to reflect the light H3-4 to the light receiving surface J of the solar battery cell 30.

In this case, the incident angle $\theta2$-4 is greater than the incident angle $\theta2$ of the light H2 without a refraction angle of $\Delta\theta0$ on the interface between the front plate 23 and air.

That is, since "$\theta2$-4" > $\theta2$ is satisfied, the probability of light being sufficiently reflected is high.

The shape of the convex portion 211 where the above-mentioned effect is obtained satisfies the following Expressions 4 and 5:

$$\text{(Expression 4)} \quad \theta rb > \theta rm > \theta rt;$$

and

$$\text{(Expression 5)} \quad \tan(90° - 2\theta rb) \times S/2 > h.$$

In the above-mentioned expressions, $\theta rb$ indicates the angle formed between the plane P and the reflecting surface 500 at a position where the distance between the front plate 23 and the surface of the convex portion 211 is the maximum, that is, in the vicinity of the bottom of the convex portion 211.

In addition, $\theta rt$ indicates the angle between the plane P and the reflecting surface 500 at a position where the distance between the front plate 23 and the surface of the convex portion 211 is the minimum, that is, in the vicinity of the top of the convex portion 211.

$\theta rm$ indicates the angle formed between the parallel plane P and the reflecting surface 500 and indicates the angle in an intermediate portion between the bottom and the top.

h indicates the difference between the maximum value and the minimum value of the distance between the convex portion 211 and the front plate 23 and indicates the height of the convex portion from the bottom to the top.

S indicates the pitch between the convex portions 211.

As shown in FIG. 28B, the angle $\theta1$ between the light H1 and the normal line of the reflecting surface is equal to the angle $\theta rb$ between the reflecting surface 500 and the plane P.

Therefore, the angle formed between the light H2 reflected from the reflecting surface 500 and the plane P is $90° - 2\theta rb$.

In the shape of the convex portion 211 satisfying Expression 5, light that is incident vertically to the plane P in the vicinity of the bottom of the cross-section of a periodic structure is reflected from the reflecting surface 500 without any multiple reflection.

Therefore, it is possible to deflect the light H2 to the light receiving surface J of the solar battery cell 30 with high efficiency.

In the shape of the convex portion 211 satisfying Expression 4, when the condition that multiple reflection does not occur in light that is incident vertically to the plane P in the vicinity of the bottom of the cross-section of the periodic structure is obtained, light that is vertically incident on the convex portion 211 can be reflected at any position on the surface of the convex portion 211 without multiple reflection.

It is more preferable that the shape of the convex portion 211 satisfy the following Expression 6:

$$\text{(Expression 6)} \quad \tan(90° - 2\theta rm - \Delta\theta) \times (S/2 + t) > h - T.$$

In Expression 6, t indicates the distance between the bottom of the convex portion 211 and the position of the starting point of the normal line N in the intermediate portion between the bottom and the top of the convex portion 211 in the direction parallel to the parallel plane P.

In addition, t indicates the distance between the bottom of the convex portion 211 and a position in the vicinity of the bottom that is closest to the incident position of light on the reflecting surface 500.

T indicates the distance between the bottom of the convex portion 211 and the position of the starting point of the normal line N in the intermediate portion between the bottom and the top of the convex portion 211 in the direction vertical to the parallel plane P.

When Expression 6 is satisfied, multiple reflection does not occur even though a refraction of Δθ0 occurs due to fine damage or contamination occurring in the front plate 23 as shown in FIG. 28C. Therefore, it is possible to deflect the light H2-4 to the light receiving surface J of the solar battery cell 30 with high efficiency.

It is preferable that Expression 6 be satisfied in the range of $0 \leq t \leq S/2$.

In this case, multiple reflection does not occur due to the refraction of Δθ0 caused by fine damage or contamination occurring in the front plate 23 even when light is incident at any position on the reflecting surface 500 of the convex portion 211.

It is preferable that Expression 6 be satisfied only in the range of $0.15S \leq t \leq 0.5S$.

In this case, the multiple reflection occurs in a portion of the light that is incident in the vicinity of the bottom of the convex portion 211 due to the refraction of Δθ0 caused by fine damage or contamination occurring in the front plate 23.

However, since the effect obtained by the light reuse sheet 220 is significantly greater than light loss due to multiple reflection, no problem arises.

It is more preferable that the shape of the convex portion 211 satisfy the following Expression 7:

$$\text{(Expression 7)} \quad 90° - 2\theta rm - \Delta\theta > \theta rt.$$

When Expression 7 is satisfied, light that is reflected from the reflecting surface 500 of the convex portion 211 serving as the first member is not multi-reflected by a portion of the reflecting surface 500 in the vicinity of the top of the convex portion 211 serving as the second member adjacent to the first member.

It is more preferable that the shape of the convex portion 211 satisfy the following Expression 8:

$$\text{(Expression 8)} \quad 30° \geq \theta rb > \theta rm > \theta rt \geq 17.5°.$$

When the angle θrb has the above-mentioned angle range, multiple reflection does not occur and it is possible to obtain a sufficiently large incident angle at the interface between the light incident surface 110 of the front plate 23 and air.

It is preferable that the top of the convex portion 211 be not flat, but have an angle less than or equal to an apex angle of 145 degrees.

When the top of the convex portion 211 is flat, light that is incident on the top of the convex portion 211 is deflected and is not reflected from the interface between the front plate 23 and air.

Therefore, the reflected light returns to the incident position on the front plate 23 and is lost, which is not preferable.

The shape of the reflecting surface 500 of the convex portion 211 is not limited to the curve shown in FIG. 28C.

For example, the reflecting surface 500 may have a polygonal shape with two or more sides in a cross-sectional view.

Alternatively, the shape of the reflecting surface 500 may be a combination of the polygonal shape and a curve.

Since the light reuse sheet 220 has the above-mentioned structure, it is possible to achieve the solar battery module 300 capable of preventing multiple reflection and having high light use efficiency.

Specifically, the light H1-3 that was incident on the reflecting surface 500 of the convex portion 211 and had a refraction angle of Δθ0 was lost light H5 in a conventional solar battery module.

In contrast, since the light reuse sheet 220 has the above-mentioned structure, the light H1-3 is reflected from the reflecting surface 500 and is converted into the light 2-4, and the light 2-4 is converted into the light H3-4, as shown in FIG. 28A. Therefore, it is possible to reflect the light H3-4 to the light receiving surface J of the solar battery cell 30.

The light H1 without a refraction angle of Δθ0 is reflected by the reflecting surface 500 and is converted into the light H2. The light H2 is incident on the interface between the light incident surface 110 of the front plate 23 and air at an angle θ2.

The incident angle θ2-4 of light on the interface between the light incident surface 110 of the front plate 23 and air is greater than the incident angle θ2 of the light H2.

Therefore, the probability of light being sufficiently reflected from the interface between the light incident surface 110 and air increases and it is possible to reflect light to the light receiving surface J of the solar battery cell 30 with high efficiency.

(Twentieth Embodiment)

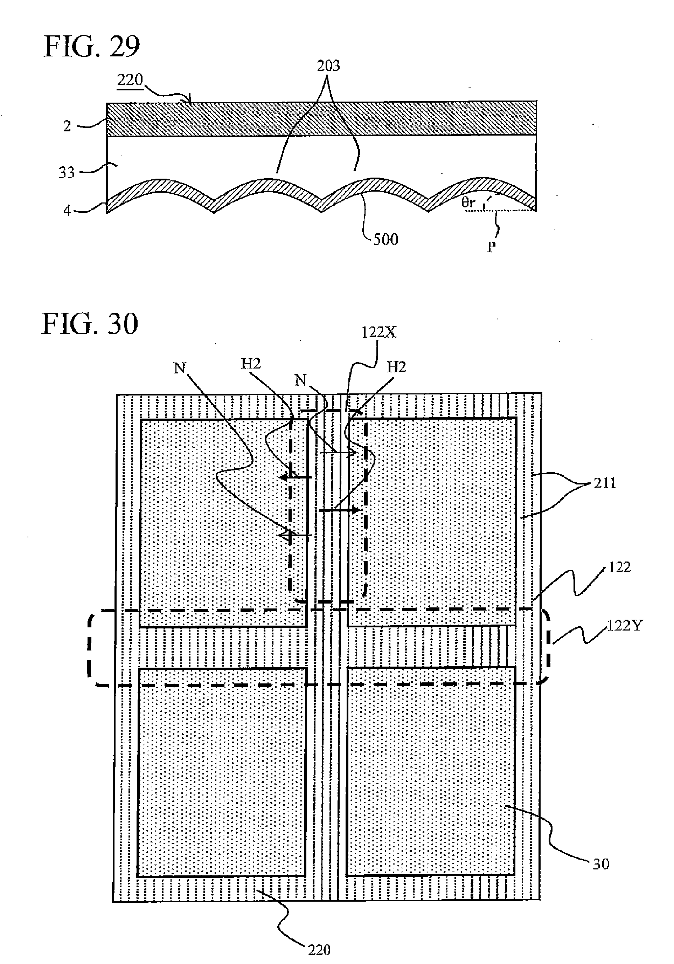

FIG. 29 is an enlarged cross-sectional view illustrating a light reuse sheet of a solar battery module according to a twentieth embodiment of the invention.

A light reuse sheet 220 according to the twentieth embodiment is a modification of the light reuse sheet according to the nineteenth embodiment.

The twentieth embodiment is different from the nineteenth embodiment in the following structure.

The structure of the twentieth embodiment is reverse to that of the nineteenth embodiment.

That is, a light transmissive base 2 is provided on a filling layer having solar battery cells which are implanted thereinto.

A reflection forming layer 33 is provided on the lower surface of the base 2 opposite to the filling layer.

A convex reflecting surface 500 having the same curvature as that of the concave portion 202 according to the nineteenth embodiment is provided on the lower surface of the reflection forming layer 33 opposite to the base 2.

In the light reuse sheet 220 having the above-mentioned structure according to the twentieth embodiment, a plurality of reflecting convex portions 203 is formed along a plane parallel to the plane P that is parallel to the light incident surface of the front plate.

The reflecting surface 500 of the convex portion 203 is covered with a metal reflecting layer 4 having high reflectance.

In this case, the interface between the reflecting layer 4 and the reflecting surface of the convex portion 2034 is the reflecting surface 500.

The twentieth embodiment has the same operation and effect as the nineteenth embodiment.

(Twenty-first Embodiment)

FIG. 30 is a plan view illustrating the arrangement relationship between a light reuse sheet and solar battery cells of a solar battery module according to a twenty-first embodiment of the invention.

In the twenty-first embodiment, a plurality of rectangular solar battery cells 30 of the solar battery module is arranged in a matrix at a constant pitch in the X direction and the Y direction on the plane, as shown in FIG. 30.

In the light reuse sheet 220, a region 122 in which the solar battery cell 30 is not provided is formed between adjacent solar battery cells 30.

In the region 122, strip-shaped convex portions 211 that have the reflecting surface according to the above-described embodiments and extend in the longitudinal direction (X direction) of the light reuse sheet 220 are arranged at a constant pitch in parallel to the width direction (the lateral direction of the light reuse sheet 220; the Y direction) of the light reuse sheet 220.

In this case, the use efficiency of light incident on the convex portion 211 in a region 122X is high.

In FIG. 30, an arrow N indicates a normal line of the reflecting surface of the strip-shaped convex portion 211 and an arrow H2 indicates the direction in which light is reflected from the reflecting surface of the convex portion 211 to the solar battery cell 30.

In the solar battery module having the above-mentioned structure, the strip-shaped convex portions 211 are arranged so as to surround the solar battery cell 30 in correspondence with the position of the solar battery cell 30.

According to this structure, light H2 reflected from the reflecting surface of the strip-shaped convex portion 211 can be effectively incident on the solar battery cell 30.

(Twenty-second Embodiment)

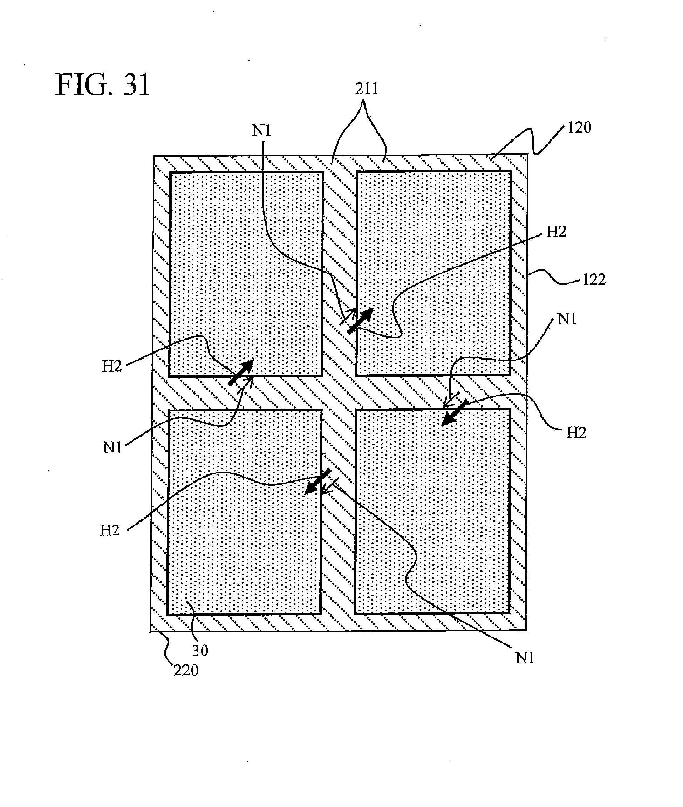

FIG. 31 is a plan view illustrating the arrangement relationship between a light reuse sheet and solar battery cells of a solar battery module according to a twenty-second embodiment of the invention.

In the twenty-second embodiment, as shown in FIG. 31, a plurality of rectangular solar battery cells 30 of the solar battery module is arranged in a matrix at a constant pitch in the X direction and the Y direction on the plane.

In a light reuse sheet 220, a region 122 in which the solar battery cell 30 is not provided is formed between adjacent solar battery cells 30.

In the region 122, strip-shaped convex portions 211 having the reflecting surface according to the above-described embodiments extend in the oblique direction intersecting the longitudinal direction of the light reuse sheet 220 and are arranged in parallel at a constant pitch.

In FIG. 31, an arrow N1 indicates a normal line of the reflecting surface of the convex portion 211 and an arrow H2 indicates the direction in which light is reflected from the reflecting surface of the convex portion 211 to the solar battery cell 30.

In the solar battery module having the above-mentioned structure, the convex portions 211 are arranged such that the intersection angle between the direction in which the strip-shaped convex portion extends and the direction in which the side of the solar battery cell 30 extends has an optional value.

In this way, it is possible to convert light incident on the region 122 into the light H2 reflected from the reflecting surface of the convex portion 211 and make the light H2 incident on the solar battery cell 30, as compared to FIG. 30.

Therefore, it is possible to deflect light with high efficiency.

(Twenty-third Embodiment)

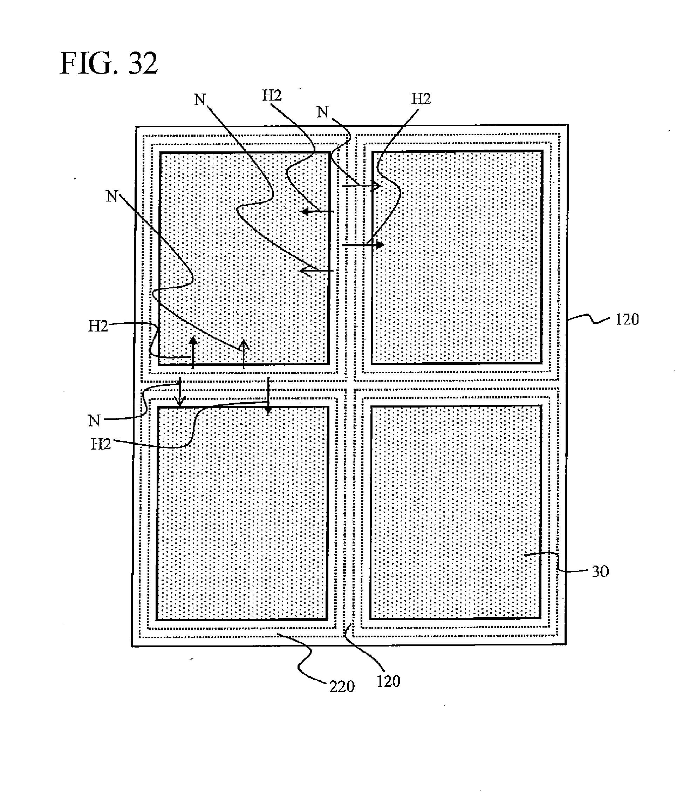

FIG. 32 is a plan view illustrating the arrangement relationship between a light reuse sheet and solar battery cells of a solar battery module according to a twenty-third embodiment of the invention.

In the twenty-third embodiment, as shown in FIG. 32, a plurality of rectangular solar battery cells 30 of the solar battery module is arranged in a matrix at a constant pitch in the X direction and the Y direction on the plane.

In a light reuse sheet 220, a region 122 in which the solar battery cell 30 is not provided is formed between adjacent solar battery cells 30.

A reflecting region 120 including strip-shaped convex portions each having the reflecting surface according to the above-described embodiments is provided in the region 122.

In FIG. 32, an arrow N indicates a normal line of the reflecting surface of the strip-shaped convex portion and an arrow H2 indicates the direction in which light is reflected from the reflecting surface of the convex portion to the solar battery cell 30.

In the solar battery module having the above-mentioned structure, the reflecting region 120 is arranged so as to surround the solar battery cell 30 in correspondence with the position of the solar battery cell 30. Therefore, it is possible to effectively deflect light H2 reflected from the reflecting region 120 with the solar battery cell 30.

(Twenty-fourth Embodiment)

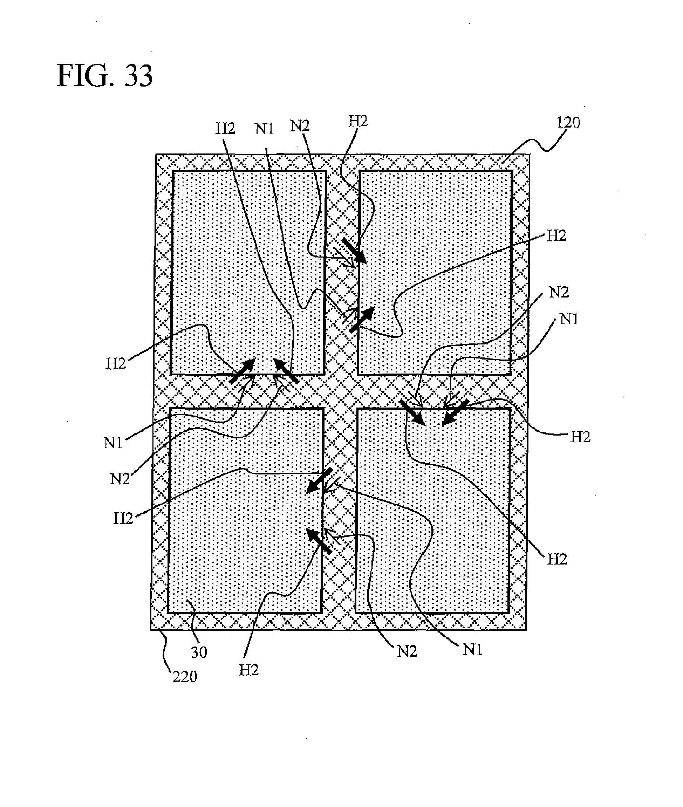

FIG. 33 is a plan view illustrating the arrangement relationship between a light reuse sheet and solar battery cells of a solar battery module according to a twenty-fourth embodiment of the invention.

In the twenty-fourth embodiment, as shown in FIG. 33, a plurality of rectangular solar battery cells 30 of the solar battery module is arranged in a matrix at a constant pitch in the X direction and the Y direction on the plane.

In a light reuse sheet 220, a region 122 in which the solar battery cell 30 is not provided is formed between adjacent solar battery cells 30.

In the region 122, a reflecting region 120 is provided in which one or both of a plurality of strip-shaped concave portions and a plurality of convex portions each having the reflecting surface according to the above-described embodiments are arranged so as to intersect each other.

In FIG. 33, arrows N1 and N2 indicate normal lines of the reflecting surfaces of the concave portions or the convex portions intersecting each other and an arrow H2 indicates the direction in which light is reflected from the reflecting surfaces of the concave portions or the convex portions intersecting each other to the solar battery cell 30.

The intersection angle between the strip-shaped concave and convex portions may be appropriately set and is preferably in the range of 30 degrees to 90 degrees.

As such, in the light reuse sheet 220, when the reflecting region 120 in which the strip-shaped convex portions are arranged so as to intersect each other is used, one side of the rectangular solar battery cell 30 intersects the strip-shaped convex portion.

It is preferable that the solar battery cell 30 and the strip-shaped convex portion be arranged such that light H2 reflected from the reflecting surface of the convex portion is deflected to the solar battery cell 30.

When the strip-shaped convex portions are arranged as shown in FIG. 33, it is possible to use the light reuse sheet 220 in which the convex portions have the same shape in the plane, as compared to FIG. 32.

In this way, it is easy to align the solar battery cells 30 and the light reuse sheet 220 and it is possible to simplify a manufacturing process.

(Twenty-fifth Embodiment)

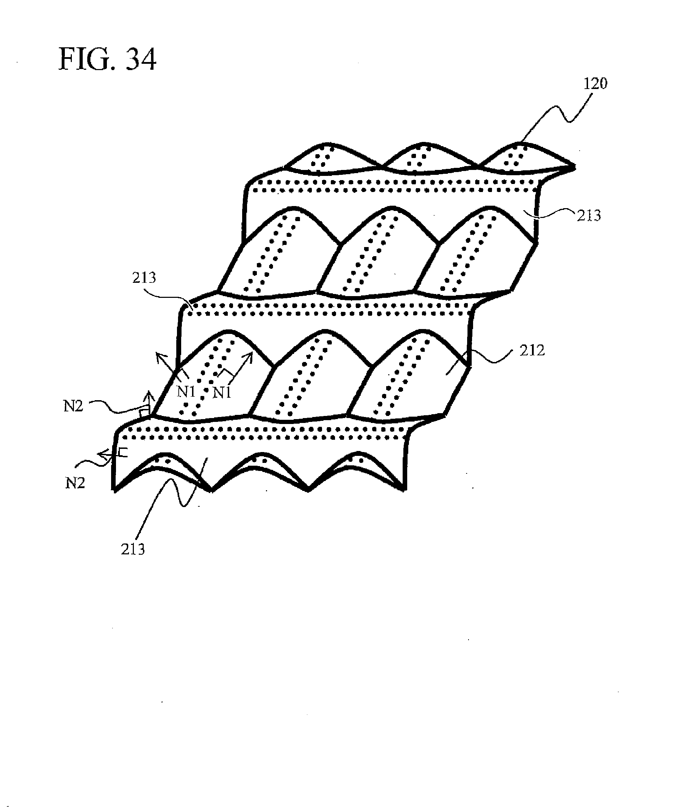

FIG. 34 is a partial enlarged perspective view illustrating an example of the arrangement of reflecting convex portions in a light reuse sheet according a twenty-fifth embodiment of the invention.

As shown in FIG. 34, a reflecting region 120 of a light reuse sheet 220 according to the twenty-fifth embodiment is formed by combining a plurality of first convex portions 212 and a plurality of second convex portions 213.

Specifically, a plurality of first strip-shaped convex portions 212 having the reflecting surface according to the above-described embodiments are arranged so as to be adjacent to each other in the width direction.

The plurality of second strip-shaped convex portions 213 longer than the first convex portion 212 and the plurality of first concave portions 101 are combined so as to intersect each other.

In FIG. 32, arrows N1 and N2 indicate normal lines of the reflecting surfaces of the first convex portion 212 and the second convex portion 213 that intersect each other.

The intersection angle between the first convex portion 212 and the second convex portion 213 of the reflecting region 120 according to the twenty-fifth embodiment may be appropriately set and is preferably in the range of 30 degrees to 90 degrees.

(Twenty-sixth Embodiment)

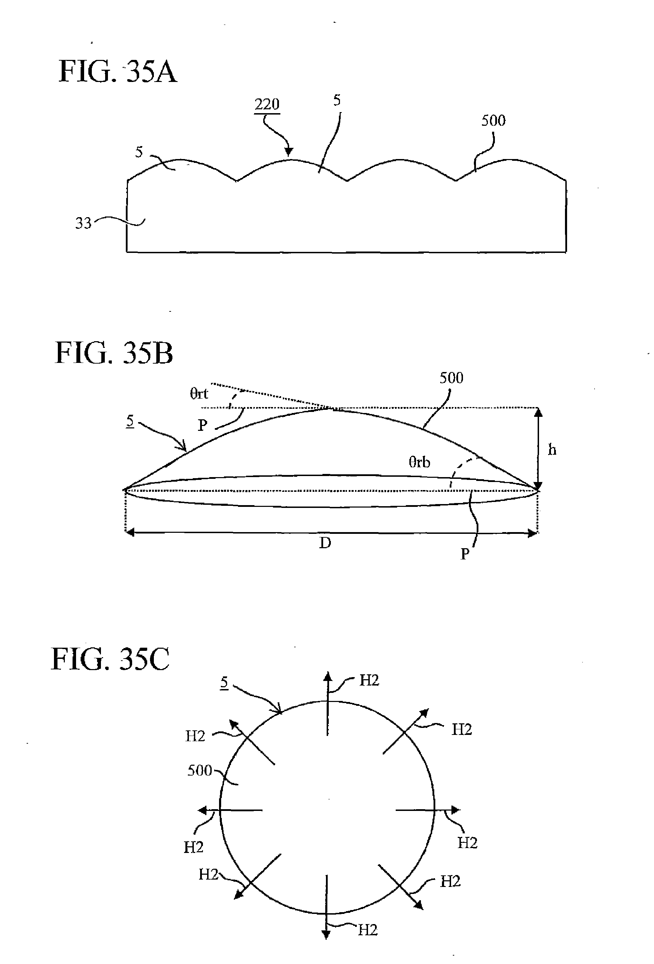

FIGS. 35A to 35C are partial enlarged cross-sectional views illustrating a reflection forming layer of a light reuse sheet according to a twenty-sixth embodiment of the invention and an example of the arrangement of reflecting convex portions formed on the reflection forming layer.

In the twenty-sixth embodiment, the reflecting convex portions that are integrally formed on the upper surface of a reflection forming layer 33 of a light reuse sheet 220 are independent optical components 5, as shown in FIGS. 35B and 35C.

For example, the reflecting convex portion is a convex microlens with a hemispherical reflecting surface 500 having an arc-shaped surface.

The optical components 5 are arranged on the upper surface of the reflection forming layer 5 in a two-dimensional direction at a constant pitch or a random pitch to form the light reuse sheet 220.

In the optical component 5 shown in FIG. 35B, D indicates a diameter and h indicates the height from the base to the top.

The reflecting surface 500 of the optical element 5 is configured such that the angle $\theta r$ formed between the plane P and the reflecting surface 500 is reduced as the reflecting surface 500 becomes closer to the sunlight or illumination light side F, as shown in FIG. 23.

That is, the angle $\theta rb$ formed between the plane P and the reflecting surface 500 at the base of the optical element 5 is large and the angle $\theta rt$ formed between the plane P and the reflecting surface 500 at the top of the optical element 5 is small.

In the optical component 5, when light H1-3 having a refraction angle of $\Delta\theta 0$ is reflected from the reflecting surface 500 similarly to the case shown in FIGS. 28A to 28C, the reflected light is not multi-reflected, similarly to the case shown in FIGS. 28A to 28C.

In this way, light H2 is generated as shown in FIG. 35C.

The light H2 is incident on the interface between the light incident surface of the front plate and air, is sufficiently reflected from the interface, travels to the light receiving surface of the solar battery cell.

In this case, the reflected light caused by light having a refraction angle of $\Delta\theta 0$ is incident on the interface between the light incident surface of the front plate and air at a large angle, as compared to the light that has not a refraction angle of $\Delta\theta 0$.

In this way, the probability of a sufficient amount of reflected light being generated is high.

In the light reuse sheet 220 shown in FIG. 35C in which independent optical components 5 are arranged in the two-dimensional direction, the light H2 that is incident on the reflecting surface 500 of the optical component 5 and then reflected is deflected in the radial direction.

That is, it is possible to deflect light in the two-dimensional direction in FIG. 35C, as compared to the structure in which the strip-shaped convex portions are arranged as shown in FIGS. 25 or 34.

Therefore, it is not necessary to adjust the position of the solar battery cell and the position of the light reuse sheet 220 as shown in FIGS. 32 or 33 and it is possible to simplify a manufacturing process and prevent a reduction in the use efficiency of light due to a defect in the alignment between the solar battery cells and the light reuse sheet.

(Twenty-seventh Embodiment)

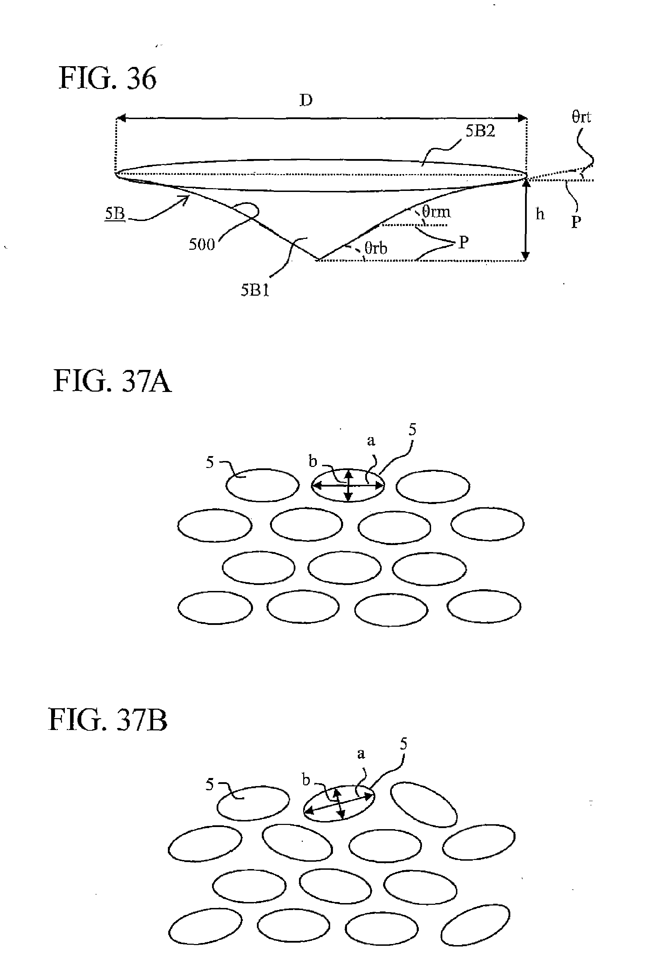

FIG. 36 is a diagram illustrating a modification of the optical component formed in the reflection forming layer of the light reuse sheet according to the invention.

An optical component 5B shown in FIG. 36 has a convex circular cone shape with a diameter D and a height h.

The inner surface of the optical component 5B is a reflecting surface 500 having a quadratic curve shape.

The angle formed between the reflecting surface 500 and the plane P in the bottom 5B1 of the optical component 5B is represented by θrb and the angle formed between the reflecting surface 500 and the plane P in the top 5B2 of the optical component 5B is represented by θrt.

In the optical component 5B, the angle formed between the reflecting surface 500 and the plane P in an intermediate portion between the bottom 5B1 and the top 5B2 is represented by θrm.

The angle Δθrm is set so as to be reduced as the intermediate portion becomes closer to the top 5B2 from the bottom 5B1 of the optical component 5B.

In the optical component 5B, when light H1-3 having a refraction angle of Δθ0 is reflected from the reflecting surface 500 similarly to the case shown in FIGS. 28A to 28C, the reflected light is not multi-reflected, similarly to the case shown in FIGS. 28A to 28C.

In this way, light reflected from the optical component 5B is incident on the interface between the light incident surface of the front plate and air, is totally reflected from the interface, travels to the light receiving surface of the solar battery cell.

In this case, the reflected light caused by light having a refraction angle of Δθ0 is incident on the interface between the light incident surface of the front plate and air at a large angle, as compared to the light that has not a refraction angle of Δθ0.

In this way, the probability of light being totally reflected is high.


(Twenty-eighth Embodiment)


FIGS. 37A and 37B are diagrams illustrating modifications of the optical component formed in the reflection forming layer of the light reuse sheet according to the invention.

An optical component 5 shown in FIG. 37A has an elliptical cone shape having a long axis a and a short axis b.

The external surface of the optical component 5 has a reflecting surface shown in FIG. 37A.

A plurality of optical components 5 is arranged at a constant pitch such that the long axes a thereof are parallel to each other, thereby forming a light reuse sheet.

Since the optical component 5 has an elliptical cone shape, it is possible to strongly deflect light reflected from the reflecting surface of the optical component 5 in any direction.

In particular, when the bottom has an elliptical shape, it is possible to strongly deflect light in a direction that is substantially orthogonal to the long axis a of the ellipse.

Therefore, since the direction that is substantially orthogonal to the long axis a of the ellipse is aligned with the solar battery cell, it is possible to improve the use efficiency of light.

An optical component 5 shown in FIG. 37B has an elliptical cone shape having a long axis a and a short axis b.

The external surface of the optical component 5 has a reflecting surface shown in FIG. 34.

A plurality of optical components 5 is arranged at a non-uniform pitch such that the long axes a thereof are not parallel to each other, thereby forming a light reuse sheet.

When the optical components 5 are arranged in this way, an in-plane variation in the direction of the long axis a is statistically controlled, and it is thereby possible to strongly deflect reflected light in an optional range in the radial direction.


(Twenty-ninth Embodiment)


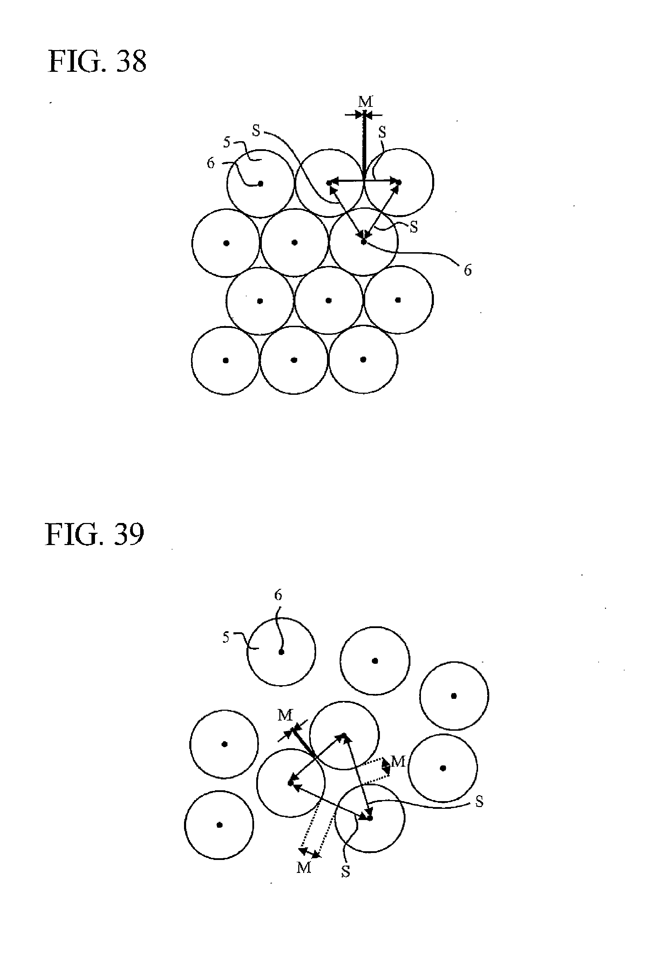

FIG. 38 is a diagram illustrating a modification of the optical component formed in the reflection forming layer of the light reuse sheet according to the invention.

An optical component 5 according to a twenty-ninth embodiment is a microlens that has a dome shape or a substantially circular cone shape and includes an opening portion with a substantially circular shape.

In a light reuse sheet according to this modification, a plurality of optical components 5 is relatively densely and geometrically arranged.

Specifically, the optical components 5 are arranged on a plurality of light reuse sheets such that a regular triangle lattice pattern is formed by lines S (S corresponds to the pitch between the optical components 5) linking the tops 6 of three adjacent optical components 5.

In the arrangement pattern, the pitch S between the tops 6 of the optical components 5 and the distance M between adjacent optical components 5 are constant. Therefore, it is possible to most densely arrange the optical components 5, which are microlenses.


(Thirtieth Embodiment)


FIG. 39 is a diagram illustrating a modification of the optical component formed in the reflection forming layer of the light reuse sheet according to the invention.

An optical component 5 according to a thirtieth embodiment is a microlens that has a dome shape or a substantially circular cone shape and includes a circular bottom.

In the light reuse sheet according to this modification, a plurality of optical components 5 is arranged such that the pitch S between the optical components 5 and the distance M between adjacent optical components 5 are set at random.

The term "random" means that the pitch S between the tops 6 of the optical components 5 and the distance M between the optical components 5 are substantially irregular in any region of the light reuse sheet.

Therefore, even when a plurality of optical components 5 is regularly arranged in a very small portion of any region, a structure in which a plurality of optical components 5 is irregularly arranged in any entire region is included in the "random" structure.

As described above, when the plurality of optical components 5 is arranged at random, the following effect is obtained.

That is, when a texture structure is provided in order to prevent the reflection of light incident on the light incident surface of the front plate, it is possible to prevent the generation of bright and dark fringes due to the interference between the structure of the light reuse sheet and the texture structure of the front plate.

As shown in FIG. 38, when the optical components 5 having the circular bottom are arranged in a regular triangle lattice pattern and there is a small variation in the pitch S between the tops 6 of the optical components 5 and the distance M between the optical components 5 in the plane, brightness unevenness is observed in the entire light reuse sheet.

For this reason, a small variation in distance is emphasized and visible in the structure in which the optical components 5 are highly uniformly arranged.

As shown in FIG. 39, since the optical components 5 are arranged at random, it is possible to prevent brightness unevenness from being visible.

(Thirty-first Embodiment)

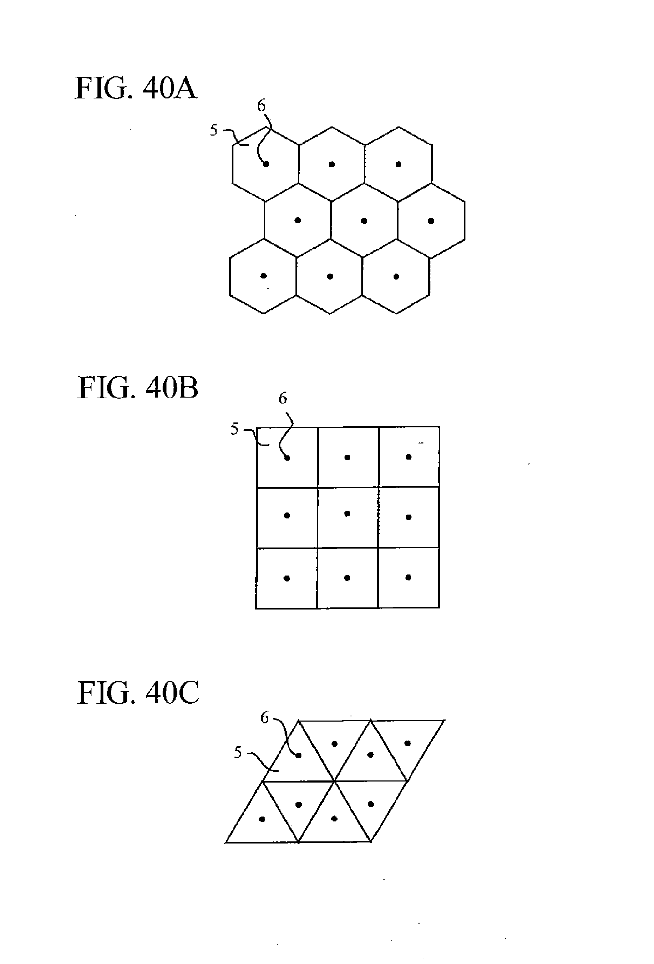

FIGS. 40A to 40C are diagrams illustrating modifications of the optical component formed in the reflection forming layer of the light reuse sheet according to the invention.

An optical component 5 shown in FIG. 40A is a microlens that has a hexagonal pyramid shape and includes the bottom with a regular hexagonal shape.

In the light reuse sheet according to this modification, a plurality of optical components 5 is arranged in a honeycomb shape so as to come into close contact with each other.

An optical component 5 shown in FIG. 40B is a microlens that has a quadrangular pyramid shape and includes the bottom with a square shape.

In the light reuse sheet, a plurality of optical components 5 is arranged in a matrix so as to come into close contact with each other.

An optical component 5 shown in FIG. 40C is a microlens that has a triangular pyramid shape and includes the bottom with a regular triangle shape.

In the light reuse sheet, a plurality of optical components 5 is arranged in a matrix so as to come into close contact with each other.

In FIGS. 40A to 40C, reference numeral 6 indicates the top of the optical component 5.

(Thirty-second Embodiment)

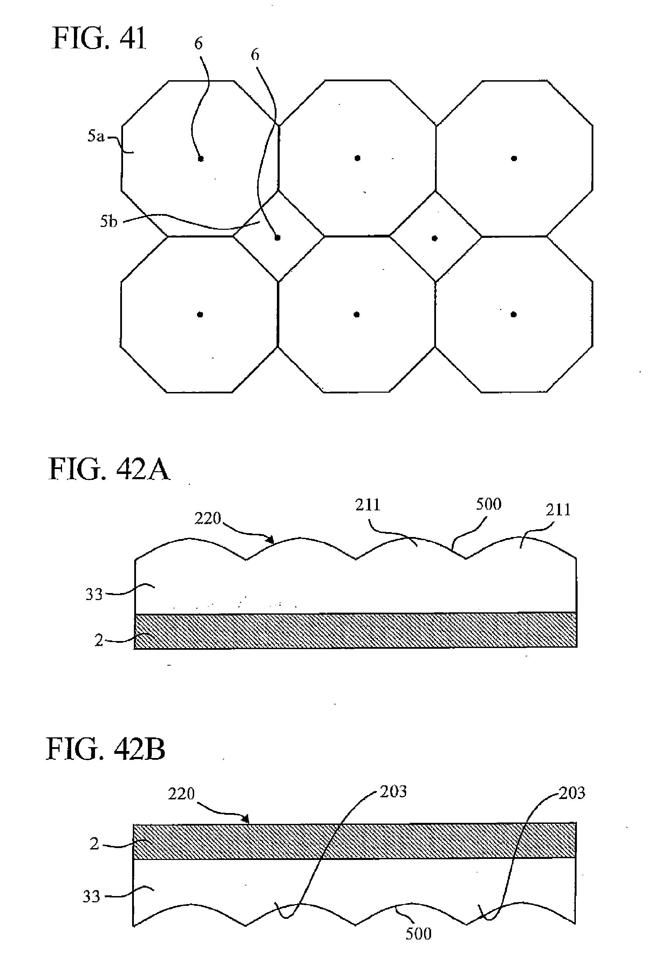

FIG. 41 is a diagram illustrating a modification of the optical component formed in the reflection forming layer of the light reuse sheet according to the invention.

In the modification shown in FIG. 41, a light reuse sheet includes an optical component 5a, which is a microlens that has a substantially octagonal pyramid shape and includes the bottom with a regular octagon shape, and an optical component 5b, which is a microlens that has a substantially quadrangular pyramid shape and includes the bottom with a square shape.

In the light reuse sheet, a plurality of optical components 5a and a plurality of optical components 5b are arranged in a matrix so as to come into close contact with each other.

In FIG. 41, reference numeral 6 indicates the tops of the optical components 5a and 5b.

As the arrangement of the optical components 5 or the optical components 5a and 5b according to this embodiment, it is preferable to use an arrangement structure in which the bottom of the optical component has a polygonal shape and a plurality of optical components is arranged without any gap therebetween, as shown in FIGS. 40A to 40C and 41.

When a plurality of optical components is arranged without any gap, a flat portion between the optical components that does not deflect incident light to the solar battery cell is barely formed.

Therefore, it is possible to improve the use efficiency of light.

Since a plurality of optical components is arranged without any gap, it is possible to prevent a small distance variation occurring in the flat portion from being emphasized and visible. As a result, it is possible to prevent brightness unevenness.

As the structure in which a plurality of optical components is arranged without any gap, a structure in which the bottoms have a regular hexagonal shape, a square shape, or a regular triangular shape and the bottoms have the same shape may be used.

Since the optical components are formed such that the bottoms have the same shape, it is possible to form the optical components with the same dimensions and shape.

Therefore, it is possible to form a light reuse sheet that does not cause brightness unevenness.

In particular, when the bottom has a regular hexagonal shape, a connecting portion for connecting adjacent bottoms is not formed in a straight line, but can be formed in zigzag which is more complicated than the straight line.

Therefore, when a texture structure is provided in order to prevent the reflection of light H0 incident on the front plate 23, it is possible to prevent the generation of bright and dark fringes due to the interference between the structure of the light reuse sheet 220 and the texture structure of the front plate 23.

As shown in FIG. 41, a plurality of optical components may be arranged without any gap therebetween by combining the bottoms and different polygonal optical components 5a and 5b.

In this case, the shape of the optical element may be a portion of a spherical shape, an oval shape, or a circular cone shape in which the angle θr of the reflecting surface 500 is reduced as the reflecting surface 500 becomes closer to the sunlight or illumination light side F.

In addition, as shown in FIG. 35B, the shape of the optical element may be a portion of a circular cone shape in which the angle θr of the reflecting surface 500 increases as the reflecting surface 500 becomes closer to the sunlight or illumination light side F.

Alternatively, the optical element may have the shapes shown in FIGS. 35B and 36.

(Thirty-third Embodiment)

FIGS. 42A and 42B are enlarged cross-sectional views illustrating a light reuse sheet of a solar battery module according to a thirty-third embodiment of the invention.

A light reuse sheet 220 shown in FIG. 42A includes a base 2, which is a flat plate, and a reflection forming layer 33 that is formed on the upper surface of the base 2.

The reflection forming layer 33 is made of a material including a scattering reflector for improving a light reflecting performance and a heat resistance performance.

A plurality of strip-shaped reflecting convex portions 211 which is the same as that shown in FIG. 25 is formed on the upper surface of the reflection forming layer 33 so as to be arranged in parallel along the upper surface of the base 2.

The convex portion 211 has a curved reflecting surface 500.

In the light reuse sheet 220 having the above-mentioned structure, it is possible to omit the metal reflecting layer 4, as compared to the light reuse sheet 220 shown in FIG. 23, and it is possible to obtain the same operation and effect as those of the structure shown in FIG. 23.

The light reuse sheet 220 shown in FIG. 42B is a modification of the light reuse sheet shown in FIG. 42A.

The difference between the light reuse sheet shown in FIG. 42A and the light reuse sheet shown in FIG. 42B will be described below.

The structure of the light reuse sheet shown in FIG. 42B is reverse to that of the light reuse sheet shown in FIG. 42A. That is, the light transmissive base 2 is provided on the filling layer into which the solar battery cells are implanted.

The reflection forming layer 33 including a scattering reflector is provided on the surface of the base 2 opposite to the filling layer.

A plurality of strip-shaped reflecting convex portions 203 is formed on the surface of the reflection forming layer 33 opposite to the base 2 so as to be arranged in parallel along the lower surface of the base 2.

Each of the plurality of strip-shaped reflecting convex portions 203 has a convex reflecting surface 500 having the same curvature as that the convex portion 211 of the light reuse sheet shown in FIG. 42A.

In the light reuse sheet 220 having the above-mentioned structure, it is possible to omit the metal reflecting layer 4, as compared to the light reuse sheet 220 shown in FIG. 25, and it is possible to obtain the same operation and effect as those of the structure shown in FIG. 23.

As the structure of the light reuse sheets 220 shown in FIGS. 42A and 42B, a light reuse sheet including a plurality of independent optical components, which are convex portions or convex microlenses formed on the upper surface or the lower surface of the reflection forming layer 33, may be used.

As the structure of the light reuse sheet, a structure in which one or both of the convex and concave optical components are arranged on the upper surface or the lower surface of the reflection forming layer 33 in the two-dimensional direction at a constant pitch or a random pitch may be used.

As a method of forming the convex portions on the reflection forming layer 33, for example, the following method may be used.

First, for example, a thermosetting resin, an ultraviolet-curable resin, or an electron beam-curable resin is coated or injected onto a concavity and convexity forming surface of a plane stamper or a roller stamper.

Then, the base 2 is arranged on the coated or injected resin and a curing process s is performed.

Then, the cured resin is demolded from the stamper.

(Thirty-fourth Embodiment)

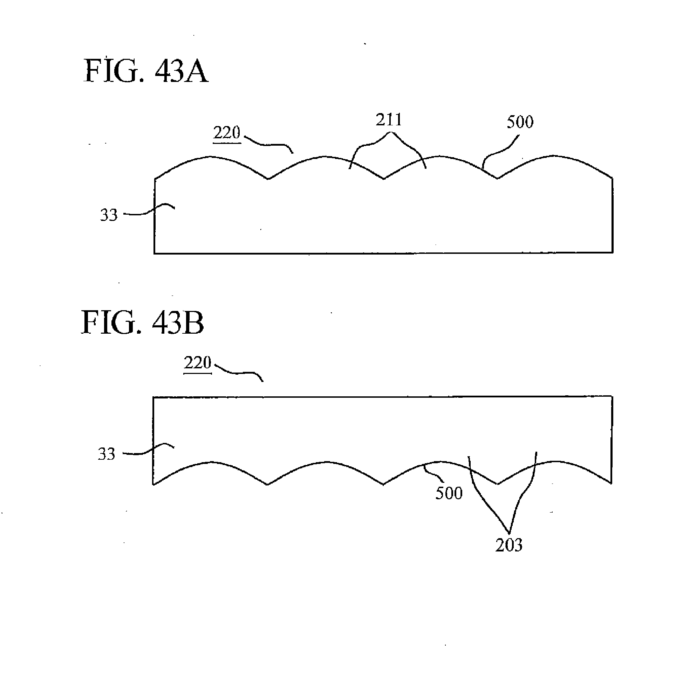

FIGS. 43A and 43B are enlarged cross-sectional views illustrating a light reuse sheet of a solar battery module according to a thirty-fourth embodiment of the invention.

A light reuse sheet 220 shown in FIG. 43A does not include the base 2 and includes only a reflection forming layer 33 including a scattering reflector for improving a light reflecting performance and a heat resistance performance.

A plurality of strip-shaped reflecting convex portions 211 which is the same as that shown in FIG. 42A is formed on the upper surface of the reflection forming layer 33 so as to be arranged in parallel to each other.

The convex portion 211 has a curved reflecting surface 500.

The light reuse sheet 220 having the above-mentioned structure has the same operation and effect as those shown in FIG. 23.

A light reuse sheet 220 shown in FIG. 43B is a modification of the light reuse sheet shown in FIG. 43A.

The light reuse sheet 220 does not include the base 2 and includes only the reflection forming layer 33 including a scattering reflector for improving a light reflecting performance and a heat resistance performance.

Next, the difference between the light reuse sheet shown in FIG. 43A and the light reuse sheet shown in FIG. 43B will be described.

The structure of the light reuse sheet shown in FIG. 43B is reverse to that of the light reuse sheet shown in FIG. 43A. That is, a plurality of strip-shaped reflecting convex portions 203 is formed on the lower surface of the reflection forming layer 33 so as to be arranged in parallel to each other.

The shape of the reflecting convex portion 203 is reverse to that of the convex portion 211 of the light reuse sheet shown in FIG. 43A and has a convex curved reflecting surface 100 having the same curvature as the reflecting surface of the convex reflecting portion 203.

The light reuse sheet 220 with the above-mentioned structure has the same operation and effect as those shown in FIG. 23.

For example, a press method, a casting method, or an injection molding method, using a mold is used to manufacture the light reuse sheets 220 shown in FIGS. 43A and 43B that do not include the base 2 but include only the reflection forming layer 33.

In the method, the uneven structure is formed at the same time as a process of forming a sheet body is performed.

The pitch between the concave portions and the convex portions forming the reflecting surface 500 is preferably less than or equal to 300 $\mu$m and more preferably less than or equal to 200 $\mu$m.

When the pitch between the concave portions and the convex portions is greater than 300 $\mu$m, a sufficient amount of resin is not filled into the mold of the bottom of the concave portion and the top of the convex portion during the molding of the reflecting surface 500. As a result, moldability deteriorates.

Therefore, when the pitch between the concave portions and the convex portions is less than or equal to 200 $\mu$m, it is possible to perform molding even when a resin with a relatively high viscosity is used.

When the pitch between the concave portions and the convex portions is too small, it is difficult to manufacture a mold.

Therefore, the pitch is preferably greater than or equal to 25 $\mu$m and more preferably greater than or equal to 50 $\mu$m.

When the pitch between the concave portions and the convex portions is less than 25 $\mu$m, it takes a long time to cut the mold and the takt time is reduced, which results a reduction in production efficiency.

When the pitch between the concave portions and the convex portions is less than 50 $\mu$m, the resin is not properly filled into grooves during the molding of the reflecting surface 500, and it is difficult to form the shape of the bottom of the concave portion and the top of the convex portion to the shape of the mold.

That is, it is difficult to appropriately transfer the shape of the mold to the light reuse sheet.

The thickness of the reflection forming layer 33 is not particularly limited. However, for example, the thickness of the reflection forming layer 33 is from 30 $\mu$m to 500 $\mu$m.

The above-mentioned manufacturing method may be appropriately selected according to its suitability for use with the following materials.

The materials described in the sixteenth embodiment may be mixed with a polymer composition forming the reflection forming layer 33.

As the polymer composition, the materials described in the sixteenth embodiment may be mixed.

As described in the sixteenth embodiment, a scattering reflector for improving the reflecting performance and the heat resistance performance may be included in the polymer composition forming the reflection forming layer 33.

The same operation and effect as those in the sixteenth embodiment are obtained.

The grain diameter described in the sixteenth embodiment is preferable as the lower limit of the mean grain diameter of the scattering reflector.

A scattering reflector having the structure or material described in the sixteenth embodiment is preferably used as the above-mentioned scattering reflector.

In the light reuse sheet 220, when the reflecting layer 4 is used, a surface treatment may be performed on the surface of the reflecting layer 4 to be subjected to vapor deposition (the surface of the reflection forming layer 33) in order to improve the adhesion of the reflecting layer 4.

The surface treatment described in the sixteenth embodiment is preferable as the above-mentioned surface treatment.

The reflecting layer 4 reflects light incident on the light reuse sheet 220.

The reflecting layer 4 is formed by vapor-depositing metal along the surface of the reflection forming layer 33 on which an uneven structure is formed.

As a vapor deposition apparatus for forming the reflecting layer 4, the vapor deposition apparatus described in the sixteenth embodiment is preferable.

For example, the reflecting layer 4 is made of the metal material described in the sixteenth embodiment.

As described in the sixteenth embodiment, the reflecting layer 4 may have a single-layer structure and a multi-layer structure of two or more layers.

The base 2 of the light reuse sheet 220 is formed by sheet molding using a synthetic resin as a material, as described in the sixteenth embodiment.

The synthetic resin used to form the base 2 and the material forming the base 2 are the same as those described in the sixteenth embodiment.

The base 2 is formed by the method described in the sixteenth embodiment.

As described in the sixteenth embodiment, the base 2 and the reflection forming layer 33 may include an ultraviolet stabilizer or a polymer having an ultraviolet stabilizer group coupled to the molecular chain thereof.

(Thirty-fifth Embodiment)

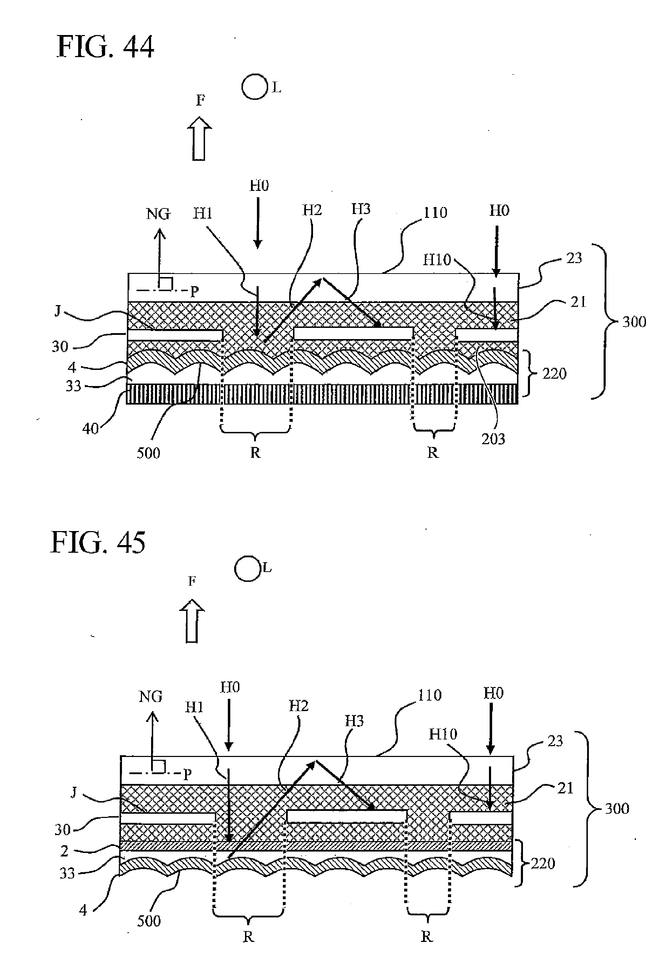

FIG. 44 is a cross-sectional view illustrating a solar battery module according to a thirty-fifth embodiment of the invention.

In FIG. 44, the same components as those in the above-described embodiments are represented as the same reference numerals and a description thereof will be omitted or described in brief. The difference between this embodiment and the structure shown in FIG. 23 will be described in detail.

In a solar battery module 300, a substrate including a barrier layer 40, which is an aluminum layer with a thickness of 10 $\mu$m to 30 $\mu$m or a silica layer with a thickness of 10 nm to 100 nm, is used instead of the base 2 in a light reuse sheet 220.

In this case, in order to improve the durability of the barrier layer 40, PVF (polyvinyl fluoride resin) may be coated on the barrier layer 40 or a film made of a polyvinyl fluoride resin may be adhered to the barrier layer 40, thereby protecting the solar battery module.

According to this structure, it is possible to use the solar battery module 300 as a back sheet.

(Thirty-sixth Embodiment)

FIG. 45 is a cross-sectional view illustrating a solar battery module according to a thirty-sixth embodiment of the invention.

In FIG. 45, the same components as those in the above-described embodiments are represented as the same reference numerals and a description thereof will be omitted or described in brief. The difference between this embodiment and the structure shown in FIG. 23 will be described in detail.

A solar battery module 300 according to the thirty-sixth embodiment includes the light reuse sheet 220 having the structure shown in FIG. 29.

That is, in the thirty-sixth embodiment, a light transmissive base 2 is provided on the lower surface of a filling layer 21 having solar battery cells 30 which are implanted thereinto.

A reflection forming layer 33 is provided on the lower surface of the base 2 opposite to the filling layer 21.

A plurality of reflecting convex portions 203 is provided on the lower surface of the reflection forming layer 33 opposite to the base 2.

The plurality of reflecting convex portions 203 has the same shape as the convex portions 211 according to the nineteenth embodiment and includes a convex curved reflecting surface having the same curvature as that of the convex portion 211.

The plurality of reflecting convex portions 203 is formed along a plane parallel to the plane P which is parallel to a light incident surface of a front plate.

The reflecting surfaces of the plurality of reflecting convex portions 203 are covered with a metal reflecting layer 4 having high reflectance.

The solar battery module 300 including the light reuse sheet 220 having the above-mentioned structure has the same operation and effect as those of the structure shown in FIG. 23.

In the invention, the following structure may be used: a plurality of light emitting elements, such as LEDs or EL elements, is implanted into the filling layer 21, instead of the solar battery cells 30 implanted into the filling layer 21 shown in FIGS. 23 and 45 and the light reuse sheet 20 and the light emitting elements are combined with each other.

According to this structure, an illuminating module is achieved.

Next, examples of the invention will be described.

(Example 1)

In Example 1, a polycarbonate resin, which was a thermoplastic resin, was heated at approximately 300°C and the polycarbonate resin was extended by a roller to form a film with a thickness of 0.3 mm.

Then, a cylinder mold having the shape of an uneven structure arranged in a stripe shape was used to press the heated film and the film was cooled (the temperature of the cylinder mold was 80°C) to reduce the viscosity of the thermoplastic resin. In this way, the thermoplastic resin was completely cured.

In the light reuse sheet 220 manufactured by this method, a spherical-prism-shaped uneven structure having a pitch of 120 $\mu$m was formed.

Specifically, the angle of a reflecting surface 500 of the uneven structure at the bottom was 28.4 degrees, and the angle thereof at the top was 17.5 degrees.

The angle formed between the plane P and the reflecting surface was continuously reduced from the bottom to the top.

As such, a mold roller having a stripe-shaped uneven structure was used as the cooling roller and extrusion molding was performed by a roll-to-roll process (the feed rate of the film: 1 m/min). In this way, it was possible to manufacture a structural layer 33 (reflection forming layer).

In addition, an aluminum film with a thickness of approximately 20 nm was formed as a reflecting layer 4 on the structural layer 33 by vapor deposition.

(Example 2)

In Example 2, a polycarbonate resin, which was a thermoplastic resin, was heated at approximately 300°C and the polycarbonate resin was extended by a roller to form a film with a thickness of 0.3 mm.

Then, a cylinder mold having the shape of a first uneven structure was used to press the heated film and the film was cooled (the temperature of the cylinder mold was 80°C).

Before the film having the shape of the first uneven structure formed therein was completely cured, a cylinder mold having the shape of a second uneven structure was used to press the film and the film was cooled (the cylinder mold in which the shape of a second lens array 5 was cut was a water-cooled roller and the temperature thereof was 10°C).

In this way, the viscosity of the thermoplastic resin was further reduced and completely cured.

In a light reuse sheet 220 manufactured by this method, a first spherical-prism-shaped uneven structure having a pitch of 120 $\mu$m and a second spherical-prism-shaped uneven structure having a pitch of 30 $\mu$m were formed such that the second uneven structure was orthogonal to the longitudinal direction of the first uneven structure.

The angle of a reflecting surface 500 of the first uneven structure at the bottom was 28.4 degrees, and the angle thereof at the top was 17.5 degrees.

The angle formed between the plane P and the reflecting surface was continuously reduced from the bottom to the top.

The angle of a reflecting surface 500 of the second uneven structure at the bottom was 28.4 degrees, and the angle thereof at the top was 17.5 degrees.

The angle formed between the plane P and the reflecting surface was continuously reduced from the bottom to the top.

As such, a mold roller having the shape of the first uneven structure and the shape of the second uneven structure was used as the cooling roller and extrusion molding was performed by a roll-to-roll process (the feed rate of the film: 1 m/min). In this way, it was possible to manufacture a structural layer 33 once.

In addition, an aluminum film with a thickness of approximately 20 nm was formed as a reflecting layer 4 on the structural layer 33 by vapor deposition.

(Example 3)

In Example 3, a polycarbonate resin, which was a thermoplastic resin, was heated at approximately 300°C and the polycarbonate resin was extended by a roller to form a film.

Then, a cylinder mold having the shape of a light reuse sheet 220 was used to press the heated film and the film was cooled (the cylinder mold having the shape of the light reuse sheet 220 was a water-cooled roller and was set to 80°C).

The viscosity of the thermoplastic resin was reduced and the light reuse sheet 220 was cured while the shape of the light reuse sheet 220 was maintained.

In the light reuse sheet 220 manufactured by this method, a first spherical-prism-shaped uneven structure having a pitch of 80 $\mu$m and a second spherical-prism-shaped uneven structure having a pitch of 40 $\mu$m were formed such that the second uneven structure was orthogonal to the longitudinal direction of the first uneven structure.

The angle of a reflecting surface 500 of the first uneven structure at the bottom was 28.4 degrees, and the angle thereof at the top was 17.5 degrees.

The angle formed between the plane P and the reflecting surface was continuously reduced from the bottom to the top.

The angle of a reflecting surface 500 of the second uneven structure at the bottom was 28.4 degrees, and the angle thereof at the top was 17.5 degrees.

The angle formed between the plane P and the reflecting surface was continuously reduced from the bottom to the top.

As such, one lens mold roller was used to perform extrusion molding using a roll-to-roll process (the feed rate of the film: 1.5 m/min). In this way, it was possible to manufacture a structural layer 33 once.

In addition, an aluminum film with a thickness of approximately 20 nm was formed as a reflecting layer 4 on the structural layer 33 by vapor deposition.

In the manufacturing method according to Example 2, two cooling rollers having different shapes were used. One of the rollers was used to form the first uneven structure and the other roller was used to form the second uneven structure.

Therefore, it was possible to easily change the shape of the light reuse sheet 220.

In contrast, in the method according to Example 3, unlike Example 2, the time and effort to optimize the setting of the cooling temperature of two cooling rollers or pressure conditions were reduced. Therefore, a process of forming the structural layer 33 is simplified.

(Example 4)

In Example 4, a biaxially-stretched and readily-adhesive PET film for optical use (film thickness: 125 $\mu$m) was prepared.

An ultraviolet-curable resin (urethane acrylate resin (refractive index: 1.51) manufactured by Nippon Kayaku Co., Ltd.) in which the pattern of a light reuse sheet 220 would be formed and which had urethane acrylate as a main component was coated on the PET film.

Then, a cylinder mold having the shape of a reflecting surface 500 of the light reuse sheet 220 was used and UV light was emitted to the PET film while the film having the ultraviolet-curable resin coated thereon was transported. In this way, the ultraviolet-curable resin was cured and a structural layer 33 was formed.

After the ultraviolet-curable resin was cured, the mold was separated from the PET film.

In the light reuse sheet 220 manufactured by this method, a first spherical-prism-shaped uneven structure having a pitch of 100 $\mu$m and a second spherical-prism-shaped uneven structure having a pitch of 40 $\mu$m were formed such that the second uneven structure was orthogonal to the longitudinal direction of the first uneven structure.

The angle of the reflecting surface 500 of the first uneven structure at the bottom was 28.4 degrees, and the angle thereof at the top was 17.5 degrees.

The angle formed between the plane P and the reflecting surface was continuously reduced from the bottom to the top.

The angle of the reflecting surface 500 of the second uneven structure at the bottom was 28.4 degrees, and the angle thereof at the top was 17.5 degrees.

The angle formed between the plane P and the reflecting surface was continuously reduced from the bottom to the top.

In addition, an aluminum film with a thickness of approximately 20 nm was formed as a reflecting layer 4 on the structural layer 33 by vapor deposition.

(Example 5)

In Example 5, a biaxially-stretched and readily-adhesive PET film for optical use (film thickness: 125 $\mu$m) was prepared.

An ultraviolet-curable resin (urethane acrylate resin (refractive index: 1.51 manufactured by Nippon Kayaku Co., Ltd.) in which the pattern of a light reuse sheet 220 would be formed and which had urethane acrylate as a main component was coated on the PET film.

Then, a cylinder mold that was formed by etching and had the shape of a structural layer 33 was used and UV light was emitted to the PET film while the film having the ultraviolet-curable resin coated thereon was transported.

In this way, the ultraviolet-curable resin was cured and the structural layer 33 was formed.

After the ultraviolet-curable resin was cured, the mold was separated from the PET film.

In the light reuse sheet 220 manufactured by this method, spherical-cone-shaped optical elements 5 each having a diameter of 80 $\mu$m, a bottom angle of 28.4 degrees, and an apex angle of 17.5 degrees were arranged at random.

In the optical element 5, the angle formed between the plane P and the reflecting surface was continuously reduced from the bottom to the top.

A mat surface treatment was performed on a flat portion between the optical elements 5.

In addition, an aluminum film with a thickness of approximately 20 nm was formed as a reflecting layer 4 on the structural layer 33 by vapor deposition.

(Example 6)

In Example 6, a PET film having a thickness of 250 $\mu$m was prepared as a base 2.

An ultraviolet-curable acrylic-based resin was used to form a structural layer 33 having a spherical-prism-shaped uneven structure on the base 2.

In a reflecting surface 500 of the uneven structure of the structural layer 33, the pitch was 150 $\mu$m, the angle of the bottom was 28.4 degrees, and the angle of the top was 1.7.5 degrees.

The angle formed between the plane P and the reflecting surface was continuously reduced from the bottom to the top.

Then, an aluminum layer with a thickness of 20 nm was formed as a metal reflecting layer 4 on the structural layer 33 by a vapor deposition method, thereby obtaining a light reuse sheet 220.

The light reuse sheet 220 was used to manufacture a solar battery module 3 00

A glass plate with a thickness of approximately 2 mm was used as a front plate 23.

Solar battery cells 30 were arranged between the front plate 23 and the light reuse sheet 220 such that the distance between the front plate 23 and the solar battery cell 30 was 1.0 mm, and EVA was filled with a thickness of approximately 1.5 mm between the front plate 23 and the light reuse sheet 220 to form a filling layer 21.

A polycrystalline solar cell was used as the solar battery cell 30.

The solar battery cells 30 were provided in the solar battery module 300 such that the percentage of a peripheral portion (a region in which the solar battery cell 30 was not provided) of the solar battery cells 30 was approximately 10% of the entire area of the solar battery module 300.

The power generation efficiency of the solar battery module 300 was measured.

In addition, a glass plate subjected to the outdoor test was prepared as the front plate.

A solar battery module including the front plate subjected to the outdoor test was manufactured.

The power generation efficiency of the solar battery module was measured. As a result of the measurement, a variation in the power generation efficiency was confirmed.

Table 1 shows the measurement result of the power generation efficiency.

(Example 7)

In Example 7, a PET film having a thickness of 250 $\mu$m was prepared as a base 2.

An ultraviolet-curable acrylic-based resin was used to form a structural layer 33 having a spherical-prism-shaped uneven structure on the base 2.

In a reflecting surface 500 of the uneven structure of the structural layer 33, the pitch was 150 $\mu$m, the angle of the bottom was 30 degrees, and the angle of the top was 17.5 degrees.

The angle formed between the plane P and the reflecting surface was continuously reduced from the bottom to the top.

Then, an aluminum layer with a thickness of 20 nm was formed as a metal reflecting layer 4 on the structural layer 33 by a vapor deposition method, thereby obtaining a light reuse sheet 220.

The light reuse sheet 220 was used to manufacture a solar battery module 300.

A glass plate with a thickness of approximately 2 mm was used as a front plate 23.

Solar battery cells 30 were arranged between the front plate 23 and the light reuse sheet 220 such that the distance between the front plate 23 and the solar battery cell 30 was 1.0 mm, and EVA was filled with a thickness of approximately 1.5 mm between the front plate 23 and the light reuse sheet 220 to form a filling layer 21.

A polycrystalline solar cell was used as the solar battery cell 30.

The solar battery cells 30 were provided in the solar battery module 300 such that the percentage of a peripheral portion (a region in which the solar battery cell 30 was not provided) of the solar battery cells 30 was approximately 10% of the entire area of the solar battery module 300.

The power generation efficiency of the solar battery module 300 was measured.

In addition, a glass plate subjected to the outdoor test was prepared as the front plate.

A solar battery module including the front plate subjected to the outdoor test was manufactured.

The power generation efficiency of the solar battery module was measured. As a result of the measurement, a variation in the power generation efficiency was confirmed.

Table 1 shows the measurement result of the power generation efficiency.

In Example 7, some light components that are incident in the vicinity of the bottom of the uneven structure are multi-reflected.

The multiple reflection occurred in the range of $0 \leq t \leq 0.155$.

Next, comparative examples will be described.

(Comparative example 1)

In Comparative example 1, a PET film having a thickness of 250 $\mu$m was prepared as a base.

An ultraviolet-curable acrylic-based resin was used to form a structural layer having a triangular-prism-shaped uneven structure without a curved surface on the base.

In the reflecting surface of the uneven structure of the structural layer, the pitch was 150 $\mu$m and the cross-sectional angle was constantly 30°.

Then, an aluminum layer with a thickness of 20 nm was formed as a metal reflecting layer on the structural layer by a vapor deposition method, thereby obtaining a light reuse sheet.

The light reuse sheet was used to manufacture a solar battery module according to the comparative example.

A glass plate with a thickness of approximately 2 mm was used as the front plate.

A glass plate with a thickness of approximately 2 mm was used as the front plate.

Solar battery cells were arranged between the front plate and the light reuse sheet such that the distance between the front plate and the solar battery cell was 1.0 mm, and EVA was filled with a thickness of approximately 1.5 mm between the front plate and the light reuse sheet to form a filling layer.

A polycrystalline solar cell was used as the solar battery cell.

The solar battery cells were provided in the solar battery module such that the percentage of a peripheral portion (a region in which the solar battery cell was not provided) of the solar battery cells was approximately 10% of the entire area of the solar battery module.

The power generation efficiency of the solar battery module was measured.

In addition, a glass plate subjected to the outdoor test was prepared as the front plate.

A solar battery module including the front plate subjected to the outdoor test was manufactured.

The power generation efficiency of the solar battery module was measured. As a result of the measurement, a variation in the power generation efficiency was confirmed.

Table 1 shows the measurement result of the power generation efficiency.

FIG. 46 shows the comparison result of the rate of decrease in power generation efficiency.

The term "rate of decrease in the rate of improvement of power generation efficiency" means the difference between the rate of improvement of power generation efficiency when the front plate 23 is used before the outdoor test is performed and the rate of improvement of power generation efficiency when the front plate 23 is used after the outdoor test is performed.

As can be seen from the result shown in FIG. 46, the use of the light reuse sheet 220 according to the invention makes it possible to reduce the rate of decrease in the rate of improvement of the power generation efficiency of the solar battery even when light that is vertically incident on the light incident surface 110 of the front plate 23 is deflected due to contamination or damage.

(Example 8)

Next, Examples 8 to 11 of the solar battery module 200 shown in FIG. 22 will be described.

In Example 8, a PET film having a thickness of 250 μm was prepared as a base 2.

An ultraviolet-curable acrylic-based resin was used to form a structural layer 3 having a spherical-prism-shaped uneven structure on the base 2.

In a reflecting surface 500 of the uneven structure of the structural layer 3, the pitch was 150 μm, the angle of the bottom was 30.0 degrees, and the angle of the top was 17.5 degrees.

The angle formed between the plane P and the reflecting surface was continuously reduced from the bottom to the top.

Then, an aluminum layer with a thickness of 20 nm was formed as a metal reflecting layer 4 on the structural layer 3 by a vapor deposition method, thereby obtaining a light reuse sheet 20.

The light reuse sheet 20 was used to manufacture a solar battery module 200.

A glass plate with a thickness of approximately 2 mm was used as a front plate 22.

Solar battery cells 30 were arranged between the front plate 22 and the light reuse sheet 20 such that the distance between the front plate 22 and the solar battery cell 30 was 1.0 mm, and EVA was filled with a thickness of approximately 1.5 mm between the front plate 22 and the light reuse sheet 20 to form a filling layer 21.

In the light reuse sheet 20, as shown in FIG. 22, a light transmissive base 2 was provided on the lower surface of the filling layer 21 having the solar battery cells 30 which are implanted thereinto.

The structural layer (reflection forming layer) 3 and the metal reflecting layer 4 were provided on the lower surface of the base 2 opposite to the filling layer 21.

A polycrystalline solar cell was used as the solar battery cell 3D.

The solar battery cells 30 were provided in the solar battery module 200 such that the percentage of a peripheral portion (a region in which the solar battery cell 30 was not provided) of the solar battery cells 30 was approximately 10% of the entire area of the solar battery module 200.

The power generation efficiency of the solar battery module 200 was measured.

(Example 9)

Next, an example of the solar battery module 200 shown in FIG. 22 will be described.

In Example 9, a PET film having a thickness of 250 μm was prepared as a base 2.

An ultraviolet-curable acrylic-based resin was used to form a structural layer 3 having a spherical-prism-shaped uneven structure on the base 2.

In a reflecting surface 500 of the uneven structure of the structural layer 3, the pitch was 150 μm, the angle of the bottom was 40.0 degrees, and the angle of the top was 17.5 degrees.

The angle formed between the plane P and the reflecting surface was continuously reduced from the bottom to the top.

Then, an aluminum layer with a thickness of 20 nm was formed as a metal reflecting layer 4 on the structural layer 3 by a vapor deposition method, thereby obtaining a light reuse sheet 20.

The light reuse sheet 20 was used to manufacture a solar battery module 200.

A glass plate with a thickness of approximately 2 mm was used as a front plate 22.

Solar battery cells 30 were arranged between the front plate 22 and the light reuse sheet 20 such that the distance between the front plate 22 and the solar battery cell 30 was 1.0 mm, and EVA was filled with a thickness of approximately 1.5 mm between the front plate 22 and the light reuse sheet 20 to form a filling layer 21.

In the light reuse sheet 20, as shown in FIG. 22, a light transmissive base 2 was provided on the lower surface of the filling layer 21 having the solar battery cells 30 which are implanted thereinto.

The structural layer (reflection forming layer) 3 and the metal reflecting layer 4 were provided on the lower surface of the base 2 opposite to the filling layer 21.

A polycrystalline solar cell was used as the solar battery cell 30.

The solar battery cells 30 were provided in the solar battery module 200 such that the percentage of a peripheral portion (a region in which the solar battery cell 30 was not provided) of the solar battery cells 30 was approximately 10% of the entire area of the solar battery module 200.

The power generation efficiency of the solar battery module 200 was measured.

(Example 10)

In Example 10, a PET film having a thickness of 250 μm was prepared as a base 2.

An ultraviolet-curable acrylic-based resin was used to form a structural layer 3 having a spherical-prism-shaped uneven structure on the base 2.

In a reflecting surface 500 of the uneven structure of the structural layer 3, the pitch was 150 $\mu$m, the angle of the bottom was 30.0 degrees, and the angle of the top was 17.5 degrees.

The angle formed between the plane P and the reflecting surface was continuously reduced from the bottom to the top.

Then, an aluminum layer with a thickness of 20 nm was formed as a metal reflecting layer 4 on the structural layer 3 by a vapor deposition method, thereby obtaining a light reuse sheet 20.

The light reuse sheet 20 was used to manufacture a solar battery module 200.

A glass plate with a thickness of approximately 2 mm was used as a front plate 22.

Solar battery cells 30 were arranged between the front plate 22 and the light reuse sheet 20 such that the distance between the front plate 22 and the solar battery cell 30 was 1.0 mm, and EVA was filled with a thickness of approximately 1.5 mm between the front plate 22 and the light reuse sheet 20 to form a filling layer 21.

In the light reuse sheet 20, as shown in FIG. 22, a light transmissive base 2 was provided on the lower surface of the filling layer 21 having the solar battery cells 30 which are implanted thereinto.

The structural layer (reflection forming layer) 3 and the metal reflecting layer 4 were provided on the lower surface of the base 2 opposite to the filling layer 21.

A polycrystalline solar cell was used as the solar battery cell 30.

The solar battery cells 30 were provided in the solar battery module 200 such that the percentage of a peripheral portion (a region in which the solar battery cell 30 was not provided) of the solar battery cells 30 was approximately 30% of the entire area of the solar battery module 200.

The power generation efficiency of the solar battery module 200 was measured.

(Example 11)

In Example 11, a PET film having a thickness of 250 $\mu$m was prepared as a base 2.

An ultraviolet-curable acrylic-based resin was used to form a structural layer 3 having a spherical-prism-shaped uneven structure on the base 2.

In a reflecting surface 500 of the uneven structure of the structural layer 3, the pitch was 150 $\mu$m, the angle of the bottom was 40.0 degrees, and the angle of the top was 17.5 degrees.

The angle formed between the plane P and the reflecting surface was continuously reduced from the bottom to the top.

Then, an aluminum layer with a thickness of 20 nm was formed as a metal reflecting layer 4 on the structural layer 3 by a vapor deposition method, thereby obtaining a light reuse sheet 20.

The light reuse sheet 20 was used to manufacture a solar battery module 200.

A glass plate with a thickness of approximately 2 mm was used as a front plate 22.

Solar battery cells 30 were arranged between the front plate 22 and the light reuse sheet 20 such that the distance between the front plate 22 and the solar battery cell 30 was 1.0 mm, and EVA was filled with a thickness of approximately 1.5 mill between the front plate 22 and the light reuse sheet 20 to form a filling layer 21.

In the light reuse sheet 20, as shown in FIG. 22, a light transmissive base 2 was provided on the lower surface of the filling layer 21 having the solar battery cells 30 which are implanted thereinto.

The structural layer (reflection forming layer) 3 and the metal reflecting layer 4 were provided on the lower surface of the base 2 opposite to the filling layer 21.

A polycrystalline solar cell was used as the solar battery cell 30.

The solar battery cells 30 were provided in the solar battery module 200 such that the percentage of a peripheral portion (a region in which the solar battery cell 30 was not provided) of the solar battery cells 30 was approximately 30% of the entire area of the solar battery module 200.

The power generation efficiency of the solar battery module 200 was measured.

(Comparative example 3)

In Comparative example 3, a PET film having a thickness of 250 $\mu$m was prepared as a base 2.

An ultraviolet-curable acrylic-based resin was used to form a structural layer 3 having a spherical-prism-shaped uneven structure on the base 2.

In a reflecting surface 500 of the uneven structure of the structural layer 3, the pitch was 150 $\mu$m and the cross-sectional angle was constantly 17.5 degrees.

Then, an aluminum layer with a thickness of 20 nm was formed as a metal reflecting layer 4 on the structural layer 3 by a vapor deposition method, thereby obtaining a light reuse sheet 20.

The light reuse sheet 20 was used to manufacture a solar battery module 200.

A glass plate with a thickness of approximately 2 mm was used as a front plate 22.

Solar battery cells 30 were arranged between the front plate 22 and the light reuse sheet 20 such that the distance between the front plate 22 and the solar battery cell 30 was 1.0 mm, and EVA was filled with a thickness of approximately 1.5 mm between the front plate 22 and the light reuse sheet 20 to form a filling layer 21.

In the light reuse sheet 20, as shown in FIG. 22, a light transmissive base 2 was provided on the lower surface of the filling layer 21 having the solar battery cells 30 which are implanted thereinto.

The structural layer (reflection forming layer) 3 and the metal reflecting layer 4 were provided on the lower surface of the base 2 opposite to the filling layer 21.

A polycrystalline solar cell was used as the solar battery cell 30.

The solar battery cells 30 were provided in the solar battery module 200 such that the percentage of a peripheral portion (a region in which the solar battery cell 30 was not provided) of the solar battery cells 30 was approximately 10% of the entire area of the solar battery module 200.

The power generation efficiency of the solar battery module 200 was measured.

The comparison result of the power generation efficiencies of Example 8, Example 9, and Comparative example 3 showed that the power generation efficiency of Example 8 was greater than that of Comparative example 3 and the power generation efficiency of Example 9 was greater than that of Example 8.

As can be seen from the comparison result, the use of the light reuse sheet 20 according to the invention makes it possible to further improve the power generation efficiency.

The comparison result of the power generation efficiencies of Example 10 and Example 11 showed that the power generation efficiency of Example 11 was greater than that of Example 10.

As can be seen from the comparison result, the use of the light reuse sheet 20 according to the invention can improve the power generation efficiency even when the area of the region in which the solar battery cell 30 is not provided increases.

When the area of the region in which the solar battery cell 30 is not provided can increase, it is possible to reduce the number of solar battery cells 30 provided in the solar battery module 200.

Therefore, it is possible to reduce the cost of the material forming the solar battery module.

Industrial Applicability

As described above, the invention is useful for a light reuse sheet that has an uneven structure provided on at least one surface thereof and is capable of deflecting light in a specific direction using the diffraction, scattering, refraction, or reflection of light by the uneven structure to reuse light that have been conventionally lost and a solar battery module using the light reuse sheet.

**Claims**

1. A light reuse sheet used for a solar battery module,
   the solar battery module comprising: a transparent front plate having a light incident surface to which light is incident; a filling layer which is stacked on a face opposite to the light incident surface and through which the light passing through the front plate is transmitted; and a solar battery cell which is implanted into the filling layer and has a light receiving face located at a face opposed to the front plate, the solar battery cell converting the light transmitted through the filling layer into electric energy by receiving the light by the light receiving face,
   the light reuse sheet being provided at a face of the filling layer opposite to the light receiving face of the solar battery cell, and
   the light reuse sheet comprising: a reflection forming layer having an uneven portion including a first inclined portion and a second inclined portion; and a reflecting surface provided at a surface of the uneven portion, wherein
   the light reuse sheet generates second light by reflecting first light toward the front plate, the first light being transmitted through the filling layer without being received by the light receiving face of the solar battery cell, the light reuse sheet generates third light by reflecting the second light at an interface between the light incident surface and outside of the front plate, and the light reuse sheet causes the third light to be incident to the light receiving face of the solar battery cell,
   the second light generated by reflection caused by the first inclined portion travels toward the front plate while having a first angle with respect to the first light, and is reflected by a first interface portion of the front plate so as to be converted into the third light, the first interface portion being arranged separately from the uneven portion by a first distance, and
   the second light generated by reflection caused by the second inclined portion travels toward the front plate while having a second angle that is smaller than the first angle with respect to the first light, and is reflected by a second interface portion of the front plate so as to be converted into the third light, the second interface portion being arranged separately from the uneven portion by a second distance that is smaller than the first distance.

2. The light reuse sheet according to claim 1, further comprising a base, wherein the reflection forming layer is formed on an upper face of the base.

3. The light reuse sheet according to claim 1, further comprising a base, wherein the reflection forming layer and the base are formed in an integrated manner.

4. The light reuse sheet according to claim 1, wherein
the reflection forming layer includes a reflecting layer having a high reflectance, and the reflecting surface serves as a surface of the reflecting layer.

5. The light reuse sheet according to any one of claims 1 to 3, wherein
the reflection forming layer contains a scattering reflector which scatters and reflects light.

6. The light reuse sheet according to claim 1, wherein
an angle θr between a parallel plane parallel to the light incident surface and the reflecting surface at a predetermined position which is located along the reflecting surface increases in a manner that the predetermined position approaches the front plate along the reflecting surface.

7. The light reuse sheet according to claim 6, wherein
where an angle between the parallel plane and the reflecting surface at a position at which a distance between the reflecting surface and the front plate is maximum in the uneven portion is represented as θrb, an array pitch of the uneven portion is represented as S, a depth of the uneven portion is represented as d, tan (90°-2θrb) . S/2 > d is satisfied.

8. The light reuse sheet according to claim 1, wherein
in a direction perpendicular to a plane parallel to the light incident surface and in a direction opposite to an incident direction of the first light, a distance between a second inclined portion and the light incident surface is greater than a distance between a first inclined portion and the light incident surface, and an angle between a first inclined portion and the parallel plane is greater than an angle between a second inclined portion and the parallel plane.

9. The light reuse sheet according to claim 1, further comprising a plurality of uneven portions formed in a strip shape extending in one direction, wherein
the uneven portions are arrayed in parallel to each other along an interface between the reflection forming layer and the filling layer.

10. The light reuse sheet according to claim 1, further comprising a plurality of uneven portions formed in a strip shape extending in one direction, wherein
the uneven portions are arrayed so as to intersect with each other along an interface between the reflection forming layer and the filling layer.

11. The light reuse sheet according to claim 1, further comprising a plurality of uneven portions which are constituted of independent optical components, the optical components being arrayed in a two-dimensional direction.

12. The light reuse sheet according to claim 11, wherein
the optical elements are formed in any of substantially circular cone shape, substantially pyramid shaped, substantially ellipsoidal cone shape, substantially circular cylinder shape, substantially truncated circular cone shape, substantially truncated pyramid shape, substantially truncated ellipsoidal cone shape, substantially hemisphere, substantially half-ellipse, or substantially U-shape in cross-sectional shape.

13. The light reuse sheet according to claim 11, wherein
the optical components constituting the uneven portions are micro lenses which are arrayed along an interface between the reflecting layer and the filling layer.

14. A solar battery module comprising the light reuse sheet according to claim 1.

**15.** is. A light reuse sheet used for a solar battery module,
the solar battery module comprising: a transparent front plate having a light incident surface to which light is incident; a filling layer which is stacked on a face opposite to the light incident surface and through which the light passing through the front plate is transmitted; and a solar battery cell which is implanted into the filling layer and has a light receiving face located at a face opposed to the front plate, the solar battery cell converting the light transmitted through the filling layer into electric energy by receiving the light by the light receiving face,
the light reuse sheet being provided at a face of the filling layer opposite to the light receiving face of the solar battery cell, and
the light reuse sheet comprising: a reflection forming layer having an uneven portion; and a reflecting surface provided at a surface of the uneven portion, wherein
the light reuse sheet generates second light by reflecting first light toward the front plate, the first light being transmitted through the filling layer without being received by the light receiving face of the solar battery cell, the light reuse sheet generates third light by reflecting the second light at an interface between the light incident surface and outside of the front plate, and the light reuse sheet causes the third light to be incident to the light receiving face of the solar battery cell,
straight light that is part of the first light is reflected by the reflecting surface and is thereby converted into second light traveling toward the front plate while having a first angle with respect to the straight light, and the second light having the first angle is reflected by a first interface portion of the front plate so as to be converted into the third light, the first interface portion being arranged separately from the uneven portion by a first distance, and
refracted light that is part of the first light is reflected by the reflecting surface and is thereby converted into second light traveling toward the front plate while having a second angle that is greater than the first angle with respect to the straight light, and the second light having the second angle is reflected by a second interface portion of the front plate so as to be converted into the third light, the second interface portion being arranged separately from the uneven portion by a second distance that is greater than the first distance.

**16.** The light reuse sheet according to claim 15 further comprising a base, wherein the reflection forming layer is formed on an upper face of the base.

**17.** The light reuse sheet according to claim 15, further comprising a base, wherein the reflection forming layer and the base are formed in an integrated manner.

**18.** The light reuse sheet according to claim 15, wherein
the reflection forming layer includes a reflecting layer having a high reflectance, and the reflecting surface serves as a surface of the reflecting layer.

**19.** The light reuse sheet according to any one of claims 1 to 17, wherein
the reflection forming layer contains a scattering reflector which scatters and reflects light.

**20.** The light reuse sheet according to claim 15, wherein
an angle θr between a parallel plane parallel to the light incident surface and the reflecting surface at a predetermined position which is located along the reflecting surface decreases in a manner that the predetermined position approaches the front plate along the reflecting surface.

**21.** The light reuse sheet according to claim 20, wherein
where an angle between the parallel plane and the reflecting surface at a position at which a distance between the reflecting surface and the front plate is maximum in the uneven portion is represented as θrb, an array pitch of the uneven portion is represented as S, a height of the uneven portion is represented as h, tan (90°-2θrb) - S/2 > h is satisfied.

**22.** The light reuse sheet according to claim 15, further comprising a plurality of uneven portions formed in a strip shape extending in one direction, wherein
the uneven portions are arrayed in parallel to each other along an interface between the reflection forming layer and the filling layer.

**23.** The light reuse sheet according to claim 15, further comprising a plurality of uneven portions formed in a strip shape extending in one direction, wherein
the uneven portions are arrayed so as to intersect with each other along an interface between the reflection forming layer and the filling layer.

**24.** The light reuse sheet according to claim 15, further comprising a plurality of uneven portions which are constituted of independent optical components, the optical components being arrayed in a two-dimensional direction.

**25.** The light reuse sheet according to claim 24, wherein
the optical elements are formed in any of substantially circular cone shape, substantially pyramid shaped, substantially ellipsoidal cone shape, substantially circular cylinder shape, substantially truncated circular cone shape, substantially truncated pyramid shape, substantially truncated ellipsoidal cone shape, substantially hemisphere, substantially half-ellipse, or substantially U-shape in cross-sectional shape.

**26.** The light reuse sheet according to claim 24, wherein
the optical components constituting the uneven portions are micro lenses which are arrayed along an interface between the reflecting layer and the filling layer.

**27.** A solar battery module comprising the light reuse sheet according to claim 15.

FIG. 1

FIG. 2

FIG. 3

# FIG. 4A

# FIG. 4B

# FIG. 4C

# FIG. 5A

# FIG. 5B

# FIG. 6

# FIG. 7

# FIG. 8

FIG. 9

## FIG. 10

## FIG. 11

## FIG. 12A

## FIG. 12B

## FIG. 12C

## FIG. 13

## FIG. 14A

## FIG. 14B

FIG. 15

FIG. 16

## FIG. 17A

## FIG. 17B

## FIG. 17C

## FIG. 18

## FIG. 19A

## FIG. 19B

# FIG. 20A

# FIG. 20B

# FIG. 21

FIG. 22

FIG. 23

# FIG. 24

# FIG. 25

## FIG. 26A

## FIG. 26B

## FIG. 26C

FIG. 27

FIG. 28A

FIG. 28B

FIG. 28C

# FIG. 29

# FIG. 30

FIG. 31

# FIG. 32

## FIG. 33

FIG. 34

# FIG. 35A

# FIG. 35B

# FIG. 35C

FIG. 36

FIG. 37A

FIG. 37B

FIG. 38

FIG. 39

FIG. 40A

FIG. 40B

FIG. 40C

FIG. 41

FIG. 42A

FIG. 42B

## FIG. 43A

## FIG. 43B

# FIG. 44

# FIG. 45

# FIG. 46

| | RATE OF DECREASE IN RATE OF IMPROVEMENT OF POWER GENERATION EFFICIENCY |
|---|---|
| COMPARATIVE EXAMPLE 1 | −1.1 |
| EXAMPLE 6 | −0.1 |
| EXAMPLE 7 | −0.3 |

# FIG. 47

| INTERNATIONAL SEARCH REPORT | International application No. |
|---|---|
| | PCT/JP2009/006246 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 11-307791 A (Sanyo Electric Co., Ltd.),<br>05 November 1999 (05.11.1999),<br>paragraphs [0023], [0037] to [0038]; fig. 3, 6<br>(Family: none) | 1-4,6,8,14<br>5 |
| Y | JP 2001-119054 A (Hitachi, Ltd.),<br>27 April 2001 (27.04.2001),<br>paragraphs [0018], [0045]; fig. 1, 5<br>(Family: none) | 1-4,6,8,14 |
| Y | JP 10-284747 A (Sharp Corp.),<br>23 October 1998 (23.10.1998),<br>paragraph [0022]<br>(Family: none) | 5 |

[X] Further documents are listed in the continuation of Box C.    [ ] See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>10 February, 2010 (10.02.10) | Date of mailing of the international search report<br>23 February, 2010 (23.02.10) |
|---|---|
| Name and mailing address of the ISA/<br>Japanese Patent Office | Authorized officer |
| Facsimile No. | Telephone No. |

Form PCT/ISA/210 (second sheet) (April 2007)

# EP 2 357 673 A1

| INTERNATIONAL SEARCH REPORT | International application No. |
|---|---|
| | PCT/JP2009/006246 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 6-61519 A (Siemens Solar Industries International, Inc.), 04 March 1994 (04.03.1994), paragraphs [0012] to [0019]; fig. 2 to 3 & US 5288337 A & EP 575797 A1 | 1-4,6,8,14 |
| A | JP 11-243225 A (Hitachi, Ltd.), 07 September 1999 (07.09.1999), fig. 4 & US 2001/0008144 A1 & DE 19907506 A | 1-6,8,14 |
| A | JP 2000-101124 A (Hitachi, Ltd.), 07 April 2000 (07.04.2000), fig. 5 & US 6323415 B1 | 1-6,8,14 |
| A | JP 2002-26364 A (Hitachi, Ltd.), 25 January 2002 (25.01.2002), entire text; all drawings (Family: none) | 1-6,8,14 |
| A | JP 2002-43600 A (President of Tokyo University of Agriculture and Technology), 08 February 2002 (08.02.2002), entire text; all drawings (Family: none) | 1-6,8,14 |

Form PCT/ISA/210 (continuation of second sheet) (April 2007)

84

**INTERNATIONAL SEARCH REPORT**

International application No.

PCT/JP2009/006246

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:
   The technical feature common to the independent claims 1 and 15 cannot be a special technical feature within the meaning of PCT Rule 13.2, second sentence when compared to Documents 1-2. The inventions of claims 1-14 relate to a convex/concave portion containing a first inclined portion and a second inclined portion while the inventions of claims 15-27 relate to a directly advancing light and a refracted light. Moreover, when compared to Document 1, the inventions of claims 1-2 have no special technical feature but the invention of claim 5 having the configuration disclosed in claims 1, 2 has a special technical feature.
   (Continued to extra sheet)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-6, 8, 14

**Remark on Protest**
   ☐ The additional search fees were accompanied by the applicant's protest and, where applicable, the payment of a protest fee.
   ☐ The additional search fees were accompanied by the applicant's protest but the applicable protest fee was not paid within the time limit specified in the invitation.
   ☐ No protest accompanied the payment of additional search fees.

Form PCT/ISA/210 (continuation of first sheet (2)) (April 2007)

**INTERNATIONAL SEARCH REPORT**

International application No.

PCT/JP2009/006246

Continuation of Box No.III of continuation of first sheet(2)

Accordingly, the present application includes five groups of inventions as follows. It should be noted that the inventions of claims 1-2, 3-4, 6, 8, 14 having no special technical feature are classified into the first group of inventions.

<first group of inventions> claims 1-6, 8, 14
<second group of inventions> claim 7 (relating to the relationship between the angle, the arrangement pitch, and the depth)
<third group of inventions> claims 9-10 (strip shape)
<fourth group of inventions> claims 11-13 (two-dimensional arrangement)
<fifth group of inventions> claims 15-27 (a directly advancing light and a refracted light)

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008296177 A
- JP 2008324503 A
- JP 2001295437 A
- JP H0461285 B

- JP 3749015 B
- JP H10284747 B
- JP 3670835 B
- JP 2006319250 A